(19) Europäisches Patentamt
European Patent Office
Office européen des brevets

(11) **EP 1 828 829 B1**

(12) **EUROPÄISCHE PATENTSCHRIFT**

(45) Veröffentlichungstag und Bekanntmachung des Hinweises auf die Patenterteilung:
**22.08.2012 Patentblatt 2012/34**

(21) Anmeldenummer: **05819425.9**

(22) Anmeldetag: **22.12.2005**

(51) Int Cl.:
**G02B 17/06** (2006.01)

(86) Internationale Anmeldenummer:
**PCT/EP2005/013841**

(87) Internationale Veröffentlichungsnummer:
**WO 2006/069725 (06.07.2006 Gazette 2006/27)**

(54) **HOCHAPERTURIGES OBJEKTIV MIT OBSKURIERTER PUPILLE**

HIGH APERTURE LENS WITH AN OBSCURED PUPIL

OBJECTIF A GRANDE OUVERTURE ET PUPILLE OBSCURCIE

(84) Benannte Vertragsstaaten:
**DE FR GB IT NL**

(30) Priorität: **23.12.2004 DE 102004063313**
**24.03.2005 US 665036 P**
**30.06.2005 US 695455 P**
**13.07.2005 US 698909 P**
**05.09.2005 DE 102005042005**

(43) Veröffentlichungstag der Anmeldung:
**05.09.2007 Patentblatt 2007/36**

(73) Patentinhaber: **Carl Zeiss SMT GmbH**
**73447 Oberkochen (DE)**

(72) Erfinder:
• **MANN, Hans-Jürgen**
**73447 Oberkochen (DE)**
• **SHAFER, David**
**Fairfield**
**CT 06430 (US)**
• **ULRICH, Wilhelm**
**73434 Aalen (DE)**

(56) Entgegenhaltungen:
EP-A- 1 093 021        EP-A- 1 199 590
EP-A- 1 450 196        DE-A1- 3 343 868
JP-A- 2003 114 387     US-A1- 2001 038 446
US-A1- 2002 171 048    US-A1- 2004 114 217

• **RUSSEL HUDYMA: "An Overview of Optical Systems for 30 nm Resolution Lithography at EUV Wavelengths" PROCEEDINGS OF SPIE, Bd. 4832, Dezember 2002 (2002-12), Seiten 137-148, XP002370501**

**Beschreibung**

Die Erfindung betrifft ein Objektiv, insbesondere ein Projektionsobjektiv, bevorzugt ein Mikrolithographie-Projektionsobjektiv. Das Objektiv gemäß der Erfindung ist auch für die Mikroskopie oder den Einsatz in Inspektionssystemen geeignet. Die Objektive sind im gesamten Wellenlängenbereich, d.h. auch für Wellenlängen > 193 nm verwendbar. Ein besonders bevorzugter, aber nicht der ausschließliche Einsatzbereich ist die Verwendung als Mikrolithographie-Projektionsobjektiv in Mikrolithographie-Projektionsbelichtungsanlagen, insbesondere für Wellenlängen $\leq$ 193 nm.

Generell kann man bei Projektionsobjektiven zwischen drei unterschiedlichen Klassen unterscheiden, sog. dioptrischen Objektiven, katoptrischen Objektiven und katadioptrischen Objektiven. Dioptrische Objektive verwenden refraktive Elemente, bspw. Linsenelemente um Licht von einer Objektebene in eine Bildebene abzubilden. Katoptrische Objektive verwenden reflektive Elemente, bspw. Spiegelelemente um Licht von einer Objektebene in eine Bildebene abzubilden und katadioptrische Objektive verwenden sowohl refraktive wie auch reflektive Elemente, um Licht von einer Objektebene in eine Bildebene abzubilden.

Bei hochaperturigen Projektionsobjektiven, insbesondere für die EUV-Lithographie treten hohe Einfallswinkel auf zumindest einigen der Spiegel des hochaperturigen Projektionsobjektives auf. Hohe Einfallswinkel führen aber zu starken Reflektionsverlusten und zu nicht oder nur sehr schwer korrigierbaren Phasendifferenzen von s- und p- polarisiertem Licht. Insbesondere im hochaperturigen Teil eines Mikrolithographie-Projektionsobjektives treten hohe Einfallswinkel bzw. sehr große Einfallswinkelvariationen über dem Spiegel auf.

Verantwortlich hierfür ist bei den Systemen gemäß dem Stand der Technik im Wesentlichen die geometrische Anordnung der letzten beiden Spiegel, die im Wesentlichen durch die Telezentrieforderung festgelegt ist.

Bei dem aus der US 5,686,728 bekannten System, ist für die im Lichtweg bildseitig letzten beiden Spiegel eine Kombination aus einem konvexen und einem konkaven Spiegel gezeigt. Zwar kann durch eine derartige Spiegelkombination eines konvexen Spiegels mit einem konkaven Spiegel die bildseitige Telezentrieanforderung erfüllt werden, jedoch sind der Einfallswinkel und insbesondere die Einfallswinkelvariation auf dem im Lichtweg vorletzten Spiegel sehr groß.

In dieser Anmeldung wird als ein charakteristisches Maß für die Größe des Einfallswinkels auf einem Spiegel der Einfallswinkel des Hauptstrahles des zentralen Feldpunktes eines Feldes, beispielsweise eines Ringfeldes in der Objektebene auf einem Spiegel betrachtet. Dieser wird auch mit $\Theta_{CR}$ bezeichnet. Kommt am physikalischen Ort des Spiegels, der am nächsten zur Bildebene angeordnet ist, ein Zwischenbild zu liegen wie beispielsweise in der EP 1434093 offenbart, so kann zwar eine hohe bildseitige Apertur von NA=0,5 erreicht werden, die Einfallswinkel sind bei derartigen System jedoch so hoch, dass ein hoher Lichtverlust im Lichtweg von der Objektebene zur Bildebene am vorletzten Spiegel unvermeidlich ist.

Um diesen Nachteil zu überwinden, schlägt z. B. die US 6,750,948 B2 ein Mikrolithographie-Projektionssystem vor, bei dem wenigstens ein Spiegel eine Öffnung aufweist, so dass eine Obskuration der Pupille auftritt.

Bei einem System wie in der US 6,750,948 beschrieben, nimmt man eine Abschattung der Pupille in Kauf, um im hochaperturigen Teil des Objektives, insbesondere auf dem im Lichtweg vorletzten Spiegel kleine Einfallswinkel zu erhalten.

Nachteilig an dem in der US 6,750,948 beschriebenen System ist jedoch der sehr kleine Arbeitsabstand, der einschließlich der endlichen Spiegeldicke des vorletzten Spiegels lediglich maximal 12 mm beträgt.

Ein derartig kleiner Arbeitsabstand ist insbesondere mit Blick auf die Steifigkeit des Spiegels problematisch.

Bei dem System gemäß der US 6,750,948 ist eine Vergrößerung des Arbeitsabstandes aber nicht möglich, da durch den geringen Spiegeldurchmesser des im Lichtweg vorletzten Spiegels die Pupillenobskuration stark ansteigt, sobald der Arbeitsabstand vergrößert wird.

Ein obskuriertes System mit einer bildseitig sehr hohen Apertur zeigt die US 2004/0114217.

Ein Nachteil dieses Systems ist, dass die Spiegel des ersten Teilobjektives gemäß der US 2004/0114217 durchbrochene Spiegel, d.h. Spiegel mit einer Öffnung sind.

Nachteilig an einem System mit durchbrochenen Spiegeln im ersten Teilobjektiv ist, dass es für große Felder wie in der EUV-Lithographie benötigt, ungeeignet ist, da sämtliche Spiegel pupillennah angeordnet sind und daher keine Möglichkeit besteht, feldabhängige Bildfehler wie beispielsweise Telezentrie und Verzeichnung zu korrigieren.

Ein weiterer Nachteil aller aus dem Stand der Technik bekannten Systeme ist, dass sie nicht für eine Auflösung von Strukturen kleiner 50 nm mit ausreichender Reflektivität und Winkelbandbreite geeignet sind.

Ein weiterer Nachteil aller aus dem Stand der Technik bekannten Objektiv, insbesondere bei Verwendung in Projektionssystemen für die Mikrolithographie ist, dass für die Korrektur bzw. zur Minimierung der chromatischen Bildfehler unterschiedliche Glassorten oder aber entsprechend schmalbandige und daher sehr teure Laser verwendet werden müssen.

Breitbandige Lichtquellen, wie sie z.B. in Form von Leuchtdioden, sogenannten LEDs auch für den UV-Bereich entwickelt werden, erzeugen so starke chromatische Aberrationen, dass sie als Lichtquelle in herkömmlichen refraktiven Lithographiesystemen nicht verwendet werden können. Leuchtdioden, sogenannte LEDs im blauen, insbesondere im UV-Bereich emittieren Wellenlängen von beispielsweise 365nm, 280nm oder 227nm Die Bandbreite dieser Leuchtdioden beträgt zwischen +/-20nm und +/-50nm. Die Lichtausgangsleistungen liegen bei Werten bis zu 100mW.

Aufgabe der Erfindung ist es somit, die Nachteile des Standes der Technik zu überwinden.

Dazu wird ein katoptrisches Projectionsobjektiv gemass Anspruch 1 angegeben.

Insbesondere soll ein hochaperturiges Objektiv, insbesondere Projektionsobjektiv angegeben werden, das zum einen durch geringe Einfallswinkel charakterisiert ist, zum anderen soll in einer besonders bevorzugten Ausführungsform ein ausreichender Arbeitsabstand des physikalisch zur Bildebene am nächsten angeordneten Spiegels gegeben sein. Bevorzugt liegt eine bildseitig telezentrische Strahlführung vor.

Insbesondere soll in einem weiteren, zweiten Aspekt der Erfindung auch ein System angegeben werden, mit denen Strukturen kleiner 50 nm aufgelöst werden können. Dies soll insbesondere für Systeme gelten, die mit Wellenlängen $\leq$ 193 nm, insbesondere $\leq$ 157 nm, ganz besonders $\leq$ 100 nm betrieben werden.

Insbesondere soll in einem weiteren, dritten Aspekt der Erfindung auch ein System angegeben werden, welches die Verwendung einer breitbandigen Lichtquelle (z.B. LEDs) erlaubt, bzw. welches die Verwendung verschiedener diskreter Lichtwellenlängen z.B. bei 633nm und 248nm ermöglicht.

Bevorzugt ist das Mikrolithographie-Projektionsobjektiv gemäß der Erfindung in ein erstes Teilobjektiv, welches wenigstens einen Spiegel aufweist und ein zweites Teilobjektiv, das wenigstens zwei weitere Spiegel aufweist unterteilt.

Die zuvor aufgeführte Aufgabe wird in einem ersten Aspekt der Erfindung durch ein Objektiv, insbesondere Mikrolithographie-Projektionsobjektiv mit einem ersten Teilobjektiv, das wenigstens einen Spiegel aufweist und einem zweiten Teilobjektiv, das einen primären Konkavspiegel und einen sekundären Konkavspiegel aufweist, gelöst, wobei der Spiegel des ersten Teilobjektives keine Öffnung für den Durchtritt eines Strahlbüschels, das das Projektionsobjektiv von der Objektseite zur Bildseite durchläuft, aufweist. Erfindungsgemäß weisen, wenigstens zwei Spiegel des zweiten Teilobjektives die als Konkavspiegel, nämlich als primärer und sekundärer Konkavspiegel ausgebildet sind, einen Durchtritt für das Strahlbüschel auf. Unter einem "Spiegel" wird in der vorliegenden Anmeldung stets der optisch genutzte Bereich der Spiegeloberfläche verstanden. Der optisch genutzte Bereich ist der Bereich, auf den die Lichtstrahlen, die das Objektiv von der Objektebene zur Bildebene durchlaufen, auftreffen. Durch die Ausgestaltung der beiden Spiegel des zweiten Teilobjektives als Konkavspiegel ist es möglich, dass der primäre Konkavspiegel einen Abstand von der Bildebene aufweist, der mehr als 12 mm insbesondere mehr als 15 mm beträgt.

Ein derartig großer Abstand des primären Konkavspiegels zur Bildebene ermöglicht zum einen, dass das zu beleuchtende Objekt, bspw. der Wafer, in der Bildebene leicht gehandhabt werden kann, zum anderen aber auch eine Ausgestaltung des Spiegels mit einer ausreichenden Spiegeldicke, was wiederum zu einer erhöhten Stabilität des Spiegels führt, da zwischen dem Spiegel und der Bildebene ein ausreichender Bauraum vorhanden ist. Unter Abstand des primären Konkavspiegels von der Bildebene wird der Abstand des Vertex der Spiegelfläche des primären Konkavspiegels von der Bildebene verstanden.

Besonders bevorzugt beträgt dieser Abstand mehr als 12 mm, insbesondere mehr als 15mm, besonders bevorzugt mehr als 30 mm, insbesondere mehr als 60 mm.

Durch die Obskuration der Pupille aufgrund des primären Konkavspiegels des Projektionsobjektives, der eine Öffnung für den Durchtritt des Strahlbüschels, das das Projektionsobjektiv durchläuft, aufweist, ist es möglich, dass das Projektionssystem eine bildseitige numerische Apertur NA aufweist, die NA > 0,4, bevorzugt NA > 0,5, ganz bevorzugt NA > 0,6, insbesondere bevorzugt NA > 0,7 ist.

Für VUV-, DUV, und UV-Projektionsobjektive mit Wellenlängen $\geq$ 157 nm kann der primäre Konkavspiegel als Mangin-Spiegel ausgelegt sein. Beim Mangin-Spiegel durchtritt der einfallende Lichtstrahl ein Linsenmaterial, bspw.$CaF_2$ bei Wellenlängen von 157 nm oder $SiO_2$ bei 193 nm, und wird auf der Rückseite der Linse, die mit einer reflektierenden Beschichtung versehen sein kann, reflektiert. Auf diese Weise ist es möglich, einen sehr dicken und damit stabilen Spiegel auszubilden, der nur einen sehr geringen Abstand zur Bildebene, in der das zu beleuchtende Objekt angeordnet ist, aufweist.

In einer besonders bevorzugten Ausführungsform der Erfindung, weist der wenigstens eine Spiegel des ersten Teilobjektives eine reflektierende Oberfläche auf, auf den das Strahlbüschel, das das Mikrolithographie-Projektionsobjektiv von der Objektebene zur Bildebene durchläuft, auftrifft und die reflektierende Oberfläche bildet ein erstes außeraxiales Segment aus.

Die Objektive, insbesondere Mikrolithographie-Projektionsobjektive gemäß der Erfindung weisen eine Symmetrieachse auf, die auch als optische Achse bezeichnet wird. In einer bevorzugten Ausführungsform sind die Spiegel rotationssymmetrisch zur optischen Achse. Unter einem außeraxialen Segment oder einem sogenannten Off-Axis-Segment eines Spiegels versteht man ein Spiegelsegment, das nur ein Teil der um diese Achse rotationssymmetrischen Spiegelfläche, nämlich einen außeraxialen Teil des Spiegels umfasst.

Neben dem ersten Teilobjektiv, das die sogenannte Feldgruppe des Objektives bezeichnet, und dem zweiten Teilobjektiv, das auch als Relay-Gruppe bezeichnet wird, umfasst in einer vorteilhaften Ausführungsform das Mikrolithographie-Projektionsobjektiv ein drittes Teilobjektiv das im Lichtweg von der Objektebene zur Bildebene nach dem ersten Teilobjektiv und vor dem zweiten Teilobjektiv ausgebildet wird.

Das dritte Teilobjektiv wird auch als sogenannte Transfergruppe bezeichnet.

Bei einer besonders vorteilhaften Ausgestaltung der Erfindung bildet bei einem Projektionsobjektiv, das aus insgesamt drei Teilobjektiven bzw. drei Teilgruppen aufgebaut ist, das erste Teilobjektiv, die sogenannte Feldgruppe, das Objekt auf ein erstes Zwischenbild ab.

Da das erste Teilobjektiv in dem Teil des Gesamtobjektives liegt, der eine niedrige Apertur aufweist, wird eine abschattungsfreie Strahlführung auch bei der Verwendung von außeraxialen oder sogenannten off-axis Spiegelsegmenten erreicht. Durch die Verwendung von off-axis-Segmenten im ersten Teilobjektiv können feldabhängige Bildfehler wie beispielsweise Telezentrie und Verzeichnung korrigiert werden, da die off-axis-Segmente feldnah angeordnet werden können.

Im ersten Teilobjektiv kann des weiteren eine zugängliche Pupillenebene ausgebildet werden, die entweder direkt auf einem Spiegel oder aber zwischen zwei Spiegel des ersten Teilobjektives angeordnet ist und in der eine Aperturblende sowie ein die Pupillenobskuration definierendes Abschattungselement angeordnet sein kann. Durch die Anordnung des Absohattungselementes für die Pupillenobskuration in einer Pupillenebene wird eine feldunabhängige Pupillenobskuration erreicht. Würde das Abschattungselement nicht in einer Pupillenebene angeordnet, so ergäbe sich eine feldabhängige Pupillenobskuration. Eine feldabhängige Pupillenobskuration ist aber für die Verwendung des Projektionsobjektives in der Mikrolithographie für lithographische Abbildungen ungeeignet, da hierdurch eine feldabhängige Variation des Auflösungsvermögens erzeugt wird.

In einer besonders vorteilhaften Ausführungsform, umfasst das erste Teilobjektiv mehr als zwei, nämlich vier Spiegel, wobei insbesondere die Spiegelabfolge konkav - konvex - konvex - konkav der vier Spiegel des ersten Teilobjektives von besonderem Vorteil ist.

Alternativ kann die Spiegelabfolge der vier Spiegel des ersten Teilobjektives auch konvex-konkav-konvex-konkav sein. In einer besonders vorteilhaften Ausführungsform ist der Krümmungsradius des ersten Spiegels sehr groß gewählt, insbesondere größer als 10.000 mm. Dabei sind auch die Spiegelabfolgen plan-konkav-konvex-konkav oder konkav-konkav-konvex-konkav für die vier Spiegel des ersten Teilobjektives möglich.

In einer weitergebildeten Ausführungsform kann das erste Teilobjektiv sechs Spiegel umfassen. Für die sechs Spiegel des ersten Teilobjektives sind verschiedene Spiegelabfolgen denkbar. So ist in einer ersten Ausführungsform die Spiegelabfolge konvex - konkav - konvex - konkav - konkav - konvex, in einer zweiten Ausführungsform konvex - konkav - konkav - konkav - konvex - konkav, in einer dritten Ausführungsform konkav - konkav - konvex - konkav - konvex - konkav, in einer vierten Ausführungsform konkav - konvex -konkav - konkav - konvex - konkav, und in einer fünften Ausführungsform konkav - konvex - konkav - konkav - konvex - konkav möglich.

In einer bevorzugten Ausführungsform ist der Krümmungsradius des ersten Spiegels des ersten Teilobjektives sehr groß gewählt, bevorzugt größer als 10.000 mm. Daher sind auch nachfolgende Spiegelabfolgen im ersten Teilobjektiv möglich, da der erste Spiegel entweder plan oder konvex oder konkav ausgebildet werden kann:

konkav - konkav - konvex - konkav - konkav - konvex
plan- konkav - konvex - konkav - kondav - konvex
konvex - konkav - konvex - konkav - konvex - konkav
plan - konkav - konvex - konkav - konvex - konkav
konvex - konvex - konkav - konkav - konvex - konkav
plan - konvex - konkav - konkav - konvex - konkav
konvex - konvex - konkav - konkav - konvex - konkav
plan - konvex - konkav - konkav - konvex - konkav

Um niedrige Einfallswinkel insbesondere auf dem im Lichtweg von der Objektebene zur Bildebene zweiten Spiegel im ersten Teilobjektiv zu erreichen, ist es vorteilhaft den im Lichtweg von der Objektebene zur Bildebene zweiten Spiegel im ersten Teilobjektiv als Konkavspiegel auszubilden.

In einer weitergebildeten Ausführungsform umfasst das Objektiv, insbesondere das Mikrolithographie-Projektionsobjektiv ein drittes Teilobjektiv, das auch als Transfergruppe bezeichnet wird. Das dritte Teilobjektiv besteht bevorzugt aus wenigstens zwei Spiegeln, in einer besonders vorteilhaften Ausführungsform aus genau zwei Spiegeln. Dieses dritte Teilobjektiv hat die Aufgabe, den niederaperturigen Objektivteil in einen hochaperturigen Objektivteil zu transformieren, d. h. im Wesentlichen den Abbildungsmaßstab bzw. Abbildungsfaktor einzustellen. Besonders vorteilhaft ist es, wenn einer der beiden Spiegel der Transfergruppe konvex und der andere konkav ausgebildet ist. Werden die Spiegel der Transfergruppe des dritten Spiegels und vierten Spiegels bezeichnet, so bedeutet dies, dass bevorzugt entweder der dritte Spiegel konvex ausgebildet ist und der vierte Spiegel konkav oder der dritte Spiegel konkav und der vierte Spiegel konvex.

Bevorzugt ist das Mikrolithographie-Projektionssystem derart ausgestaltet, dass das erste Teilobjektiv die Objektebene auf ein erstes Zwischenbild, das dritte Teilobjektiv das erste Zwischenbild auf ein zweites Zwischenbild und das zweite Teilobjektiv das zweite Zwischenbild in die Bildebene abbildet.

Um die Spiegelbohrungen und damit die notwendigen Obskurationen, insbesondere die Pupillenobskuration gering zu halten, ist es vorteilhaft die Öffnungen, d.h. die Spiegelbohrungen so klein wie möglich zu halten. Dies wiederum ist möglich, wenn gemäß einem weiteren Aspekt der Erfindung bei einem Mikrolithographie-Projektionsobjektiv umfassend mehrere Spiegel die Zwischenbilder des Systems, zwischen einzelnen Teilobjektiven in der Nähe der Spiegelbohrungen ausgebildet werden. Besonders vorteilhaft ist es, wenn das erste Zwischenbild physikalisch in der Nähe des vierten Spiegels liegt und das zweite Zwischenbild physikalisch in der Nähe des dritten Spiegels. Physikalisch in der Nähe bedeutet, dass der Abstand des jeweiligen Zwischenbildes von dem Scheitelpunkt der Spiegeloberfläche einen entlang der optischen Achse gemessenen Abstand von weniger als 1/10 der Baulänge des Objektives aufweist. Unter der Baulänge des Objektivs wird der Abstand entlang der optischen Achse von der Objektebene zur Bildebene verstanden.

Wie zuvor beschrieben erzeugt das dritte Teilobjektiv das zweite Zwischenbild, welches in der Regel durch die bevorzugte Lage am dritten Spiegel für eine Bildebene nicht zugänglich ist. Das zweite Zwischenbild wird durch das zweite Teilobjektiv bevorzugt so in die Bildebene abgebildet, dass ein unter Berücksichtigung der notwendigen Spiegeldicke ausreichender Arbeitsabstand vor der Bildebene eingehalten werden kann.

Bevorzugt sind die Durchmesser des dritten Spiegels und des sekundären Konkavspiegels nicht wie in der US 2004/0114217 A1 stark unterschiedlich voneinander, sondern im Wesentlichen von der gleichen Größenordnung. In einer bevorzugten Ausführungsform unterscheiden sich die Durchmesser der beiden Spiegel nur um einen Faktor 2 voneinander.

In einer besonders bevorzugten Ausführungsform wird bei einem derartigen System, bei dem der dritte Spiegel und der sekundäre Konkavspiegel im wesentlichen den gleichen Durchmesser aufweisen vorgeschlagen, dass die Durchmesser d1 und d2 des sekundären Konkavspiegels (d1) und des dritten Spiegels (d2) sowie die Abstände des Zwischenbildes von den beiden Spiegeloberflächen z1 und z2 der Bedingung

$$\frac{d1}{d2} \approx \frac{z1}{z2}$$

entsprechen, d. h. das Verhältnis $\dfrac{d1}{d2}$ entspricht ungefähr dem Verhältnis $\dfrac{z1}{z2}$. Dabei bezeichnet d1 den Durchmesser des sekundären Konkavspiegels, d2 den Durchmesser des dritten Spiegels, z1 den Abstand des zweiten Zwischenbildes von der Spiegeloberfläche des sekundären Konkavspiegels und z2 den Abstand des zweiten Zwischenbildes von der Spiegeloberfläche des dritten Spiegels.

Die Erfinder haben nun herausgefunden, dass wenn diese Bedingung erfüllt ist, die Obskuration des Systems minimal wird. Insbesondere kann eine ungewünschte Vergrößerung der Pupillenobskuration verhindert werden.

In einer besonders bevorzugten Ausführungsform der Erfindung werden die Spiegelflächen des im Lichtweg von der Objektebene zur Bildebene viertletzten und des letzten Spiegels als Doppelspiegel ausgebildet. Bei einem derartigen Doppelspiegel werden die beiden reflektierenden Vorder- und Rückflächen eines Substrates verwandt, wobei in den Doppelspiegel eine Aperturöffnung, bspw. in Form einer Bohrung eingelassen ist. Die beiden Seiten des Substrates werden bei einem derartigen Doppelspiegel jeweils auf der Vorder- und Rückseite mit einer hochreflektierenden Schicht, bspw. für Röntgenlithographie mit Wellenlängen von λ = 13 nm umfassend 40 Schichtpaare aus Mo/Si bedampft. Bei einem System mit drei Teilobjektiven ist der viertletzte Spiegel der dritte Spiegel, und der letzte Spiegel im Lichtweg von der Objektebene zur Bildebene der sekundäre Konkavspiegel.

Ein derartiger Doppelspiegel hat den Vorteil, dass er sich wie eine Linse herstellen und fassen lässt. Eine Ausgestaltung in Form zweier Spiegel wäre aber auch möglich. Jedoch müssen dann beide Spiegel aus einem Material gefertigt werden, welches eine große Steifigkeit besitzt (z.B. Siliziumcarbid)

In einer vorteilhaften Ausführungsform ist vorgesehen, dass um eine möglichst geringe Obskuration zu erzielen, die Aperturöffnung des Doppelspiegels, hier die Bohrung, konisch ausgestaltet ist.

Durch die Ausgestaltung eines Doppelspiegels wird eine hohe mechanische Stabilität erreicht.

Um einen ausreichenden Abstand zur Bildebene zu gewährleisten, kann bei Wellenlängen im UV, DUV- oder VUV-Bereich auch einen Mangin-Spiegel verwandt werden.

Die Ausgestaltung eines Mangin-Spiegels ist beispielsweise aus Lexikon der Optik, Seite 223 bekannt.

In einer besonders vorteilhaften Ausgestaltung der Erfindung werden auf den Spiegeln niedrigere Einfallswinkel dadurch erreicht, dass der im Lichtweg von der Objektebene zur Bildebene zweite Spiegel als Konkavspiegel ausgebildet ist.

In einer weiteren bevorzugten Ausführungsform der Erfindung sind die Aperturblenden und die Abschattungsblenden des Systems nicht an einem Ort, sondern in zwei zueinander konjugierten Blendenebenene angeordnet, wobei die Blendenebenen wiederum konjugierte Ebenen zur Eintrittspupille des Projektionsobjektives darstellen, d. h. sog.

**EP 1 828 829 B1**

Pupillenebenen sind.

Durch eine Anordnung sowohl der Abschattungsblende wie der Aperturblende entfernt von einem Spiegel ergeben sich sowohl optische als auch mechanische Vorteile. Eine direkt vor einem Spiegel angeordnete Apertur- oder Obskurationsblende wird zwangsläufig zweifach vom Lichtbündel durchtreten, so dass unvermeidliche Vignettierungen auftreten, die die Abbildungsqualität beeinträchtigen. Aus mechanischer Sicht ist eine Anordnung einer Apertur- oder Obskurationsblende nahe bei einem Spiegel schwierig, da zum einen die benötigten Bauräume sich gegenseitig begrenzen und einengen und zum anderen die mechanischen Positionstoleranzen sehr eng gehalten werden müssen. Realisiert man die Obskurationsblende durch eine Antireflexbeschichtung auf einem Spiegel - wie dies in der US 6,750,648 offenbart wird - so ist ein Auswechseln der Obskurationsblende, die auch als Abschattungsblende bezeichnet werden, nur durch das Auswechseln des gesamten Spiegels möglich, was aufwändig und teuer ist. Während die Aperturblende das Lichtbüschel nach außen begrenzt und den äußeren Radius, den sog. Aperturradius, festlegt, wird durch die Abschattungsblende die feldunabhängige Obskuration definiert, also der innere Radius des Lichtbüschels, der das Projektionssystem von der Objektebene zur Bildebene durchläuft.

In einer besonderen Ausgestaltung der Erfindung werden Mikrolithographie-Projektionsobjektive mit einem zweiten Teilobjektiv, das zwei Konkavspiegel umfasst, angegeben, die aber lediglich ein erstes Teilobjektiv aufweisen, das als sogenannte Feldgruppe bezeichnet wird. Die Feldgruppe umfasst lediglich sogenannte off-axis Spiegelsegmente. Diese Objektive verfügen über kein drittes Teilobjektiv, d.h. keine Transfergruppe mit Spiegeln, die einen Durchtritt für ein Strahlbüschel aufweisen. Der Vorteil derartiger Objektive ist, dass durch den Wegfall der Transfergruppe zwei Spiegel eingespart werden können. Hierdurch kann die Lichttransmission vergrößert werden und der Herstellaufwand gesenkt werden. Bei den vorliegenden Objektiven wird die Wirkung der Transfergruppe, nämlich die Vermittlung von der niedrigaperturigen Feldgruppe zur hochaperturigen Aperturgruppe durch Feld- und Aperturgruppe selbst bewerkstelligt. Die Feldgruppe umfasst bei den bevorzugten Ausführungsbeispielen sechs Spiegel, die Spiegelfolge ist beispielsweise konkav-konkav-konvex-konkav-konvex-konkav oder konkav-konvex-konkav-konvex-konvex-konkav. In besonders bevorzugten Ausführungsformen derartiger Objektive können besonders kleine Hauptstrahlwinkel und Aperturen von NA=0,7 erreicht werden.

Gemäß einem zweiten weiteren Aspekt der Erfindung wird ein Objektiv angegeben, mit dem es möglich ist, Strukturen mit einer Strukturgröße im Bereich von 50 nm und weniger bei einer Wellenlänge ≤ 193nm, also insbesondere auch 193nm, 157nm oder bei einer Wellenlänge von ca. 100nm aufzulösen. Dieser zweite Aspekt der Erfindung wird durch ein System gelöst, wobei das System derart aufgebaut ist, dass die bildseitige numerische Apertur NA größer als 0,7 ist. Bevorzugt ist die numerische Apertur größer als 0,72, bevorzugt größer als 0,80, ganz bevorzugt beträgt sie 0,90.

Ein Objektiv gemäß dem zweiten weiteren Aspekt der Erfindung weist bevorzugt mehr als acht Spiegel, insbesondere wenigstens zehn Spiegel auf. Alternativ oder zusätzlich kann ein Objektiv gemäß dem zweiten Aspekt der Erfindung ein Bildfeld aufweisen, wobei wenigstens eine Bildfeldabmessung bzw. Bildfelddimension größer als 1 mm ist.

In einer besonderen Ausführungsform zeichnet sich ein System mit hoher numerischer Apertur dadurch aus, dass der größte Einfallswinkel des Hauptstrahles zu einem zentralen Feldpunkt auf allen Spiegeln geringer ist als 30°

In einer bevorzugten Ausführungsform eines Systems gemäß einem zweiten Aspekt der Erfindung weist das System zwei Teilsysteme auf, ein erstes Teilsystem und ein zweites Teilsystem.

Bevorzugt umfasst das erste Teilsystem nur Spiegel ohne eine zentrale Öffnung, die bevorzugt außeraxial zu einer Hauptachse des Projektionsobjektives angeordnet ist. Diese Spiegel werden daher durch sogenannte off-axis Segmente gebildet. Das erste Teilsystem wird auch als Feldgruppe bezeichnet.

Das zweite Teilsystem umfasst wenigstens einen Spiegel mit zentraler Öffnung Das zweite Teilsystem wird auch als Aperturgruppe bezeichnet.

In einer ersten Ausführungsform gemäß dem zweiten weiteren Aspekt der Erfindung umfasst die Feldgruppe acht Spiegel, die sich in ein erstes Teilobjektivsubsystem mit sechs Spiegeln und ein zweites Teilobjektivsubsystem mit zwei Spiegeln unterteilt. Bevorzugt ist die Spiegelfolge der Feldgruppe konkav-konkav-konvex-konkav-konkav-konvex-konvex-konkav. Dadurch, dass die Feldgruppe acht Spiegel umfasst, können feldabhängige Bildfehler sehr gut korrigiert werden.

Die Aperturgruppe bei dem ersten Ausführungsbeispiel gemäß dem weiteren Aspekt der Erfindung umfasst zwei Konkavspiegel.

In einer zweiten Ausführungsform gemäß dem zweiten weiteren Aspekt der Erfindung umfasst die Feldgruppe sechs Spiegel mit der Spiegelfolge konkav-konkav-konvex-konkav-konvex-konkav. Die Feldgruppe ist in ein erstes Teilobjektivsubsystem mit vier Spiegeln und ein zweites Teilobjektivsubsystem mit zwei Spiegeln unterteilt. Die Aperturgruppe umfasst ein erstes Teilobjektivteilsystem aus zwei Konkavspiegel und ein zweites Teilobjektivteilsystem aus zwei Konkavspiegeln. Insgesamt werden in dem Objektiv gemäß dem zweiten Ausführungsbeispiel insgesamt drei Zwischenbilder ausgebildet. Das zweite Ausführungsbeispiel zeichnet sich dadurch aus, dass eine sehr hohe Apertur bei sehr niedrigen Einfallswinkeln erreicht wird. So beträgt der Einfallswinkel des Hauptstrahles zum zentralen Feldpunkt beim zweiten Ausführungsbeispiel gemäß dem weiteren Aspekt der Erfindung weniger als 30°. Desweiteren zeichnet sich das System gemäß dem zweiten Ausführungsbeispiel zum zweiten weiteren Aspekt der Erfindung durch große Driftstrecken zwischen den Spiegeln aus.

In einer dritten Ausführungsform gemäß dem zweiten weiteren Aspekt der Erfindung umfasst die Feldgruppe sechs Spiegel. Die Spiegelfolge in der Feldgruppe ist: konvex-konkav-konkav-konvex-konvex-konkav. Die Aperturgruppe ist ebenfalls in ein erstes Teilobjektivteilsystem und in ein zweites Teilobjektivteilsystem unterteilt. Die Spiegelfolge in der Aperturgruppe ist: konvex-konkav-konkav-konkav. Insgesamt weist das Objektiv zwei Zwischenbilder auf. Das Objektiv zeichnet sich insbesondere durch eine sehr hohe Apertur aus.

In einem weiteren dritten Aspekt der Erfindung wird ein System mit wenigstens acht Spiegeln zur Verfügung gestellt, wobei das System derart aufgebaut ist, dass die bildseitige numerische Apertur NA größer als 0,5, insbesondere größer als 0,7 ist, wobei im Strahlengang zwischen Objektebene und Bildebene maximal ein Zwischenbild ausgebildet wird.

In einer alternativen Ausführungsform weist das System gemäß einem weiteren, dritten Aspekt der Erfindung zwei Teilobjektive auf und das zweite Teilobjektiv weist wenigstens einen Spiegel auf, der eine Öffnung für den Durchtritt eines Strahlbüschels aufweist. In einer besonderen Ausführungsform zeichnen sich diese Systeme dadurch aus, dass der größte Einfallswinkel des Hauptstrahles zu einem mittleren Feldpunkt auf allen Spiegeln geringer ist als 30 °, bevorzugt geringer ist als 26°.

In einer bevorzugten Ausführungsform eines Systems gemäß dem weiteren, dritten Aspekt umfasst das erste Teilsystem nur Spiegel ohne eine zentrale Öffnung, die bevorzugt außeraxial zu einer Hauptachse des Projektionsobjektives angeordnet ist. Diese Spiegel werden dann durch sogenannte off-axis Segmente gebildet. Das erste Teilsystem wird auch als Feldgruppe bezeichnet.

Bevorzugt umfasst das zweite Teilsystem wenigstens einen Spiegel mit zentraler Öffnung. Das zweite Teilsystem wird auch als Aperturgruppe bezeichnet.

In einer bevorzugten Ausführungsform umfasst die Feldgruppe sechs Spiegel mit der Spiegelfolge konvex-konkav-konkav-konvex-konvex-konkav und weist eine Zentralabschattung in der Pupille auf, die flächenmäßig weniger als 12% der gesamten ausgeleuchteten Pupille beträgt. Der Vorteil dieser Ausführungsform liegt in der sehr geringen Abschattung der Pupille. Ein weiterer Vorteil dieser Ausführungsform liegt darin, dass die Eintrittspupille eine negative Schnittweite aufweist. Dies ermöglicht es im Beleuchtungssystem auf zwei Spiegel zu verzichten, wodurch die Transmission für das Gesamtsystem erhöht wird.

In einer alternativen Ausführungsform der Erfindung umfasst die Feldgruppe sechs Spiegel mit der Spiegelabfolge konkav-konkav-konvex-konkav-konkav-konvex, wobei der Krümmungsradius des ersten Spiegel so groß ist, dass er alternativ auch plan oder konvex ausgelegt werden kann. Die Schnittweite der Eintrittspupille ist in diesem Beispiel positiv ausgelegt, so dass besonders kleine Einfallswinkel auf die Spiegeloberflächen in der Feldgrupppe auftreten, die < 26° sind.

Ohne erfinderisch tätig zu werden, können auch Systeme angegeben werden, bei denen die Hauptstrahlen am Retikel parallel zur optischen Achse verlaufen. Um die Beleuchtung für ein solches System zu ermöglichen, muss entweder eine transmissive Maske, d. h. eine Transmissionsmaske verwendet werden oder aber bei Verwendung einer Reflexionsmaske ein Strahlteiler oder halbdurchlässiger Spiegel in den Strahlengang eingebaut werden.

Die Aperturgruppe umfasst in einer bevorzugten Ausführungsform zwei Spiegel. Bevorzugt ist der erste Spiegel der Aperturgruppe ein Konvexspiegel und der zweite Spiegel der Aperturgruppe ein Konkavspiegel.

In einer besonders bevorzugten Ausführungsform der Erfindung wird genau ein Zwischenbild zwischen der Feldgruppe und der Aperturgruppe ausgebildet.

In einer bevorzugten Ausführungsform ist die Blende im Lichtweg zwischen dem ersten Spiegel der Aperturgruppe, d. h. dem siebten Spiegel und dem zweiten Spiegel der Aperturgruppe, d. h. dem achten Spiegel angeordnet. Durch diese Anordnung der Aperturblende ist es möglich, diese als Irisblende auszulegen, da genügend angrenzender Bauraum zur Verfügung steht.

Alternativ kann die Blende auch in der Feldgruppe nahe oder auf einem Spiegel angeordnet sein.

Weitere vorteilhafte Ausgestaltungen der Objektive, insbesondere der Projektionsobjektive und ihrer Anwendungen gemäß der vorliegenden Anmeldung sind insbesondere in den Unteransprüchen und der zugehörigen Figurenbeschreibung beschrieben.

Die hier beschriebenen Objektive werden insbesondere als Projektionsobjektive in Lithographie-Projektionsbelichtungsanlagen eingesetzt. In einer Lithographie-Projektionsbelichtungsanlage beleuchtet ein Beleuchtungssystem eine strukturtragende Maske (Retikel), welche von dem Projektionsobjektiv auf ein lichtempfindliches Substrat abgebildet wird. Derartige Lithographie-Projektionsbelichtungsanlagen sind aus dem Stand der Technik hinreichend bekannt, bspw. für die EUV-Lithographie aus der US 5,212,588, US 5,003,567, US 6,452,661 oder US 6,195,201 und für Lithographie mit Wellenlängen ≤ 193 nm aus US 6,512,641 und EP 1069448.

Insbesondere sind doppelt facettierte Beleuchtungssysteme bevorzugt, insbesondere solche, bei denen die Feldfacetten des Feldfacettenspiegels die Form des auszuleuchtenden Feldes in der Retikelebene aufweisen, d. h. bei auszuleuchtenden ringförmigen Feld in der Feldfacettenebene sind die Feldfacetten ringförmig ausgebildet. Ein feldformender Spiegel wird bei einem solchen System nicht benötigt.

Mikrostrukturierte Halbleiterbauelemente werden in einer Vielzahl von einzelnen, sehr komplexen Verfahrensschritten hergestellt. Ein wesentlicher Verfahrensschritt betrifft dabei das Belichten von lichtempfindlichem Substrat (Wafem), beispielsweise mit Fotolack versehene Silizium-Substraten. Dabei wird bei der Herstellung eines einzelnen sogenannten Schichten bzw. Layers das entsprechende Retikel von dem Projektionsobjektiv auf den Wafer abgebildet.

Die in der Erfindung beschriebenen Objektive, insbesondere die beschriebenen Projektionsobjektive haben zusammengefasst die im nachfolgenden Abschnitt dargestellten Vorteile für sich einzeln genommen oder in Kombination.

Ein Vorteil der beschriebenen katoptrischen Projektionsobjektive ist deren sehr große bildseitige numerische Apertur. Die Projektionsobjektive können eine große bildseitige numerische Apertur aufweisen und relativ niedrige Einfallswinkel der auf die reflektiven Elemente des Projektionsobjektives auftreffenden Strahlung. Demgemäß können Intensitätsschwankungen der von den reflektiven Elementen reflektierten Strahlung reduziert werden, verglichen mit Projektionsobjektiven bei denen die Strahlung auf eine oder mehrere reflektive Elemente in einem breiten Winkelbereich auftrifft. Die verminderten Intensitätsvariationen führen dazu, dass eine bessere Bildqualität erreicht wird. Des weiteren haben bestimmte Ausführungsformen der hier dargestellten Projektionsobjektive eine große bildseitige numerische Apertur und einen relativ großen Arbeitsabstand, was dazu führt, dass ausreichend Bauraum z. B. für die Waferstage zur Verfügung gestellt wird, und die Bildebene leicht zugänglich ist. Beispielsweise kann der bildseitige Arbeitsabstand 15mm und mehr betragen.

Des Weiteren sind in einigen Ausführungsbeispielen die Projektionsobjektive bildseitig telezentrisch. In bestimmten Ausführungsbeispielen können die Projektionsobjektive Spiegel umfassen, die Öffnungen zum Durchtritt von Strahlungen aufweisen, die derart ausgebildet sind, dass nur geringe Obskurationen der Pupille auftreten. Bestimmte Ausführungsbeispiele zeichnen sich durch eine sehr große Auflösung aus. Bspw. können die Projektionsobjektive Strukturen mit Strukturbreiten $\leq 50$ nm auflösen. Diese hohe Auflösung kann bei den erfindungsgemäßen Projektionsobjektiven zusammen mit einer hohen bildseitigen numerischen Apertur erreicht werden. Bevorzugt sind die Projektionsobjektive für die Verwendung von kurzen Wellenlängen bspw. Wellenlängen zwischen 10 nm und 30 nm ausgelegt.

Die Projektionsobjektive stellen eine Abbildung mit geringen Aberrationen zur Verfügung. In bestimmten Ausführungsformen haben die Projektionsobjektive einen Wellenfrontfehler von 10 m$\lambda$ oder weniger. In einigen Ausführungsbeispielen sind die Verzeichnungen auf Werte besser als 1 nm korrigiert.

Die Projektionsobjektive können eine oder mehrere Pupillenebenen umfassen, die zum Einbringen einer Aperturblende oder einer Obskurationsblende bzw. Abschattungsblende in der Pupillenebene zugänglich ausgebildet sein kann.

Die hier beschriebenen Projektionsobjektive können für den Betrieb bei einer Vielzahl von unterschiedlichen Wellenlängen ausgelegt sein, bspw. Wellenlängen im sichtbaren Bereich des Lichtes oder UV-Wellenlängen. Ganz besonders bevorzugt sind die Ausführungsbeispiele für den Betrieb bei EUV-Wellenlängen ausgelegt. In einer weiteren Ausgestaltung der Erfindung können Ausführungsbeispiele für die Verwendung bei einer oder mehrerer Wellenlängen oder in einem Wellenlängenbereich ausgelegt sein.

In bestimmten Ausführungsbeispielen eines Projektionsobjektives können sehr niedrige Winkel am Retikel vorliegen bei einer relativ hohen bildseitigen Apertur. Bspw. kann Strahlung des Beleuchtungssystems auf das Retikel mit Winkeln < 10° oder weniger, bspw. ungefähr 7 ° in Bezug auf die optische Achse auftreffen, wobei das Projektionsobjektiv eine bildseitige numerische Apertur von 0,4 oder mehr aufweist.

In bestimmten Ausführungsbeispielen verfügen die Projektionsobjektive über Eigenschaften, die eine Reduktion der Komplexität des Beleuchtungssystems ermöglichen. Bspw. kann die Lage der Eintrittspupille des Projektionsobjektives im Lichtweg vor der Objektebene liegen. Mit anderen Worten sind Hauptstrahlen, die von verschiedenen Feldpunkten ausgehen divergent in Bezug zueinander und in Bezug auf die optische Achse. Dies macht die Eintrittspupille des Projektionsobjektives bzw. die Austrittspupille des Beleuchtungssystems zugänglich, ohne dass eine optische Komponente, bspw. ein Teleskopsystem im Beleuchtungssystem notwendig ist, um die Austrittspupille des Beleuchtungssystems an den Ort der Eintrittspupille des Projektionsobjektives abzubilden.

In bestimmten Ausführungsbeispielen können die Projektionsobjektive einen relativ großen Arbeitsraum nahe zu der Position, an der die optische Achse die Objektebene schneidet, aufweisen. Dies ermöglicht die Anordnung von Komponenten, insbesondere Komponenten des Beleuchtungssystems nahe dem Retikel. In einigen Ausführungsbeispielen kann dies dadurch erreicht werden, dass das Projektionsobjektiv so aufgebaut bzw. designed wird, dass der Spiegel, der physikalisch am nächsten zur Objektebene ist, relativ weit von der optischen Achse entfernt, positioniert wird. In derartigen Ausführungsbeispielen kann es sein, dass das Strahlbündel, das vom Retikel zum ersten Spiegel des Projektionsobjektives läuft sich mit dem Strahlbündel, das vom zweiten Spiegel zum dritten Spiegel des Projektionsobjektives läuft, schneidet.

Von der Offenbarung werden in vorliegender Anmeldung auch sämtliche Kombinationen von Merkmalen umfasst, auch wenn sie nur für sich alleine angegeben sind und ohne dass die Kombination explizit beschrieben ist.

Die Erfindung soll nunmehr näher anhand der Zeichnungen erläutert werden, ohne dass die Erfindung auf diese Ausführungsbeispiele beschränkt ist. Weitere Vorteile und Eigenschaften der Erfindung gehen aus der nachfolgenden beispielhaften Beschreibung hervor.

Es zeigen:

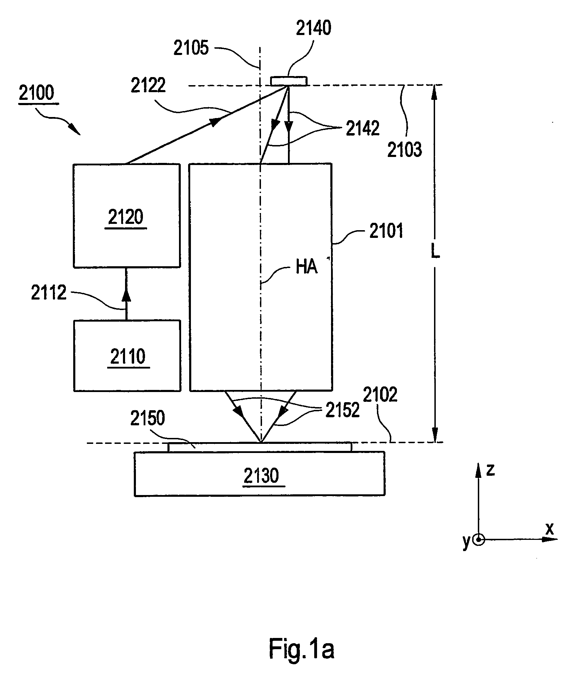

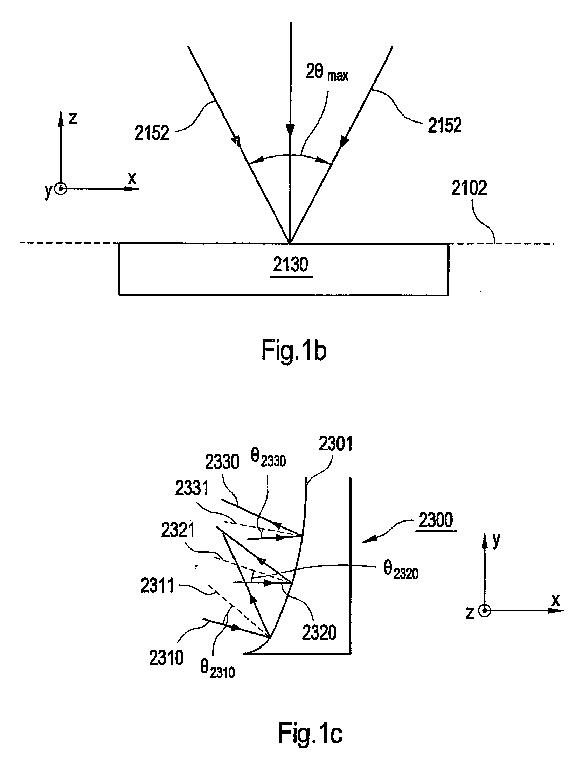

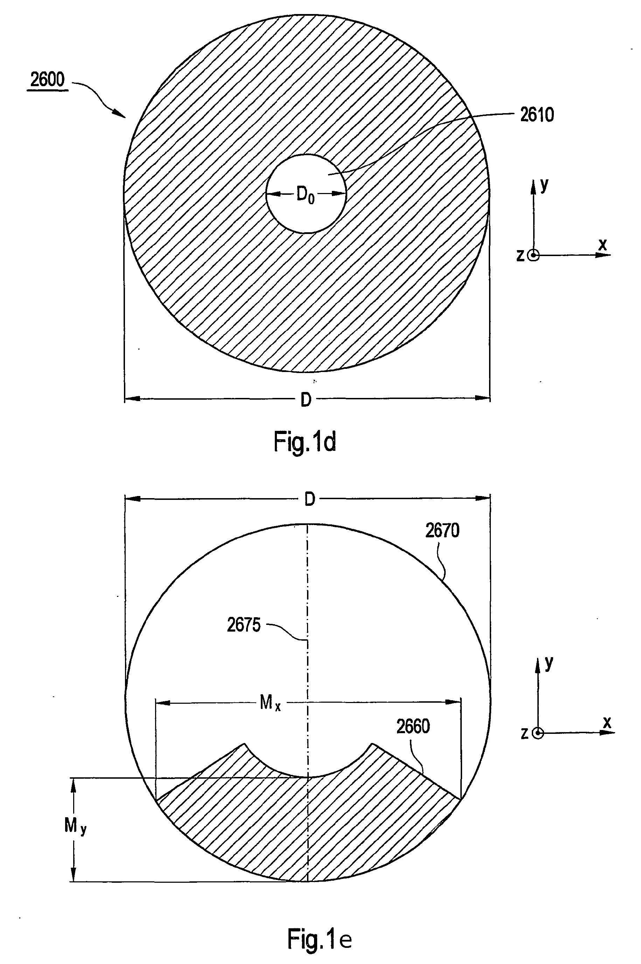

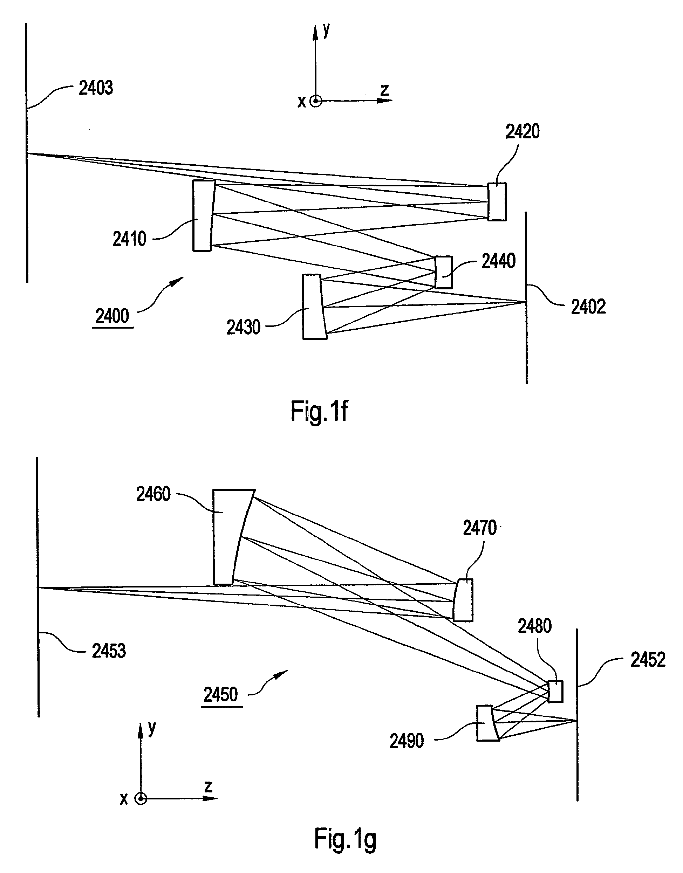

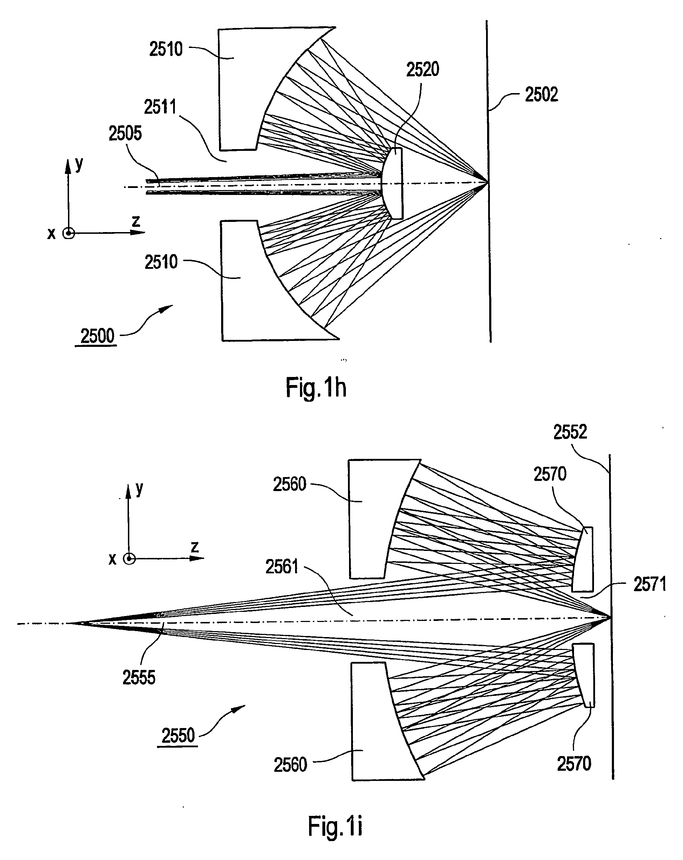

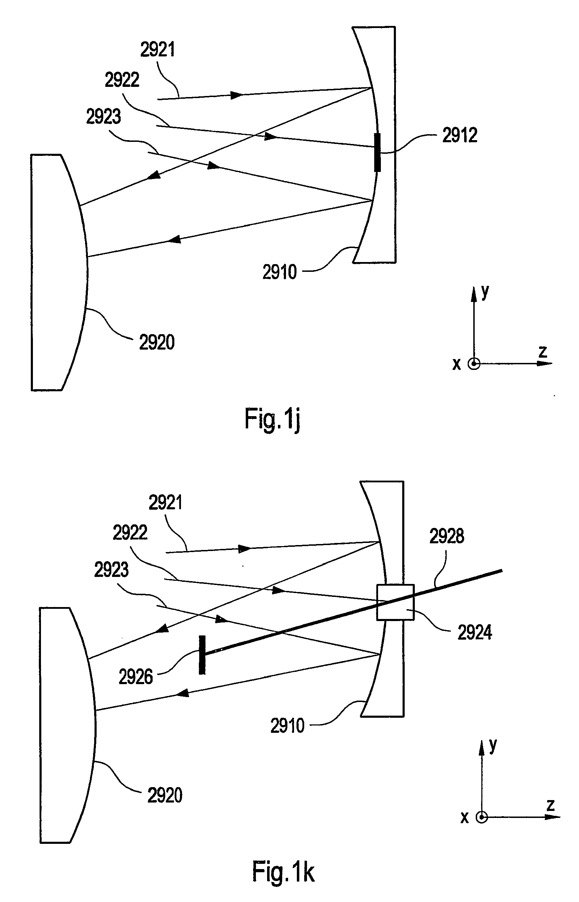

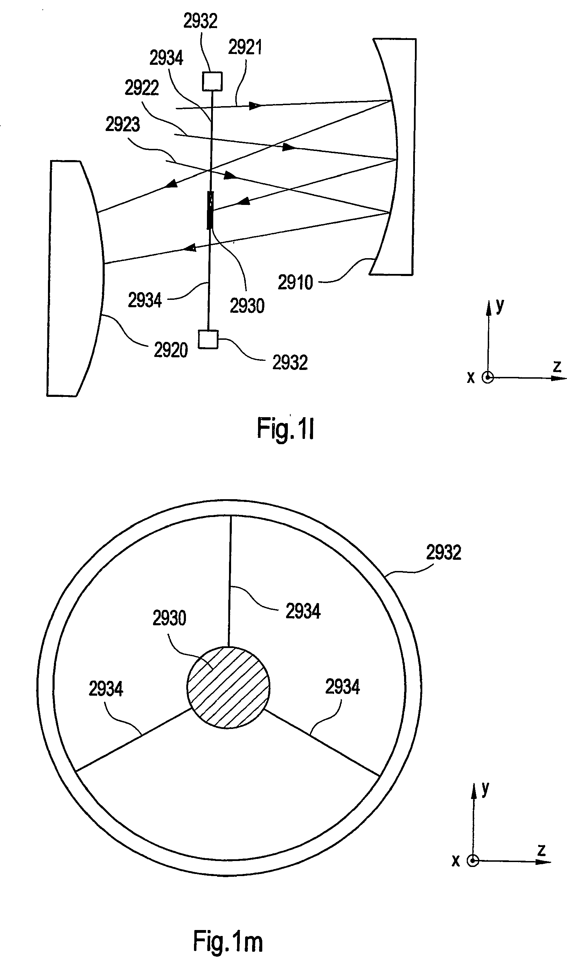

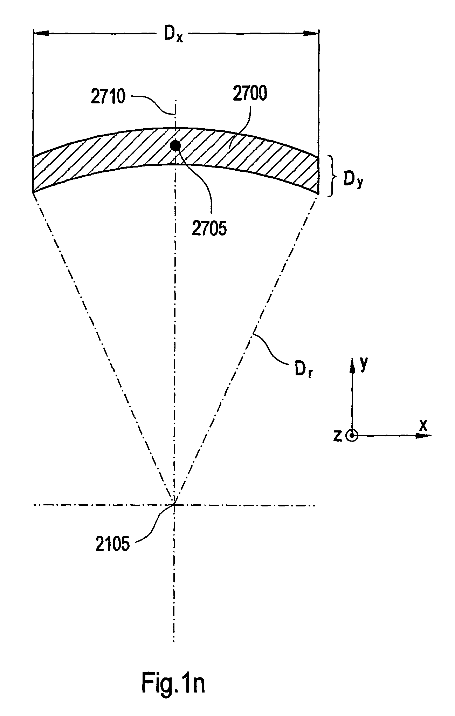

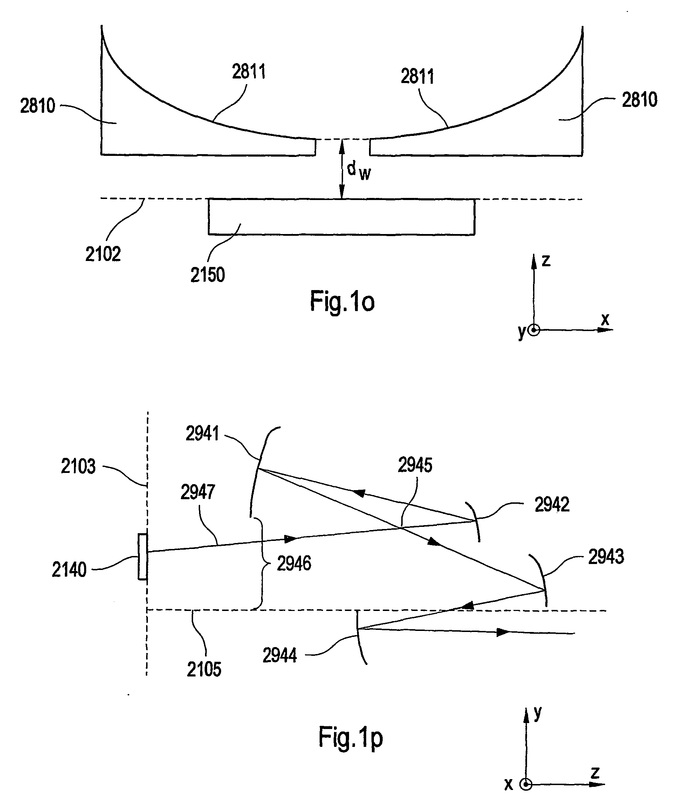

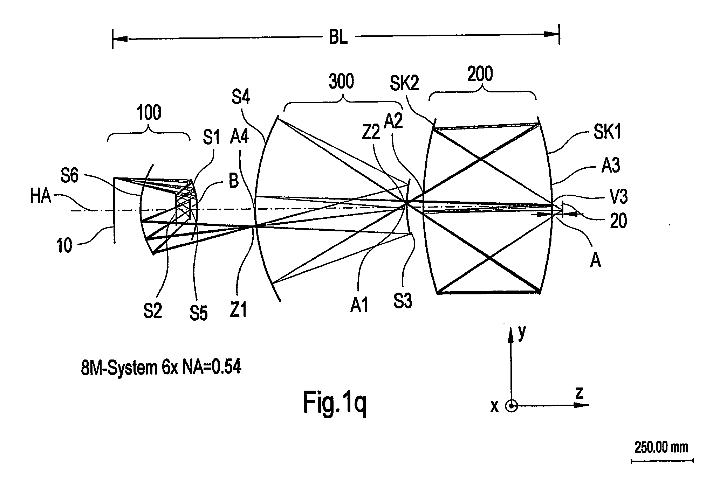

Fig. 1 a: schematische Ansicht einer Mikrolithographie-Projektionsbelichtungsanlage

Fig. 1b: Strahlkonus, der auf ein Objekt in einer Bildebene auftrifft

Fig. 1 c: Ausschnitt einer Spiegeloberfläche, auf die mehrere Strahlen einer das Projektionsobjektiv durchlaufenden Strahlung auftreffen

Fig. 1d: Beispiel eines Spiegels der eine Öffnung für den Durchtritt eines Strahlbüschels aufweist

Fig. 1 e: Beispiel eines Spiegels der keine Öffnung eines Strahlbüschels aufweist.

Fig. 1 f: Beispiel eines Teilobjektives in einer Meridionalebene

Fig. 1 g: Beispiel eines alternativen Teilobjektives in einer Meridionalebene

Fig. 1 h: Teilobjektiv, das aus Spiegeln mit einer Öffnung besteht in einer Meridionalebene

Fig. 1i: Alternatives Beispiel eines Teilobjektives das aus Spiegeln aufgebaut ist, die eine Öffnung umfassen in einer Meridionalebene

Fig. 1j: Ausgestaltung eines Projektionsobjektives mit Obskurations- bzw. Abschattungsblende auf einem Spiegel

Fig. 1 k: Ausgestaltung eines Projektionsobjektives mit Abschattungsblende im Lichtweg zwischen zwei Spiegeln

Fig. 1l-m: Ausgestaltung eines Projektionsobjektives mit Abschattungsblende im Lichtweg zwischen zwei Spiegeln und Befestigungseinrichtung

Fig. 1n: Beispiel eines Ringsfeldes, wie es bspw. in der Bildebene ausgebildet wird

Fig. 1o: Definition des bildseitigen freien Arbeitsabstandes

Fig. 1 p: Ausgestaltung eines Projektionsobjektives mit gekreuztem Strahlengang in einem Objektivteil

Fig. 1 q: eine erste Ausführungsform eines 8-Spiegel-System mit einer numerischen Apertur NA=0,54 und sechsfacher Vergrößerung

Fig. 2: eine zweite Ausführungsform eines 8-Spiegel-Systems mit einer numerischen Apertur NA=0,5 und einer vierfachen Vergrößerung.

Fig. 3: eine dritte Ausführungsform eines 8-Spiegel-Systems mit einer numerischen Apertur NA=0,5 und einer fünffachen Vergrößerung.

Fig. 4: eine vierte Ausführungsform eines 8-Spiegel-Systems mit einer numerischen Apertur NA=0,5 und einer sechsfachen Vergrößerung.

Fig. 5: eine fünfte Ausführungsform eines 8-Spiegel-Systems mit einer numerischen Apertur NA=0,5 und einer achtfachen Vergrößerung

Fig. 6a: ein sechstes Ausführungsbeispiel eines 8-Spiegel-Systems mit einer numerischen Apertur NA=0,6 und einer 8-fachen Vergrößerung

Fig. 6b: ein siebtes Ausführungsbeispiel eines 8-Spiegel-Systems mit einer numerischen Apertur NA=0,6 und einer 8-fachen Vergrößerung.

Fig. 6c: ein achtes Ausführungsbeispiel eines 8-Spiegel-Systems mit einer numerischen Apertur NA=0,6 und einer 8-fachen Vergrößerung.

Fig. 6d:  ein neuntes Ausführungsbeispiel eines 8-Spiegel-Systems mit einer numerischen Apertur NA=0,6 und einer 8-fachen Vergrößerung.

Fig. 6e:  ein zehntes Ausführungsbeispiel eines 8-Spiegel-Systems mit einer numerischen Apertur NA=0,7 und einer 8-fachen Vergrößerung.

Fig. 7:  ein erstes Ausführungsbeispiel eines 10-Spiegel-System mit einer NA=0,75 und achtfacher Vergrößerung

Fig. 8:  ein zweites Ausführungsbeispiel eines 10-Spiegel-System mit einer NA=0,75 und achtfacher Vergrößerung

Fig. 9.  ein drittes Ausführungsbeispiel eines 10-Spiegel-Objektives mit zwei Zwischenbildern

Fig. 10:  ein viertes Ausführungsbeispiel eines 10-Spiegel-System mit einer NA=0,72 und achtfacher Vergrößerung

Fig. 11:  ein fünftes Ausführungsbeispiel eines 10-Spiegel-System mit einer NA=0,70 mit achtfacher Vergrößerung

Fig. 12:  ein sechstes Ausführungsbeispiel eines 10-Spiegel-System mit einer NA=0,72 und achtfacher Vergrößerung

Fig. 13:  die Lage des zweiten Zwischenbildes im Bereich des zweiten bzw. dritten Teilobjektives

Fig. 14:  die optimale Zwischenbildlage in einem Doppelspiegel für das zweite und dritte Teilobjektiv

Fig. 15:  eine Ausführungsform des zweiten Teilobjektives mit einem Mangin-Spiegel

Fig. 16:  ein siebtes Ausführungsbeispiel eines 10-Spiegel-Systems mit einer NA=0,7 und achtfacher Vergrößerung.

Fig. 17:  ein erstes Ausführungsbeispiel eines 6-Spiegel-Systems mit einer NA=0.5 und achtfacher Vergrößerung und einem Konkavspiegel als zweiten Spiegel im Lichtweg von der Objektebene zur Bildebene

Fig. 18:  ein Ausführungsbeispiel eines weiteren 6-Spiegel-Systems mit einer NA=0.5 und achtfacher Vergrößerung

Fig. 19:  Beleuchtungssystem mit einem Mikrolithographie-Projektionsobjektiv mit obskurierter Pupille.

Fig. 20  ein erstes Ausführungsbeispiel eines 10-Spiegel-Objektives mit einer hohen Apertur NA=0,72 zur Abbildungen von Strukturen kleiner als 50 nm

Fig. 21  ein zweites Ausführungsbeispiel eines 10-Spiegel-Objektives mit einer hohen Apertur NA=0,85 zur Abbildungen von Strukturen kleiner als 50 nm

Fig. 22  ein drittes Ausführungsbeispiel eines 10-Spiegel-Objektives mit einer hohen Apertur NA=0,90 zur Abbildungen von Strukturen kleiner als 50 nm

Fig. 23:  eine erste Ausführungsform eines 8-Spiegel-System mit einer bildseitigen numerischen Apertur NA=0,70 und achtfacher Vergrößerung

Fig. 24:  eine zweite Ausführungsform eines 8-Spiegel-Systems mit einer bildseitigen numerischen Apertur NA=0,7 und einer achtfachen Vergrößerung.

In den Figuren 1a bis 1p sind allgemeine Begriffe, die in einer Vielzahl von Ausführungsbeispielen verwendet werden und sich auf eine Vielzahl von Ausführungsbeispielen beziehen, detailliert anhand der Figuren beschrieben.

In Figur 1a ist eine Mikrolithographie-Projektionsbelichtungsanlage 2100 gezeigt. Die Mikrolithographie-Projektionsbelichtungsanlage umfasst eine Lichtquelle 2110, ein Beleuchtungssystem 2120, ein Projektionsobjektiv 2101 sowie eine Trägerstruktur bzw. Arbeitsfläche 2130. Des Weiteren ist ein kartesisches Koordinatensystem dargestellt. Die Strahlung der Lichtquelle 2110 wird einem Beleuchtungssystem 2120 zugeführt. Das Beleuchtungssystem 2120 beeinflusst die von der Lichtquelle 2110 ausgehende Strahlung, bspw. in dem die Strahlung homogenisiert wird oder indem ein Strahlbündel 2122 der Strahlung auf eine Maske 2140, die in einer Objektebene 2103 positioniert ist, gelenkt wird. Das Projektionsobjektiv 2101 bildet die von der Maske 2140 reflektierte Strahlung auf eine Substratoberfläche 2150, die in einer Bildebene 2102 positioniert ist ab. Das Strahlbüschel auf der Bildseite des Projektionsobjektives 2101 ist mit Bezugsziffer 2152 gekennzeichnet. Das Substrat 2150 wird von einer Trägerstruktur 2130 unterstützt bzw. getragen, wobei die Trägerstruktur 2130 das Substrat 2150 relativ zum Projektionsobjektiv 2101 bewegt, so dass das Projektionsobjektiv 2101 die Maske 2140 auf unterschiedliche Bereiche des Substrats 2150 abbildet.

Das Projektionsobjektiv 2101 umfasst eine optische Achse 2105. Wie in Figur 1a dargestellt bildet das Projektionsobjektiv 2101 ein Teil der Maske 2140 der nicht die optische Achse des Projektionsobjektives 2101 umfasst in eine Bildebene 2102 ab. In nicht dargestellten alternativen Ausgestaltungen können auch Objekte, die auf der optischen Achse HA des Projektionsobjektives liegen in die Bildebene 2102 abgebildet werden. Die Lichtquelle 2110 wird derart ausgewählt, dass sie elektromagnetische Strahlung bei einer Betriebswellenlänge $\lambda$, mit der die Mikrolithographie-Projektionsbelichtungsanlage 2100 betrieben wird, zur Verfügung stellt. In einigen Ausführungsbeispielen ist die Lichtquelle 2110 eine Laserlichtquelle wie bspw. eine Laserplasmaquelle für die Emission von EUV-Strahlung oder ein KrF-Laser für Wellenlängen bei 248 nm oder ein ArF-Laser bei 193 nm. Alternativ können auch Lichtquellen eingesetzt werden, die keine Laserlichtquellen sind, wie bspw. Leuchtdioden (LED) die Strahlung im blauen oder UV-Bereich des elektromagnetischen Spektrums, bspw. bei 365 nm, 280 nm oder 227 nm emittieren.

Die Betriebswellenlänge $\lambda$ der Mikrolithographie-Projektionsbelichtungsanlage liegt in ultraviolettem oder extremen ultravioletten (EUV)-Bereich des elektromagnetischen Spektrums. Die Betriebswellenlänge kann 400 nm oder weniger, 300 nm oder weniger, insbesondere 200 nm oder weniger, ganz besonders 100 nm oder weniger, betragen. In den Ausführungsbeispiel kann beispielsweise die Betriebswellenlänge im Bereich von 193 nm, bevorzugt im Bereich von 157 nm, ganz besonders bevorzugt im EUV-Wellenlängenbereich, insbesondere im Bereich um 13 nm, liegen.

Die Verwendung von besonders kurzwelliger Strahlung ist besonders wünschenswert, da im Allgemeinen die Auflösung eines Projektionsobjektives in etwa proportional zur verwendeten Betriebswellenlänge ist. Deswegen können bei Verwendung kürzerer Wellenlängen, Projektionsobjektive kleinere Strukturen eines Bildes als gleichartige Projektionsobjektive, die längere Wellenlängen benutzen auflösen.

Das Beleuchtungssystem 2120 umfasst optische Komponenten, die einen kollimierten Strahl mit einem weitgehenden homogenen Intensitätsprofil zur Verfügung stellen. Das Beleuchtsystem 2120 umfasst des Weiteren Optiken um das Strahlbüschels 2122 auf die Maske 2140 zu lenken. In einer besonders bevorzugten Ausführungsform umfasst das Beleuchtungssystem 2120 des Weiteren Komponenten, die ein bestimmtes Polarisationsprofil des Strahlbüschels zur Verfügung stellen.

Die Bildebene 2103 weist zur Objektebene 2102 einen Abstand L auf, der auch als Baulänge BL des Projektionsobjektives 2101 bezeichnet wird. Im Allgemeinen hängt diese Baulänge von der spezifischen Ausgestaltung des Projektionsobjektives 2101 und der Wellenlänge, mit der die Mikrolithographie-Projektionsbelichtungsanlage 2100 betrieben wird, ab. In den beschriebenen Ausführungsbeispielen liegt die Baulänge im Bereich von einem Meter bis ungefähr drei Meter, bevorzugt im Bereich von ungefähr 1,5 m bis 2,5 m.

In bestimmten Ausführungsbeispielen ist die Baulänge geringer als 2 m, bspw. geringer als 1,9 m, bevorzugt geringer als 1,8 m, ganz bevorzugt geringer als 1,7 m, insbesondere bevorzugt geringer als 1,6 m, insbesondere bevorzugt geringer als 1,5 m.

Das Projektionsobjektiv 2101 hat einen Abbildungsfaktor der sich auf das Verhältnis der Abmessungen des Feldes in der Objektebene 2103 zu den korrespondierenden Abmessungen des abgebildeten Feldes in der Bildebene 2102 bezieht. Typischerweise sind die Projektionsobjektive, die in Lithographieanlagen verwandt werden Reduktions-Projektionsobjektive, d.h. dass die Abmessungen des Bildes kleiner sind als die des Objektes. In einigen Ausführungsbeispielen kann daher das Projektionsobjektiv 2101 ein Feld in der Bildebene 2102 erzeugen, dessen Dimensionen um einen Faktor 2x oder mehr, bevorzugt 3x oder mehr, insbesondere 4x oder mehr, ganz besonders bevorzugt 5x oder mehr, insbesondere bevorzugt 6x oder mehr, bevorzugt 7x oder insbesondere 8x oder mehr, insbesondere bevorzugt 9x oder mehr, ganz bevorzugt 10x oder mehr verringert sind, verglichen mit den Dimensionen in der Objektebene 2103. Es können aber auch Projektionsobjektive entwickelt werden, die ein vergrößertes Bild oder ein Bild gleicher Größe, wie das Objekt zur Verfügung stellen.

In Figur 1b sind die Randstrahlen 2152 des Lichtbüschels die das Objekte in die Bildebene 2102 abbilden dargestellt. Die Randstrahlen 2152 definieren einen Strahlkonus.

Der Winkel des Strahlenkonus steht in Beziehung zur bildseitigen numerischen Apertur (NA) des Projektionsobjektives 2101. Die bildseitige numerische Apertur kann ausdrückt werden als

$$NA = n_0 * \sin\Theta_{max},$$

wobei $n_0$ sich auf den Brechungsindex des Mediums bezieht, der dem Substrat 2150 benachbart ist. Dieses Medium kann bspw. Luft, Stickstoff, Wasser oder Vakuum sein. $\Theta_{max}$ ist der Winkel, der durch die Randstrahlen des Projektionsobjektives 2101 definiert wird.

Im Allgemeinen weisen Projektionsobjektive 2101 eine relativ hohe bildseitige numerische Apertur NA auf. Bspw. beträgt die bildseitige numerische Apertur NA des Projektionsobjektives 2101 in einigen Ausführungsbeispielen mehr als 0,4, insbesondere mehr als 0,45, insbesondere mehr als 0,5, insbesondere mehr als 0,55, insbesondere mehr als 0,6, insbesondere mehr als 0,65, insbesondere mehr als 0,7, insbesondere mehr als 0,75, insbesondere mehr als 0,8, insbesondere mehr als 0,85, insbesondere mehr als 0,9. Im Allgemeinen variiert die Auflösung des Projektionsobjektives 2101 in Abhängigkeit von der Wellenlänge λ und der bildseitigen numerischen Apertur NA.

Die Auflösung eines Projektionsobjektives kann mit Bezug auf die Wellenlänge und auf die bildseitige numerische Apertur durch die nachfolgende Formel

$$R = k \cdot \frac{\lambda}{NA}$$

abgeschätzt werden. Hierbei bezeichnet R die minimale Dimension des Projektionsobjektives die aufgelöst werden kann, k ist eine dimensionslose Konstante und wird als Prozessfaktor bezeichnet. Der Prozessfaktor k variiert in Abhängigkeit von verschiedenen Faktoren, bspw. den Polarisationseigenschaften des Resistmaterials. Typischerweise liegt k im Bereich von 0,4 bis 0,8, aber k kann auch unterhalb von 0,4 und höher als 0,8 liegen, für spezielle Anwendungen.

In einigen Ausführungsbeispielen weist das Projektionsobjektiv 2101 eine relativ hohe Auflösung, d.h. der Wert von R ist relativ klein, auf. Bspw. kann R einen Wert von 150 nm oder weniger, bevorzugt 130 nm oder weniger, ganz besonders bevorzugt 100 nm oder weniger, insbesondere bevorzugt 75 nm oder weniger, ganz besonders bevorzugt 50 nm oder weniger, bevorzugt 40 nm oder weniger, insbesondere bevorzugt 35 nm oder weniger, ganz bevorzugt 32 nm oder weniger, insbesondere 30 nm oder weniger, bevorzugt 28 nm oder weniger, insbesondere 25 nm oder weniger, besonders bevorzugt 22 nm oder weniger, bevorzugt 20 nm oder weniger, insbesondere bevorzugt 18 nm oder weniger, insbesondere 17 nm oder weniger, ganz bevorzugt 16 nm oder weniger, insbesondere 15 nm oder weniger, insbesondere bevorzugt 14 nm oder weniger, ganz bevorzugt 13 nm oder weniger, insbesondere 12 nm oder weniger, bevorzugt 11 nm oder weniger, insbesondere bevorzugt 10 nm oder weniger annehmen.

Die Qualität eines Bildes, das durch das Projektionsobjektiv 2001 ausgebildet wird, kann auf verschiedene Arten und Weisen quantifiziert werden.

Beispielsweise können Bilder charakterisiert bzw. quantifiziert werden, basierend auf den gemessenen oder berechneten Abweichungen des Bildes von idealen Bedingungen die mit einer Gaußschen Optik erreicht werden können. Diese Abweichungen sind im Allgemeinen als Aberrationen bekannt. Ein Maß, das benutzt wird, um die Abweichung einer Wellenfront von der Ideal- oder gewünschten Form zu quantifizieren, ist der "root-mean-square"-Wellenfrontfehler, der sog. RMS-Wert $W_{RMS}$. $W_{RMS}$ ist bspw. wie in "Handbook of optics", Vol. 1, 2nd, edited by Michael Bass (McGraw Hill), Inc. 1995 auf Seite 35.3 definiert. Im Allgemeinen gilt, dass je niedriger der $W_{RMS}$-Wert für ein Objektiv ist, umso weniger die Wellenfront von der gewünschten oder idealen Form abweicht und damit umso besser die Qualität des Bildes ist.

In bevorzugten Ausführungsformen weist das Projektionsobjektiv 2101 sehr kleine Werte für $W_{RMS}$ des Bildes in der Bildebene 2102 auf. Bspw. kann ein Projektionsobjektiv 2101 einen $W_{RMS}$-Wert von ungefähr 0,1 λ oder weniger, insbesondere weniger als 0,07·λ, besonders bevorzugt weniger als 0,06·λ, insbesondere weniger als 0,05·λ, bevorzugt weniger als 0,045·λ, insbesondere weniger als 0,04·λ, ganz besonders bevorzugt weniger als 0,035·λ, insbesondere bevorzugt weniger als 0,03·λ, insbesondere bevorzugt weniger als 0,025·λ, besonders bevorzugt weniger als 0,02·λ, insbesondere bevorzugt weniger als 0,15·λ, besonders bevorzugt weniger als 0,01·λ aufweisen.

Ein anderes Maß, dass dazu verwendet werden kann, die Qualität eines Bildes zu evaluieren ist die Bildfeldwölbung oder Bildfeldkrümmung, die sog. field curvature. Die Bildfeldkrümmung ist definiert als peak-to-valley-Wert der axialen Fokalebeneposition in Abhängigkeit vom Feldpunkt. In einigen Ausführungsbeispielen weist das Projektionsobjektiv 2101 eine relativ geringe Bildfeldkrümmung für Bilder in der Bildebene 2102 auf. Bspw. weist das Projektionsobjektiv 2101 eine bildseitige Bildfeldkrümmung von weniger als 20 nm, bevorzugt weniger als 15 nm, besonders bevorzugt weniger als 12 nm, insbesondere bevorzugt weniger als 10 nm, ganz besonders bevorzugt weniger als 9 nm, bevorzugt weniger als 8 nm, bevorzugt weniger als 7 nm, ganz bevorzugt weniger als 6 nm, insbesondere bevorzugt weniger als 5 nm, ganz besonders bevorzugt weniger als 4 nm, insbesondere bevorzugt weniger als 3 nm, bevorzugt weniger als 2 nm, ganz bevorzugt weniger als 1 nm auf.

Ein anderes Maß, das dazu verwendet werden kann, die optische Performance eines Projektionsobjektives zu evaluieren, ist die Verzeichnung, die sog. Distortion. Die Verzeichnung ist definiert als der maximale absolute Wert der feldpunktabhängigen Ablage des Bildpunktes von der idealen Bildpunktposition in der Bildebene. In einigen Beispielen hat das Projektionsobjektiv eine relativ geringe Verzeichnung von 10 nm oder weniger, bevorzugt 9 nm oder weniger, ganz bevorzugt 8 nm oder weniger, insbesondere bevorzugt 7 nm oder weniger, ganz bevorzugt 6 nm oder weniger, insbesondere bevorzugt 5 nm oder weniger, insbesondere 4 nm oder weniger, bevorzugt 3 nm oder weniger, ganz bevorzugt 2 nm, bevorzugt 1 nm oder weniger.

Falls das Objektiv als katoptrisches System ausgebildet ist, umfasst das Projektionsobjektiv 2101 eine Vielzahl von Spiegeln, die derart angeordnet sind, dass die Strahlung, die von einer Maske 2140 zu einem Substrat 2150 verläuft derart reflektiert wird, dass ein Bild der Maske 2140 auf der Oberfläche des Substrats 2150 ausgebildet wird. Spezielle Ausgestaltungen eines Projektionsobjektives sind wie in der nachfolgenden Beschreibung beschrieben ausgebildet. Allgemein gesprochen wird die Anzahl, die Größe und die Struktur der Spiegel von den gewünschten optischen Eigenschaften des Projektionsobjektives 2101 und den physikalischen Randbedingungen der Projektionsbelichtungsanlage 2100 determiniert.

Die Anzahl der Spiegel im Projektionsobjektiv 2101 kann variieren. Typischerweise ist die Spiegelanzahl mit verschiedenen Anforderungen an die optischen Eigenschaften des Objektives verknüpft.

In bestimmten Ausführungsbeispielen hat das Projektionsobjektiv 2101 wenigstens vier Spiegel, bevorzugt wenigstens fünf Spiegel, ganz bevorzugt wenigstens sechs Spiegel, insbesondere bevorzugt wenigstens sieben Spiegel, ganz besonders bevorzugt wenigstens acht Spiegel, bevorzugt wenigstens neun Spiegel, insbesondere bevorzugt wenigstens zehn Spiegel, ganz besonders bevorzugt wenigstens elf Spiegel, insbesondere bevorzugt wenigstens zwölf Spiegel. In besonders bevorzugten Ausführungsbeispielen der Erfindung, bei denen Spiegel des Objektives zwischen der Objektebene und der Bildebene angeordnet sind, weist das Projektionsobjektiv 2101 eine gerade Spiegelanzahl auf, bspw. vier Spiegel, sechs Spiegel, acht Spiegel oder auch zehn Spiegel.

Das Projektionsobjektiv 2101 umfasst im Allgemeinen einen oder mehrere Spiegel mit positiver optischer Brechkraft. Mit anderen Worten bedeutet dies, dass der reflektierende Abschnitt des Spiegels, d. h. der Nutzbereich des Spiegels, eine konkave Oberfläche hat und demgemäß als Konkavspiegel oder konkaver Spiegel bezeichnet wird. Das Projektionsobjektiv 2101 kann zwei oder mehr bspw. drei oder mehr, insbesondere vier oder mehr, ganz besonders fünf oder mehr, insbesondere sechs oder mehr Konkavspiegel umfassen. Das Projektionsobjektiv 2101 kann auch einen oder mehrere Spiegel umfassen, die negative optische Brechkraft aufweisen. Dies bedeutet, dass ein oder mehrere der Spiegel einen reflektiven Abschnitt, d. h. einen Nutzbereich mit einer konvexen Oberfläche haben. Derartige Spiegel werden auch als konvexe Spiegel oder Konvexspiegel bezeichnet. In einigen Ausführungsbeispielen kann das Projektionsobjektiv 2101 zwei.oder mehr, insbesondere drei oder mehr, ganz besonders vier oder mehr, insbesondere fünf oder mehr, ganz besonders sechs oder mehr konvexe Spiegel aufweisen.

In bestimmten Ausführungsbeispielen sind die Spiegel derart in Projektionsobjektiven 2101 angeordnet, dass die Strahlung, die von der Objektebene 2103 ausgeht, ein oder mehrere Zwischenbilder ausbildet.

Ausführungsbeispiele der Erfindung haben eines oder mehrere Zwischenbilder und umfassen zwei oder mehr Pupillenebene. Im bevorzugten Ausführungsbeispiel ist wenigstens in einer dieser Pupillenebenen physikalisch zugänglich eine Aperturblende angeordnet.

Im Allgemeinen sind die Spiegel derart ausgebildet, dass ein großer Anteil des Lichtes der Betriebswellenlänge λ des Projektionsobjektives, die unter einem Winkel oder einem Winkelbereich auf die Spiegelfläche auftreffen im wesentlichen reflektiert werden. Die Spiegel können so ausgebildet sein werden, dass sie beispielsweise mehr als 50%, bevorzugt mehr als 60%, ganz bevorzugt mehr als 70%, insbesondere bevorzugt mehr als 80%, ganz besonders bevorzugt mehr als 90% der auf die Fläche auftreffenden Strahlung mit einer Wellenlänge λ reflektiert werden. In einigen Ausführungsbeispielen umfassen die Spiegel einen Vielfach-Schicht-Stapel, einen so genannten multilayer stack, von Schichten unterschiedlichen Materials, wobei der Stapel so aufgebaut ist, dass er auf die Fläche einfallende Strahlung der Wellenlänge λ im wesentlich reflektiert. Jeder Film des Stapels hat eine optische Dicke von ungefähr $\frac{\lambda}{4}$. Die Vielfach-Schicht-Stapel können 20 oder mehr, bevorzugt 30 oder mehr, insbesondere bevorzugt 40 oder mehr, ganz besonders bevorzugt 50 oder mehr Schichten umfassen. Im Allgemeinen ist das Material, dass dafür ausgewählt wird, die Vielfach-Schicht-Stapel zu bilden ausgewählt, aus den Materialen, die für die Betriebswellenlänge λ der Mikrolithographieanlage geeignet sind. Beispielsweise besteht das Vielfach-Schicht-System aus alternierenden Vielfach-Schichten bestehen aus Molybdän und Silizium oder Molybdän und Beryllium um Spiegel auszubilden, die Strahlung im Wellenlängenbereich von 10 nm bis 30 nm reflektieren, beispielsweise bei einem Wellenlängenwert λ von 13 nm oder 11 nm.

In bestimmten Ausführungsformen sind die Spiegel aus Quarzglas hergestellt, die mit einer einzigen Aluminiumschicht beschichtet sind. Dieser wiederum ist überschichtet, das heißt overcoated mit dielektrischen Schichten die Materialien wie $MgF_2$, $LaF_2$, $Al_2O_3$ beispielsweise für Wellenlängen von ungefähr 193 nm umfassen.

Im Allgemeinen variiert der Anteil der Strahlung, der von einem Spiegel reflektiert wird, als Funktion des Einfallswinkels der Strahlung auf die Spiegeloberfläche. Da die abbildende Strahlung durch ein katoptrisches Projektionsobjektiv entlang einer Vielzahl von unterschiedlichen Wegen propagiert, kann der Einfallswinkel der Strahlung auf jedem Spiegel variieren. Dies ist gezeigt in Figur 1c, die einen Teil eines Spiegels 2300 im meridionalen Schnitt, das heißt in der Meridionalebene zeigt. Die Meridionalebene ist eine Ebene des Projektionsobjektives, die die optische Achse umfasst. Der Spiegel 2300 umfasst eine konkave reflektive Spiegeloberfläche 2301. Die abbildende Strahlung, die auf die Fläche 2301 entlang unterschiedlicher Wege auftrifft, umfasst bspw. die Wege, die durch die Strahlen 2310, 2320, 2330 dargestellt sind. Die Strahlen 2310, 2320 und 2330 treffen auf einen Teil der Spiegeloberfläche 2301 auf. Die Normalen auf die Oberfläche des Spiegels sind in diesem Bereich der Spiegeloberfläche 2301 unterschiedlich. Die Richtung der Oberflächennormalen sind in diesem Bereich durch die Geraden 2311, 2321 und 2331, die korrespondierend zu den Strahlen 2310, 2320 und 2330 sind, dargestellt. Die Strahlen 2310, 2320, und 2330 treffen auf die Oberfläche unter den Winkeln $\Theta_{2310}$, $\Theta_{2320}$ und $\Theta_{2330}$ auf.

Für jeden Spiegel im Projektionsobjektiv 2100 können die Einfallswinkel der abbildenden Strahlen auf eine Vielzahl von Wegen dargestellt werden. Eine mögliche Darstellung ist der maximale Winkel der auf jeden Spiegel auftreffenden Strahlen im Meridionalschnitt des Projektionsobjektives 2101. Dieser maximale Winkel wird mit $\Theta_{max}$ bezeichnet. Im Allgemeinen kann der Winkel $\Theta_{max}$ verschiedener Spiegel des Projektionsobjektives 2101 variieren. In bestimmten Ausführungsbeispielen der Erfindung beträgt der maximale Wert $\Theta_{max(max)}$ für alle Spiegel des Projektionsobjektivs 2101 75° oder weniger, bevorzugt 70° oder weniger, ganz bevorzugt 65° oder weniger, insbesondere bevorzugt 60° oder weniger, bevorzugt 55° oder weniger, insbesondere 50° oder weniger, insbesondere 45° oder weniger. In einigen Ausführungsbeispielen ist der maximale Winkel $\Theta_{max(max)}$ relativ gering. Beispielsweise kann der maximale Winkel $\Theta_{max(max)}$ 40° oder weniger, bevorzugt 35° oder weniger, ganz bevorzugt 30° oder weniger, insbesondere 25° oder weniger, besonders bevorzugt 20° oder weniger, insbesondere 15° oder weniger, insbesondere 13° oder weniger, besonders bevorzugt 10° oder weniger, betragen.

Eine andere Möglichkeit der Charakterisierung ist die Charakterisierung über den Einfallswinkel des Hauptstrahls des zentralen Feldpunktes des in der Objektebene auszuleuchtenden Feldes auf jedem Spiegel im meridionalen Schnitt. Dieser Winkel wird als $\Theta_{CR}$ bezeichnet. Bezüglich des Hauptstrahlwinkels $\Theta_{CR}$ wird auch auf den einleitenden Teil der Anmeldung verwiesen. Wiederum kann ein maximaler Winkel $\Theta_{CR(max)}$ im Projektionsobjektiv als maximaler Hauptstrahlwinkel des zentralen Feldpunktes definiert werden. Dieser Winkel $\Theta_{CR(max)}$ kann relativ niedrig sein, beispielsweise kann der maximale Winkel $\Theta_{CR(max)}$ im Projektionsobjektiv geringer als 35°, bevorzugt geringer als 30°, ganz bevorzugt geringer als 25°, insbesondere geringer als 15°, insbesondere geringer als 13°, insbesondere bevorzugt geringer als 10°, bevorzugt geringer als 8° oder ganz bevorzugt geringer als 5° sein.

Jeder Spiegel im Projektionsobjektiv 2101 kann des Weiteren durch einen Bereich der Einfallswinkel im meridonalen Schnitt des Projektionsobjektives 2101 charakterisiert sein. Der Bereich in dem der Winkel $\Theta$ auf jedem Spiegel variiert wird als $\Delta\Theta$ bezeichnet. Für jeden Spiegel wird $\Delta\Theta$ durch den Unterschied zwischen einem Winkel $\Theta_{(max)}$ und $\Theta_{(min)}$ definiert, wobei $\Theta_{(min)}$ der minimale Einfallswinkel der abbildenden Strahlen auf eine Spiegeloberfläche im meridionalen Schnitt des Projektionsobjektives 2101 und $\Theta_{(max)}$ der maximale Wert der einfallenden abbildenden Strahlen auf eine Spiegeloberfläche ist, wie bereits zuvor definiert. Im Allgemeinen variiert der Bereich $\Delta\Theta$ für jeden Spiegel im Projektionsobjektiv 2101. Für einige Spiegel kann $\Delta\Theta$ relativ gering sein. Beispielsweise kann $\Delta\Theta$ geringer als 10°, bevorzugt geringer als 8°, insbesondere bevorzugt geringer als 5°, ganz bevorzugt geringer als 3°, insbesondere geringer als 2° sein. Alternativ hierzu, kann für andere Spiegel im Projektionsobjektiv 2101 $\Delta\Theta$ relativ groß sein. Beispielsweise kann $\Delta\Theta$ für einige Spiegel 20° oder mehr, insbesondere 25° oder mehr, besonders bevorzugt 30° oder mehr, insbesondere bevorzugt 35° oder mehr, ganz besonders 40° oder mehr sein. In einigen Ausgestaltungen kann der Maximalwert für $\Delta\Theta$, der Wert $\Delta\Theta_{max}$ der Maximalwert der Winkelvariation auf einem Spiegel für alle Spiegel im Projektionsobjektiv 2101 relativ gering sein. Beispielsweise kann der Wert $\Delta\Theta_{max}$ geringer als 25°, insbesondere geringer als 20°, ganz besonders geringer als 15°, insbesondere geringer als 12°, insbesondere geringer als 10°, insbesondere geringer als 8°, insbesondere geringer als 7°, ganz bevorzugt geringer als 6°, insbesondere bevorzugt geringer als 5°, ganz besonders bevorzugt geringer als 4° sein.

Im Allgemeinen werden katoptrische Projektionsobjektive derart gestaltet, dass sie die Obskuration des Lichtweges, die durch die reflektiven Elemente verursacht werden, in Betracht ziehen, im Gegensatz zu transmissiven Elementen, die in dioptrischen Systemen verwandt werden.

Die Spiegel sind so ausgestaltet und angeordnet, dass Strahlen die durch das Projektionsobjektiv propagieren in einem Lichtweg durch eine transmissive Öffnung, bspw. ein Loch in einem Spiegel geführt oder an der Ecke eines Spiegels vorbeigeführt werden. Die Spiegel in einem Projektionsobjektiv 2101 können daher in zwei Gruppen aufgeteilt werden:

- Spiegel umfassend eine Öffnung für den Durchtritt von Strahlung und
- Spiegel bei denen keine Öffnungen vorhanden ist

Ein Beispiel eines Spiegels 2600 der eine Öffnung für den Durchtritt eines Strahlbüschels umfasst, ist in Figur 1d gezeigt. Der Spiegel 2600 umfasst eine Öffnung 2610. Der Spiegel 2600 kann im Projektionsobjektiv 2101 so angeordnet sein, dass die optische Achse 2105 die Öffnung 2610 schneidet. Der Spiegel 2600 ist von kreisförmiger Form mit einem Durchmesser D. Im Allgemeinen wird D durch das Design des Projektionsobjektives 2101 bestimmt. In einigen Beispielen ist D 1500 mm oder geringer, bevorzugt 1400 mm oder geringer, insbesondere bevorzugt 1300 mm oder geringer, besonders 1200 mm oder geringer, ganz besonders 1100 mm oder geringer, ganz bevorzugt 1000 mm oder geringer, insbesondere bevorzugt 900 mm oder geringer, ganz besonders bevorzugt 800 mm oder geringer, ganz bevorzugt 700 mm oder geringer, insbesondere 600 mm oder geringer, bevorzugt 500 mm oder geringer, ganz besonders 400 mm oder geringer, ganz bevorzugt 300 mm oder geringer, insbesondere 200 mm oder geringer, ganz bevorzugt 100 mm oder geringer.

Im Allgemeinen können die Spiegel des Projektionsobjektives 2101 die eine Öffnung umfassen von kreisförmiger oder nichtkreisförmiger Form sein.

Spiegel die nicht von kreisförmiger Gestalt sind, können eine maximale Dimension aufweisen, die geringer als 1500 mm ist, bevorzugt geringer als 1400 mm, insbesondere geringer als 1300 mm, bevorzugt geringer als 1200 mm, insbesondere geringer als 1100 mm, bevorzugt geringer als 1000 mm, insbesondere geringer als 900 mm, bevorzugt geringer als 800 mm, insbesondere geringer als 700 mm, bevorzugt geringer als 600 mm, insbesondere geringer als 500 mm, bevorzugt geringer als 400 mm, insbesondere geringer als 300 mm, bevorzugt geringer als 200 mm, insbesondere geringer als 100 mm.

Die Öffnung 2610 ist bspw. kreisförmig mit einem Durchmesser $D_0$. $D_0$ hängt von dem Design des Projektionsobjektives 2101 ab und ist im Allgemeinen derart bemessen, dass er eine ausreichend große Öffnung für den Durchtritt von Strahlung von der Objektebene 2103 zur Bildebene 2102 zur Verfügung stellt.

Die Öffnung kann aber auch nicht-kreisförmig sein. Beispiele für nicht-kreisförmige Öffnungen umfassen polygonale Öffnungen, wie bspw. eine quadratische Öffnung, eine rechteckige Öffnung, eine hexagonale Öffnung, eine oktagonale Öffnung und nichtkreisförmige, gebogene Öffnungen, bspw. elliptische Öffnungen oder irreguläre gebogenen Öffnungen.

Öffnungen die von nicht kreisförmiger Form sind, können einen maximalen Durchmesser von 0,75 D oder weniger, insbesondere von 0,5 D oder weniger, bevorzugt 0,4 D oder weniger, insbesondere 0,3 D oder weniger, bevorzugt 0,2 D oder weniger, insbesondere 0,1 D oder weniger, bevorzugt 0,05 D oder weniger sein. In einigen Ausführungsbeispielen können Spiegel nicht kreisförmige Öffnungen umfassen, die eine maximale Dimension von ungefähr 50 mm oder weniger, bevorzugt 45 mm oder weniger, insbesondere 40 mm oder weniger, bevorzugt 35 mm oder weniger, insbesondere 30 mm oder weniger, bevorzugt 25 mm oder weniger, insbesondere 20 mm oder weniger, bevorzugt 15 mm oder weniger, insbesondere 10 mm oder weniger, insbesondere 5 mm oder weniger betragen.

In Ausführungsbeispielen, in denen das Projektionsobjektiv 2101 mehr als einen Spiegel mit einer Öffnung umfasst, können die Öffnungen in verschiedenen Spiegeln von gleicher Form oder unterschiedlicher Form ausgebildet werden. Des Weiteren können die Öffnungen für den Durchtritt von Strahlung in unterschiedlichen Spiegeln dieselbe Dimension oder unterschiedliche Dimensionen besitzen.

Ein Beispiel eines Spiegels 2660, der keine Öffnung umfasst ist in Figur 1 e gezeigt. Der Spiegel 2660 weißt die Form eines Ringsegmentes auf. Der Spiegel 2660 korrespondiert in der Form zu einem Segment eines kreisförmigen Spiegels 2670 mit einem Durchmesser D. Der Spiegel 2660 hat eine maximale Dimension bzw. Abmessung in x Richtung, die durch $M_x$ gegeben ist. In den Ausführungsbeispielen kann $M_x$ 1500 mm oder weniger, bevorzugt 1400 mm oder weniger, insbesondere 1300 mm oder weniger, insbesondere 1200 mm oder weniger, bevorzugt 1100 mm oder weniger, insbesondere 1000 mm oder weniger, bevorzugt 900 mm oder weniger, insbesondere 800 mm oder weniger, bevorzugt 700 mm oder weniger, insbesondere 600 mm oder weniger, insbesondere 500 mm oder weniger, bevorzugt 400 mm oder weniger, insbesondere 300 mm oder weniger, bevorzugt 200 mm oder weniger, insbesondere 100 mm oder weniger betragen.

Der Spiegel 2660 ist symmetrisch mit Bezug auf den Meridian 2675. Der Spiegel 2660 hat eine Dimension $M_x$ entlang des Merdian 2675. $M_y$ kann geringer oder größer sein als $M_x$. In einigen Ausführungsbeispielen ist $M_x$ im Bereich von 0.1 $M_x$, bevorzugt 0.2 $M_x$ oder mehr, insbesondere 0,3 $M_x$ oder mehr, insbesondere 0,4 $M_x$ oder mehr, bevorzugt 0,5 $M_x$ oder mehr, insbesondere 0,6 $M_x$ oder mehr, bevorzugt 0,7 oder mehr, insbesondere 0,8 $M_x$ oder mehr, ganz bevorzugt 0,9 $M_x$ oder mehr. Alternativ kann in bestimmten Ausführungsformen $M_y$ 1,1 $M_x$ oder mehr, bevorzugt 1, 5 $M_x$ oder mehr, oder im Bereich von 2 $M_x$ bis 10 $M_x$ liegen. $M_y$ kann ungefähr 1000 mm oder weniger, bevorzugt 900 mm oder weniger, insbesondere 800 mm oder weniger, bevorzugt 700 mm oder weniger, insbesondere 600 mm oder weniger, bevorzugt 500 mm oder weniger, insbesondere 400 mm oder weniger, besonders 300 mm oder weniger, insbesondere 200 mm oder weniger, bevorzugt 100 mm oder weniger betragen.

Spiegel die keine Öffnung umfassen können so angeordnet sein, dass die optische Achse 2105 den Spiegel schneidet oder aber auch das die optische Achse 2105 den Spiegel nicht schneidet.

Im Allgemeinen kann das Projektionsobjektiv 2100 Spiegel unterschiedlicher Form und Größe umfassen, in Abhängigkeit vom Design. In einigen Beispielen kann die maximale Dimension jedes Spiegels des Projektionsobjektivs 1500 mm oder weniger, bevorzugt 1400 mm oder weniger, insbesondere 1300 mm oder weniger, bevorzugt 1200 mm oder weniger, insbesondere 1100 mm oder weniger, besonders 1000 mm oder weniger, insbesondere 900 mm oder weniger, bevorzugt 800 mm oder weniger, insbesondere 700 mm oder weniger sein.

In bestimmten Ausführungsbeispielen umfasst das Projektionsobjektiv 2101 eine Gruppe von Spiegeln beispielsweise 2 oder mehr Spiegel, 3 oder mehr Spiegel, 4 oder mehr Spiegel, 5 oder mehr Spiegel, 6 oder mehr Spiegel, die keine Öffnung aufweisen und die derart angeordnet sind, dass sie ein Objekt abbilden, beispielsweise in eine Bildebene 2102 oder in eine Zwischenbildebene. In den Ausführungsbeispielen, in denen das Projektionsobjektiv 2101 Gruppe bzw. Gruppen von Spiegeln umfasst wird die Gruppe von Spiegeln als Teilobjektiv bzw. Teilsystem bezeichnet.

In bestimmten Ausführungsbeispielen kann das Projektionsobjektiv 2101 mehr als ein Teilobjektiv umfassen. Beispielsweise kann das Projektionsobjektiv zwei Teilobjektive, drei Teilobjektive, vier Teilobjektive oder mehr als vier Teilobjektive umfassen. Ein Beispiel für ein Teilobjektiv ist das Teilobjektiv 2400, das in Figur 1f dargestellt ist. Das Teilobjektiv 2400 umfasst Spiegel 2410, 2420, 2430 und 2440 die derart angeordnet sind, das die Strahlung von einer Objektebene 2403, die zur Objektebene 2103 oder eine Zwischenbildebene korrespondiert, in eine Bildebene 2402 die korrespondierend zur Bildebene 2102 oder einer Zwischenbildebene ist, abbildet. Die reflektierenden Oberflächen der Spiegel 2410, 2420, 2430 und 2440 sind Teile von axialsymmetrischen Oberflächen, bei denen der Rest der Spiegeloberfläche entfernt wurde um einen Weg für die abbildende Strahlung zu Verfügung zu stellen. Die Teile der Spiegel sind die Abschnitte der Spiegeloberfläche auf die Strahlung auftrifft. Sie werden auch als Nutzbereiche bezeichnet. Der erste Spiegel im Weg der Strahlung, die das Projektionsobjektiv durchläuft, d.h. im Strahlengang bzw. Lichtweg, ist vorliegend Spiegel 2420, der am nächsten zur, d. h. in der Nähe der Ebene 2402 angeordnet ist, während der zweite Spiegel im Lichtweg, das heißt im Strahlengang der Spiegel 2410 ist der am nächsten zur, d. h. in der Nähe der Ebene 2403 angeordnet ist.

In einem alternativen Ausführungsbeispiel, das in Figur 1g dargestellt ist umfasst das Teilobjektiv 2450, Spiegel 2460, 2470, 2480 und 2490, die Licht einer Objektebene 2453, die beispielsweise korrespondierend zur Objektebene 2103 oder einer Zwischenbildebene sein kann, in eine Bildebene 2452, beispielsweise korrespondierend zur Bildebene 2102 oder einer Zwischenbildebene abbilden. Die Spiegel die das Teilobjektiv 2400 ausbilden, d.h. die Spiegel 2460, 2470, 2480 und 2490 sind Teile von axialsymmetrischen Oberflächen, bei denen der Rest der Spiegeloberfläche entfernt würde, um einen Lichtweg für den Abbildungsstrahlengang bzw. die abbildenden Strahlen zur Verfügung zu stellen, d. h. vorliegend sind nur die Bereiche der Spiegel gezeigt, die Licht reflektieren, die sog. Nutzbereiche. Der dritte Spiegel im Strahlengang, der Spiegel 2480 ist am nächsten zur Ebene 2452, wohingegen der zweite Spiegel im Strahlengang bzw. der Lichtweg der Spiegel 2460 am nächsten zur Ebene 2403 ist.

Während die Teilobjektive 400, 450 durch Spiegel ausgebildet sind, die keine Öffnungen umfassen, kann ein Teilobjektiv auch ausgebildet werden aus Spiegeln, die eine Öffnung umfassen. Diesbezüglich wird Bezug genommen auf Figur 1g in der ein Teilobjektiv 2500 dargestellt ist, dass aus Spiegeln 2510, 2520 besteht, bei dem der Spiegel 2510 eine Öffnung 2511 aufweist. Das Teilobjektiv 2500 ist derart aufgebaut, dass es Strahlen in eine Bildebene 2502, die beispielsweise korrespondiert zur Bildebene 2102 oder eine Zwischenbildebene sein kann, abbildet.

In Figur 1i ist ein anderes Beispiel eines Teilobjektives gezeigt, dass auf Spiegeln aufgebaut ist, die eine Öffnung umfassen. Dieses Teilobjektiv ist als Teilobjektiv 2550 bezeichnet. Das Teilobjektiv 2550 umfasst Spiegel 2560 und 2570. Der Spiegel 2560 umfasst eine Öffnung 2561 und Spiegel 2570 umfasst eine Öffnung 2571. Das Teilobjektiv 2550 ist derart aufgebaut, dass es Strahlen bzw. Strahlung bzw. Licht in eine Bildebene 2552 abbildet, wobei die Bildebene zur Bildebene 2102 oder eine Zwischenbildebene korrespondiert.

Teilobjektive, die Spiegel verwenden, die eine Öffnung haben, führen dazu, dass ein Teil der Pupille des Teilobjektives obskuriert ist. Dementsprechend haben Ausführungsbeispiele eines Projektionsobjektivs 2101 mit einem derartigen Teilobjektiv eine obskurierte Pupille. Das Ausmaß bis zu welchem die Pupille des Projektionsobjektivs 2101 obskuriert wird kann durch den Wert $R_{obs}$ charakterisiert werden, der den Anteil des Aperturradius des Projektionsobjektivs 2101 angibt, der in der Pupillenebene in einem meridionalen Schnitt bzw. in der Meridionalebene des Projektionsobjektivs 2101 obskuriert wird. Aufgrund der Rotationssymmetrie des Systems in Bezug auf die optische Achse ist es ausreichend den Obskurationsradius in der Meridionalebene zu berechnen. In einigen Ausführungsbeispielen die ein oder mehrere Spiegel mit einer Öffnung umfassen kann das Projektionsobjektiv 2100 eine sehr niedrige Pupillenobskuration aufweisen. Beispielsweise kann $R_{obs}$ 30% oder weniger, bevorzugt 25% oder weniger, insbesondere 22% oder weniger, bevorzugt 20% oder weniger, insbesondere 18% oder weniger, bevorzugt 15% oder weniger, insbesondere 12% oder weniger bevorzugt 10% oder weniger des Aperturradius betragen.

In einigen Ausführungsbeispielen umfasst das Projektionsobjektiv 2101 eine oder mehrere Pupillenebenen, die physikalisch zugänglich sind, um ein. Licht obskurierendes Element z. B. eine Abschattungsblende im Wesentlichen in der Pupillenebene anzuordnen, wobei die Pupillenebene die optische Achse 2105 schneidet.

Eine Anordnung einer Obskurationsblende bzw. einer Abschattungsblende in einer Pupillenposition kann zu einer feldunabhängigen Obskuration der Pupille führen.

Bevorzugt sind die Abschattungsblenden aus einem Material ausgebildet bzw. bestehen aus einer Beschichtung, die keine Strahlung bei der Betriebswellenlänge λ reflektiert, d. h. das Material absorbiert einfallende Strahlung der Betriebswellenlänge λ im Wesentlichen. Vorzugsweise ist die Abschattungsblende derart ausgestaltet, dass keine Streustrahlung in das System gelangt. In Figur 1 j wird ein Spiegel 2910 dargestellt, der im Wesentlichen in einer Pupillenebene des Projektionsobjektives 2101 angeordnet ist und eine Obskurationsblende 2912 auf der Spiegeloberfläche aufweist. Die Obskurationsblende 2912 kann bspw. aus einer nichtreflektierenden Beschichtung für Strahlung bei einer Wellenlänge λ bestehen. Die Obskurationsblende 2912 blockiert Strahlung, die entlang bestimmter Strahlenwege propagiert. Dies ist in Fig. 1j durch die Strahlen 2921, 2922 und 2923 illustriert. Die Strahlen 2921 und 2923 schneiden den reflektierenden Anteil des Spiegels 2910, wohingegen der Strahl 2922 die Abschattungsblende 2912 schneidet. Demgemäß wird durch den Spiegel 2910 Strahlung, die entlang des Weges 2921 und 2923 propagiert, auf einen im Lichtweg nachgeordneten Spiegel 2920 reflektiert. Die Strahlung, die entlang des Strahlwegs 2922 propagiert wird andererseits durch die Obskurationsblende bzw. Abschattungsblende 2912 geblockt.

In bestimmten Ausführungsbeispielen kann die Obskurationsblende zwischen den Spiegeln im Projektionsobjektiv 2101 angeordnet werden. Bspw. kann eine Obskurationsblende in einer Pupillenebene angeordnet werden, die nicht mit Ebenen von anderen im Projektionsobjektiv angeordneten Spiegeln zusammenfällt. Bezugnehmend auf Figur 1k wird eine Abschattungsblende 2926 zwischen dem Spiegel 2910 und 2920 angeordnet, um Strahlung, die entlang bestimmter Strahlwege zwischen den Spiegeln propagieren, abzublocken. Die Obskurationsblende kann bspw. unter Zuhilfenahme eines Hilfsstrahls 2928, der durch eine Öffnung 2924 des Spiegels hindurchtritt, platziert werden.

Eine andere Art der Befestigung ist in den Figuren 1l bis 1m angegeben. Hier wird eine Obskurationsblende 2930 zwischen den Spiegeln 2910 und 2920 platziert, wobei die Obskurationsblende von einem Haltering 2932, dessen innerer Durchmesser größer ist als die Apertur des Projektionsobjektives in der Pupillenebene, in der die Obskurationsblende 2930 angeordnet ist, gehalten wird. Die Obskurationsblende 2930 wird an einem ringförmigen Rahmenelement 2932 mit Hilfe von radialen Aufhängungen 2934 gehalten. Die Aufhängungen 2934 sind derart ausgebildet, dass sie nicht wesentliche Strahlung bzw. Licht blockieren.

In bestimmten Ausführungsbeispielen kann eine Abschattungsblende, die im Wesentlichen in einer Pupillenebene angeordnet ist, entfernt werden, bzw. mit einer anderen Abschattungsblende ausgetauscht werden, ohne dass ein Spiegel des Projektionsobjektives getauscht werden muss.

In einigen Ausführungsbeispielen können die Obskurationsblenden auf transmissiven optischen Elementen angeordnet werden. Bspw. kann bei Betriebswellenlängen, bei denen Materialien existieren, die ausreichend transmissiv sind und über eine ausreichende mechanische Festigkeit verfügen, eine Obskurationsblende auf einem transmissiven flachen Element gehalten werden.

Bspw. ist dies möglich bei Ausführungsbeispielen bei denen die Betriebswellenlänge $\lambda$ im sichtbaren Bereich des elektromagnetischen Spektrums liegt. Bei derartigen Wellenlängen im sichtbaren elektromagnetischen Spektrum können die Abschattungsblenden durch Beschichtungen oder Anordnen einer Obskurationsblende auf einem flachen Glaselement mit ausreichender Größe realisiert werden, die flachen Glassegmente vom Körper des Objektives 2101 gehalten werden.

Bspw. könne Obskurationsblenden in Ausführungsbeispielen verwendet werden, bei denen wenigstens ein Spiegel des Projektionsobjektives 2101 eine Öffnung für den Durchtritt von Strahlung aufweist. Im Allgemeinen kann die Größe der Obskurationsblenden variieren. In bestimmten Ausführungsbeispielen ist die Obskurationsblende derart gewählt, dass sie die kleinstmögliche Größe aufweist, die zur Verfügung gestellt werden muss, um eine im Wesentlichen feldunabhängige Obskuration der Austrittspupille des Projektionsobjektives zur Verfügung zu stellen. In einigen Ausführungsbeispielen kann die Obskurationsblende bzw. Abschattungsblende eine radiale Abmessung von ungefähr 60 % oder weniger, insbesondere 55 % oder weniger, insbesondere 50 % oder weniger, insbesondere 45 % oder weniger, ganz bevorzugt 40 % oder weniger, insbesondere 35 % oder weniger, insbesondere 30 % oder weniger, insbesondere 25 % oder weniger, ganz besonders 20 % oder weniger des Radius der Pupillenapertur haben.

Im Allgemeinen kann die Form des Feldes des Projektionsobjektives 2101 variieren. In einigen Ausführungsbeispielen kann das Feld eine bogenförmige Form aufweisen bspw. die Form eines Segmentes eines Ringes, ein so genanntes Ringfeld. Bspw. kann ein Projektionsobjektiv die Teilobjektive, die aus Spiegel gebildet werden, ohne eine Öffnung, wie die Teilobjektive 2400 und 2450, die oben beschrieben wurden, ein Feld in Form eines Ringfeldes aufweisen, In Figur 1f ist ein Ringsegment 2700 bzw. Ringfeld dargestellt. Dieses Ringsegment 2700 kann durch eine x-Dimension $D_x$, eine y-Dimension $D_y$ und eine radiale Dimension $D_r$ charakterisiert werden. $D_x$ und $D_y$ korrespondieren zur Dimension des Feldes bzw. zur Abmessung des Feldes entlang der x-Richtung und der y-Richtung. Diese Größen werden in der nachfolgendenbeschreibung angegeben. So beträgt bei einem Feld mit einer von bspw. 18.1 mm$^2$ in der Bildebene $D_x$=18 mm und $D_y$=1 mm. $D_r$ korrespondiert zum Ringradius gemessen von der optischen Achse 2105 zur inneren Grenze des Feldes 2700. Das Ringfeldsegment 2700 ist symmetrisch bezogen auf die Ebene parallel zur y-z-Ebene, wie durch die Linie 2710 angedeutet. Im Allgemeinen ist die Größe von $D_x$, $D_y$ und $D_r$ variabel und hängt von dem Design des Projektionsobjektives 2101 ab. Typischerweise ist $D_x$ größer als $D_y$. Die relative Größe der Felddimensionen bzw. Feldabmessungen $D_x$, $D_y$ und $D_r$ in der Objektebene 2103 und der Bildebene 2102 variieren in Abhängigkeit von der Vergrößerung oder Verkleinerung des Projektionsobjektives 2101. In einigen Ausführungsbeispielen ist $D_x$ in der Bildebene 2103 relativ groß. Beispielsweise kann $D_x$ in der Bildebene 2101 größer als 1 mm, bevorzugt größer als 3 mm, insbesondere größer als 4 mm, bevorzugt größer als 5 mm, insbesondere größer als 6 mm, insbesondere größer als 7 mm, bevorzugt größer als 8 mm, insbesondere größer als 9mm, bevorzugt größer als 10 mm, insbesondere größer als 11 mm, bevorzugt größer als 12 mm, insbesondere größer als 13 mm, bevorzugt größer als 14 mm, insbesondere größer als 15 mm, bevorzugt größer als 18 mm, insbesondere größer als 20 mm, bevorzugt größer als 25 mm sein. $D_y$ in der Bildebene 2102 kann im Bereich von 0,5 mm bis 5 mm liegen, bspw. bis 1 mm, bevorzugt bis 2 mm, insbesondere bis 3 mm, ganz besonders bevorzugt bis 4mm. Typischerweise ist $D_r$ in der Bildebene 2102 im Bereich von 10 mm bis 50 mm. $D_r$ kann beispielsweise 15 mm oder mehr, beispielsweise 20 mm oder mehr, insbesondere 25 mm oder mehr, bevorzugt 30 mm oder mehr in der Bildebene 2102 betragen. Des Weiteren gezeigt ist für das Ringfeld 2700 der zentrale Feldpunkt 2705.

Allgemein gesprochen kann für andere Feldformen das Projektionsobjektiv 2101 eine maximale Felddimension bzw. Feldabmessung mehr als 1 mm, insbesondere mehr als 3 mm, bevorzugt mehr als 4 mm, insbesondere mehr als 5 mm, bevorzugt mehr als 6 mm, insbesondere mehr als 7 mm, bevorzugt mehr als 8 mm, insbesondere mehr als 9 mm, bevorzugt mehr als 10 mm, insbesondere mehr als 11 mm, bevorzugt mehr als 12 mm, insbesondere mehr als 13 mm, bevorzugt mehr als 14 mm, insbesondere mehr als 15 mm, bevorzugt mehr als 18 mm, insbesondere mehr als 20 mm oder mehr als 25 mm in der Bildebene 2102 betragen.

Die Ausführungsform des Projektionsobjektiv 2101 haben einen relativ großen bildseitigen freien Arbeitsabstand. Der bildseitige freie Arbeitsabstand bezieht sich auf die kürzeste Entfernung zwischen der Bildebene 2102 und der Spiegelfläche des Spiegels, der geometrisch am nächsten zur Bildebene 2102 angeordnet ist. Dies ist in Figur 1o gezeigt, die einen Spiegel 2810 zeigt, der geometrisch am nächsten zur Bildebene 2102 angeordnet ist. Die Strahlung wird von der Oberfläche 2811 auf den Spiegel 2810 reflektiert. Der bildseitige freie Arbeitsabstand ist mit $D_w$ bezeichnet. In einigen Ausführungsbeispielen ist $D_w$ 25 mm oder mehr, bevorzugt 30 mm oder mehr, insbesondere 35 mm oder mehr, bevorzugt 40 mm oder mehr, insbesondere 45 mm oder mehr, bevorzugt 50 mm oder mehr, insbesondere 55 mm oder mehr, bevorzugt 60 mm oder mehr, insbesondere 65 mm oder mehr. Ein relativ großer Arbeitsabstand ist wünschenswert, da er es erlaubt, dass die Oberfläche des Substrates 2150 in der Bildebene 2102 angeordnet werden kann, ohne das eine Seite des Spiegels 2810, der zur Bildebene 2102 hinweist, berührt wird.

In analoger Weise bezieht sich der objektseitige freie Arbeitsabstand auf die kürzeste der Entfernung zwischen der Objektebene 2103 und der Ebene der reflektiven Seite des Spiegels im Projektionsobjektiv 2101, der geometrisch am nächsten zur Objektebene 2103 angeordnet ist. In einigen Ausführungsbeispielen weist das Projektionsobjektiv 2101 einen großen objektseitigen freien Arbeitsabstand auf. Beispielsweise kann das Projektionsobjektiv 2101 einen objektseitigen freien Arbeitsabstand von 50 mm oder mehr, bevorzugt 100 mm oder mehr, insbesondere 150 mm oder mehr, bevorzugt 200 mm oder mehr, insbesondere 250 mm oder mehr, bevorzugt 300 mm oder mehr, insbesondere 350 mm oder mehr, insbesondere 400 mm oder mehr, bevorzugt 450 mm oder mehr, bevorzugt 500 mm oder mehr, insbesondere 550 mm oder mehr, bevorzugt 600 mm oder mehr, insbesondere 650 mm oder mehr, bevorzugt 700 mm oder mehr, bevorzugt 750 mm oder mehr, insbesondere 800 mm oder mehr, bevorzugt 850 mm oder, insbesondere 900 mm oder mehr, insbesondere 950 mm oder mehr, insbesondere 1000 mm oder mehr betragen. Ein relativ großer objektseitiger freier Arbeitsabstand kann in Ausführungsformen vorteilhaft sein, bei denen der Raum zwischen Projektionsobjektiv 2101 und der Objektebene 2103 zugänglich sein muss. Beispielsweise bei Ausführungsformen, bei denen die Maske 2140 reflektiv ausgebildet ist, ist es notwendig, die Maske von der Seite, die dem Objektiv 2101 zugewandt ist, zu beleuchten. Daher sollte ein ausreichender Raum zwischen dem Projektionsobjektiv 2101 und der Objektebene 2103 vorhanden sein, um die Maske durch das Beleuchtungssystem 2120 unter einem bestimmten Beleuchtungswinkel zu beleuchten. Des Weiteren ermöglicht ein großer objektseitiger freier Arbeitsabstand eine Flexibilität im Design des Restes des Mikrolithographie-Projektionsobjektives, bspw. dadurch, dass ausreichend Raum zum Befestigen anderer Komponenten des Projektionsobjektives 2101 und der Trägerstruktur für die Maske 2140 zur Verfügung gestellt wird.

In einigen Ausführungsbeispielen ist der Spiegel der am nächsten zur Objektebene 2103 angeordnet ist derart positioniert, dass er einen großen Abstand von der optischen Achse 2105 aufweist. In anderen Worten bedeutet dies, dass die optische Achse 2105 nicht die Spiegel, die am nächsten zur Objektebene 2103 angeordnet sind, schneidet. Ein derartiges System ist in Figur 1p gezeigt. Das in Figur 1p gezeigte System umfasst vier Spiegel 2941 bis 2944, wobei Spiegel 2941 am nächsten zur Objektebene 2103 angeordnet ist. Die minimale Entfernung zwischen dem Spiegel 2941 und der optischen Achse 2105 ist der Abstand 2946.

In einigen Ausführungsbeispielen kann der Abstand 2946 50 mm oder mehr, bevorzugt 60 mm oder mehr, insbesondere 70 mm oder mehr, ganz besonders 80 mm oder mehr, insbesondere 90 mm oder mehr, ganz besonders 100 mm oder mehr, insbesondere 110 mm oder mehr, besonders 120 mm oder mehr, insbesondere 130 mm oder mehr, ganz besonders 140 mm oder mehr, insbesondere 150 mm oder mehr, insbesondere 160 mm oder mehr, insbesondere 170 mm oder mehr, insbesondere 180 mm oder mehr, insbesondere 190 mm oder mehr, insbesondere 200 mm oder mehr, insbesondere 210 mm oder mehr, insbesondere 220 mm oder mehr, insbesondere 230 mm oder mehr, insbesondere 240 mm oder mehr, insbesondere 250 mm oder mehr, insbesondere 260 mm oder mehr, insbesondere 270 mm oder mehr, insbesondere 280 mm oder mehr, insbesondere 290 mm oder mehr, ganz bevorzugt 300 mm oder mehr sein.

Es kann vorteilhaft sein, dass der Abstand zur optischen Achse 2946 relativ groß ist, da dies einen sehr großen Raum nahe dem Ort, an dem die optische Achse 2105 die Objektebene 2103 schneidet zur Verfügung stellt. Dieser Raum kann dazu benutzt werden, andere Komponenten der Belichtungsanlage bzw. des lithographischen Tools wie bspw. eine oder mehrere optische Komponenten des Beleuchtungssystems, bspw. einen gracing-incidence-Spiegel, ein sog. reflektives gracing-incidence-Element anzuordnen. Einige der Strahlungen, die vom Projektionsobjektiv abgebildet werden, folgt dem Lichtweg 2947. Die Strahlen schneiden bzw. treffen auf die Spiegel in der nachfolgenden Ordnung: Spiegel 2942, Spiegel 2941, Spiegel 2943 und Spiegel 2944 auf. Der Lichtweg 2947 kreuzt sich in der Meridionalebene mit sich selbst zwischen den Spiegeln 2941 und 2943 bevor er am Spiegel 2942 reflektiert wird.

**EP 1 828 829 B1**

Im Allgemeinen ist das Projektionsobjektiv 2101 so ausgestaltet, dass Hauptstrahlen vom Retikel 2140 entweder konvergieren zu oder divergieren von oder parallel sind zur optischen Achse 2105. In anderen Worten, kann die Position der Eintrittspupille des Projektionsobjektives 2101 in Bezug auf die Objektebene 2103 variieren, abhängig vom Design des Projektionsobjektives. In einigen Ausführungsbeispielen liegt die Objektebene 2103 zwischen Projektionsobjektiv 2101 und der Eintrittspupille des Projektionsobjektives 2101. Alternativ hierzu kann in einigen Ausführungsbeispielen die Eintrittspupille zwischen der Objektebene 2103 und dem Projektionsobjektiv 2101 positioniert sein.

Das Beleuchtungssystem 2120 kann so angeordnet sein, dass die Austrittspupille des Beleuchtungssystems im Wesentlichen am Ort der Eintrittspupille des Projektionsobjektives 2101 angeordnet ist. In bestimmten Ausführungsbeispielen umfasst das Beleuchtungssystem 2120 ein Teleskopsystem, das die Austrittspupille des Beleuchtungssystems an den Ort der Eintrittspupille des Projektionsobjektives 2101 projiziert. In einigen Ausführungsbeispielen hingegen ist die Austrittspupille des Beleuchtungssystems 2120 im Bereich der Eintrittspupille des Projektionsobjektives 2101 platziert, ohne das ein Teleskopsystem im Beleuchtungssystem vorhanden ist. Bspw. koinzidiert, wenn die Objektebene 2103 zwischen Projektionsobjektiv 2101 und der Eintrittspupille des Projektionsobjektives angeordnet ist, die Austrittspupille des Beleuchtungssystems 2120 mit der Eintrittspupille des Projektionsobjektives, ohne dass ein Teleskop-System im Beleuchtungssystem verwandt werden muss.

Im Allgemeinen kann das Projektionsobjektiv 2101 unter Verwendung kommerziell erhältlicher optischer Designprogramme wie ZEMAX, OSLO, Code V, designed werden. Beginnend mit der Festlegung der Wellenlänge, der Feldgröße und der numerischen Apertur können die optischen Eigenschaften optimiert werden, die für ein Projektionsobjektiv benötigt werden, wie bspw. der Wellenfrontfehler, die Telezentrie, die Uniformität sowie die Verzeichnung. Nachfolgend sollen Ausführungsbeispiele der Erfindung eingehend mit optischen Daten beschrieben werden.

In Fig. 1q ist als erstes Ausführungsbeispiel ein 8-Spiegel-System mit einer bildseitigen Apertur von NA=0,54 für eine Betriebswellenlänge von 13,4 nm gezeigt. Der Abbildungsmaßstab ist sechsfach, d.h. das Bild ist in der Bildebene gegenüber dem Objekt 6-fach verkleinert und die Auflösung 15 nm.

Das Bildfeld hat eine Größe von 13 x 1 mm$^2$ in der Bildebene, d. h. $D_x$=13 mm, Dy=1 mm, $D_r$=20 mm. Die bildseitige $W_{RMS}$= 0,024 λ und die bildseitig Feldkrümmung, d. h. die Bildfeldkrümmung 3 nm. Die Baulänge des Systems beträgt 1745 mm.

Eingezeichnet ist auch das Koordinatensystem in x, y und z-Richtung. Dargestellt ist das Objektiv in der y-, z-Ebene, die auch die optische Achse HA des Projektionsobjektives umfasst und somit eine Meridionalebene ist.

Das erfindungsgemäße Projektionsobjektiv umfasst drei Teilobjektive, das erste Teilobjektiv 100, das zweite Teilobjektiv 200 sowie das dritte Teilobjektiv 300. Das erste Teilobjektiv umfasst insgesamt vier Spiegel, S1, S2, S5 sowie S6. Im Lichtweg von der Objektebene 10 zur Bildebene 20 gesehen ist der Spiegel S1 ein Konkavspiegel, der Spiegel S2 ein Konvexspiegel, der siebte Spiegel S5 ein Konvexspiegel und der Spiegel S6 ein Konkavspiegel. Der Abbildungsfaktor des ersten Teilobjektives beträgt 1,77x. Eine Aperturblende B ist auf dem Spiegel S5 angeordnet. Die Objektebene, in der bspw. das Retikel zu liegen kommt, ist mit 10 bezeichnet. Die optische Achse, um die einzelne Spiegelsegmente rotationssymmetrisch sind ist mit HA bezeichnet und die Gesamtlänge des Systems von der Objektebene 10 zur Bildebene 20, die auch als Baulänge bezeichnet wird mit BL. Das erste Teilobjektiv wird auch als Feldgruppe bezeichnet und umfasst wenigstens zwei Spiegel, den Spiegel S1 und den Spiegel S2. Spiegel S1 und Spiegel S2 sind wie Fig. 1 zeigt außeraxiale Spiegelsegmente sog. off-axis Spiegelsegmente, die die Korrektur feldabhängiger Bildfehler zulassen. An das erste Teilobjektiv 100 schließt sich in dem dargestellten Ausführungsbeispiel eine Transfergruppe an, die vorliegend als drittes Teilobjektiv 300 bezeichnet wird und zwei Spiegel, den Spiegel S3 und den Spiegel S4 umfasst, wobei S3 ein Konvexspiegel und S4 ein Konkavspiegel ist.

In dem gezeigtem Ausführungsbeispiel wird ein Zwischenbild Z1 in oder nahe des Konkavspiegels S4 ausgebildet und ein Zwischenbild Z2 des Projektionsobjektives physikalisch in der Nähe des Konvexspiegels S3.

Der Abbildungsfaktor des dritten Teilobjektives das auch als Transfergruppe bezeichnet wird, beträgt 2,88x. An das dritte Teilobjektiv schließt sich eine sogenannte Relay-Gruppe an, die auch als zweites Teilobjektiv 200 bezeichnet wird und einen Abbildungsfaktor von 1,18x hat.

Das zweite Teilobjektiv 200 umfasst vorliegend zwei Spiegel, die beide als Konkavspiegel ausgebildet sind. Diese Spiegel werden daher auch als primärer Konkavspiegel SK1 und sekundärer Konkavspiegel SK2 bezeichnet. Der Spiegel S3, beinhalten eine Aperturöffnung A1, und der sekundäre Konkavspiegel SK2 eine Aperturöffnung A2, der primäre Konkavspiegel eine Aperturöffnung A3 sowie der Spiegel S4 eine Aperturöffnung A4. Somit sind im in Figur 1 dargestellten Objektiv die Spiegel S3, S4 SK1 und SK2 Spiegel mit einer Öffnung durch die ein Strahlbüschel hindurchtritt im Sinne der Anmeldung. Desweiteren bilden die Spiegel S3, S4, SK1, SK2 im Sinne dieser Anmeldung ein zweites Subobjektiv aus, das ausschließlich Spiegel mit einer Öffnung für den Durchtritt eines Strahlbüschels aufweist. Der resultierende Radius der die feldunabhängige Obskuration zur Verfügung stellt, beträgt sind 43 % des Aperturradius.

Die Spiegel S1, S2, S5 und S6 bilden im Sinne dieser Anmeldung ein erstes Subobjektiv aus, das keinen Spiegel mit einer Öffnung für den Durchtritt eines Strahlbüschels aufweist, d.h. keinen durchbohrten Spiegel.

Wie deutlich zu erkennen ist, ist aufgrund der Ausbildung des zur Bildebene 20 nächsten liegenden Spiegels SK1 als Konkavspiegel der Abstand A zwischen der Vertex V3, d.h. des Scheitelpunktes des primären Konkavspiegels SK1 und der Bildebene 20, d. h. der bildseitige Arbeitsabstand größer als 12 mm, bevorzugt größer als 15 mm, ganz bevorzugt größer als 40 mm. Der objektseitige freie Arbeitsabstand beträgt 100 mm.

Das zweite Teilobjektiv 200 bildet das zweite Zwischenbild Z2 in die Bildebene 20 ab.

Bei der dargestellten Ausführungsform wird aus der relativen Größe der Abbildungsmaßstäbe deutlich, dass das dritte Teilobjektiv den niederaperturigen Objektivteil mit dem hochaperturigen Objektivteil verbindet. Das dritte Teilobjektiv wird daher auch als Transfergruppe bezeichnet.

Der maximale Einfallswinkel $\Theta_{CR(max)}$ des Hauptstrahles zum zentralen Feldpunkt beträgt auf den Spiegeln S1, S2, S3, S4, S5, S6, SK1, SK2 $\Theta_{max(max)}$ 33,8°. Der maximale Einfallswinkel eines jeden Strahls auf die Spiegel S1, S2, S3, S4, S5, S6, SK1 und SK2 beträgt 38,6°. Der maximale Winkelbereich $\Delta\Theta_{max}$ der einfallenden Strahlen auf jeden Spiegel S1, S2, S3, S4, S5, S6, SK1 und SK2 beträgt 12°. Die Größe des größten Spiegels im Meridionalschnitt, d. h. in der Meridionalebene beträgt 669 mm. Die Größe des größten Spiegels in x-Richtung beträgt 675 mm.

Die optischen Daten des Systems gemäß Figur 1q können aus nachfolgender Tabelle 1 entnommen werden.

Dabei bezeichnet

Mirror 1: den Spiegel S1
Mirror 2: den Spiegel S2
Mirror 3: den Spiegel S5
Mirror 4: den Spiegel S6
Mirror 5: den Spiegel S3
Mirror 6: den Spiegel S4
Mirror 7: den primären Konkavspiegel SK1
Mirror 8: den sekundären Konkavspiegel SK2

Der erste Teil von Tabelle 1 gibt die optischen Daten wieder und der zweite Teil von Tabelle 1 die asphärischen Konstanten der jeweiligen Spiegelflächen.

<div align="center">Tabelle 1</div>

| Surface | Radius | Thickness | Mode |
|---|---|---|---|
| Object | INFINITY | 316.480 | |
| Mirror 1 | -375.233 | -77.505 | REFL |
| Mirror 2 | 2976.73 | 51.007 | REFL |
| STOP | INFINITY | 0.000 | |
| Mirror 3 | 127.889 | -189.982 | REFL |
| Mirror 4 | 329.839 | 1029.934 | REFL |
| Mirror 5 | 787.6 | -596.052 | REFL |
| Mirror 6 | 735.437 | 1171.383 | REFL |
| Mirror 7 | -1195.158 | -512.255 | REFL |
| Mirror 8 | 977.668 | 552.254 | REFL |
| Image | INFINITY | 0.000 | |

| Surface | K | A | B | C |
|---|---|---|---|---|
| Mirror 1 | 0.00000E+00 | -3.72335E-09 | -1.17134E-13 | -9.45919E-19 |
| Mirror 2 | 0.00000E+00 | -6.42297E-08 | 5.78359E-13 | -1.12102E-17 |
| Mirror 3 | 0.00000E+00 | -1.89730E-07 | 1.46577E-11 | -7.35930E-15 |
| Mirror 4 | 0.00000E+00 | -6.59877E-10 | -4.46770E-15 | -8.43588E-22 |
| Mirror 5 | 0.00000E+00 | 6.80330E-10 | 8.62377E-15 | 7.97025E-20 |
| Mirror 6 | 0.00000E+00 | 1.51444E-10 | 4.21253E-16 | 9.86205E-22 |
| Mirror 7 | 0.00000E+00 | -9.01450E-11 | 7.43085E-17 | -9.79557E-22 |
| Mirror 8 | 0.00000E+00 | -4.33573E-10 | -6.45281 E-16 | 1.20541 E-22 |

(fortgesetzt)

| Surface | D | E | F | G |
|---------|---|---|---|---|
| Mirror 1 | 2.64879E-22 | -1.44452E-26 | 3.02340E-31 | 0.00000E+00 |
| Mirror 2 | 1.41033E-20 | -2.65285E-24 | 1.76103E-28 | 8.50988E-33 |
| Mirror 3 | 4.29136E-18 | 4.55565E-22 | 6.01716E-23 | -9.67457E-26 |
| Mirror 4 | -1.47803E-24 | 4.37901 E-29 | -7.78139E-34 | 6.26619E-39 |
| Mirror 5 | 9.90660E-24 | -3.49519E-27 | 2.27576E-31 | -5.30361 E-36 |
| Mirror 6 | 2.49255E-27 | 3.14626E-33 | 1.55856E-38 | 5.58485E-45 |
| Mirror 7 | 6.90221 E-27 | -3.91894E-32 | 1.37730E-37 | -2.19834E-43 |
| Mirror 8 | 6.77194E-28 | 1.92112E-32 | -7.82371 E-38 | 1.09694E-43 |

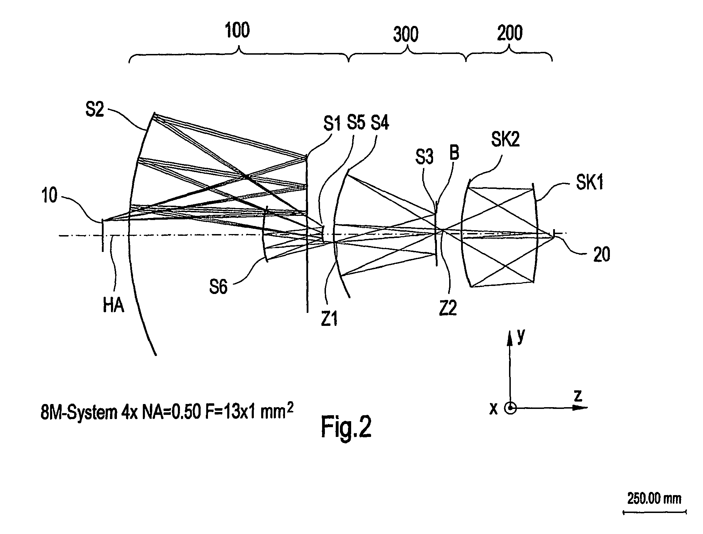

In Figur 2 ist ein zweites Ausführungsbeispiel eines 8-Spiegel-Objektives mit einer numerischen Apertur NA=0,5 und 4-facher Verkleinerung gezeigt. Gleiche Bauteile wie in Figur 1 sind mit denselben Bezugsziffern belegt.

Die Betriebswellenlänge 1 beträgt 13,5 nm. Die Auflösung des Objektives beträgt 17 nm, sowie die Baulänge 1711 mm. Der bildseitige $W_{RMS}$ beträgt 0,044 λ und die bildseitige Feldkrümmung 12 nm. Der Obskurationsradius, der für eine feldunabhängige Obskuration sorgt, beträgt 36 % des Aperturradius. Der bildseitige freie Arbeitsabstand beträgt 69 mm und der objektseitige freie Arbeitsabstand 100 mm. Der maximale Einfallswinkel $\Theta_{CR(max)}$ des Hauptstrahles zum zentralen Feldpunkt auf den Spiegeln S1, S2, S3, S4, S5, S6, SK1 und SK2 beträgt 19,4°. Der maximale Einfallswinkel $\Theta_{max(max)}$ irgendeines Strahls auf die Spiegel S1, S2, S3, S4, S5, S6, SK1 und SK2 beträgt 21,8°. Der maximale Winkelbereich $\Delta\Theta_{max}$ der einfallenden Strahlen auf jedem Spiegel S1, S2, S3, S4, S5, S6, SK1 und SK2 beträgt 15°. Der größte Spiegel hat eine Abmessung im Meridionalschnitt von 385 mm und die Größe des größten Spiegels in x-Richtung beträgt 616 mm.

Die optischen Daten ergeben sich aus nachfolgender Tabelle 2

Dabei bezeichnet

| Mirror 1: | den Spiegel S1 |
|-----------|----------------|
| Mirror 2: | den Spiegel S2 |
| Mirror 3: | den Spiegel S5 |
| Mirror 4: | den Spiegel S6 |
| Mirror 5: | den Spiegel S3 |
| Mirror 6: | den Spiegel S4 |
| Mirror 7: | den primären Konkavspiegel SK1 |
| Mirror 8: | den sekundären Konkavspiegel SK2 |

Der erste Teil von Tabelle 2 gibt die optischen Daten wieder und der zweite Teil von Tabelle 2 die asphärischen Konstanten der jeweiligen Spiegelflächen.

Tabelle 2

| Surface | Radius | Thickness | Mode |
|---------|--------|-----------|------|
| Object | INFINITY | 762.134 | |
| Mirror 1 | 44367.928 | -662.134 | REFL |
| Mirror 2 | 1027.348 | 717.444 | REFL |
| Mirror 3 | 122.696 | -209.209 | REFL |
| Mirror 4 | 298.792 | 645.481 | REFL |
| STOP | INFINITY | 0.000 | |
| Mirror 5 | 1184.237 | -391.582 | REFL |
| Mirror 6 | 518.111 | 780.329 | REFL |
| Mirror 7 | -834.844 | -288.328 | REFL |
| Mirror 8 | 612.533 | 357.344 | REFL |
| Image | INFINITY | 0.000 | |

**EP 1 828 829 B1**

(fortgesetzt)

| Surface | K | A | B |
|---|---|---|---|
| Mirror 1 | 0.00000E+00 | -7.47500E-11 | -1.75668E-16 |
| Mirror 2 | 0.00000E+00 | -1.89057E-11 | -2.80932E-17 |
| Mirror 3 | 0.00000E+00 | 4.36794E-08 | -1.06646E-11 |
| Mirror 4 | 0.00000E+00 | 2.82491E-10 | 8.34214E-15 |
| Mirror 5 | 0.00000E+00 | -3.60521 E-09 | 9.55167E-14 |
| Mirror 6 | 0.00000E+00 | 3.17133E-10 | 1.58610E-15 |
| Mirror 7 | 0.00000E+00 | 1.39054E-10 | -7.02552E-16 |
| Mirror 8 | 0.00000E+00 | -1.05535E-09 | -1.09975E-15 |

| Surface | C | D | E |
|---|---|---|---|
| Mirror 1 | 3.61103E-22 | 3.67940E-28 | 0.00000E+00 |
| Mirror 2 | -3.13881 E-23 | -4.81965E-29 | 0.00000E+00 |
| Mirror 3 | 2.88089E-15 | 1.57635E-18 | 0.00000E+00 |
| Mirror 4 | 1.25238E-19 | 6.61889E-25 | 4.85405E-29 |
| Mirror 5 | -3.43883E-18 | -4.42296E-23 | -5.96479E-28 |
| Mirror 6 | 7.12061 E-21 | 2.79827E-26 | 2.00701 E-31 |
| Mirror 7 | 1.18760E-20 | -6.15624E-26 | 5.37541 E-31 |
| Mirror 8 | 8.52603E-23 | 3.64425E-26 | 2.56412E-31 |

Die Größe des Feldes, das durch das Objektiv gemäß Figur 2 abgebildet wird, beträgt 13 x 1 mm$^2$ in der Bildebene. Die Feldform ist ein Ringfeld wie in Fig. 1 n gezeigt, wobei $D_x$=13 mm, $D_y$=1 mm und $D_r$=13 mm ist.

Im Gegensatz zum Ausführungsbeispiel in Figur 1, das die Aperturblende auf dem Spiegel S5 (Mirror 3) und damit dem dritten Spiegel im Strahlengang von der Objektebene zur Bildebene im ersten Teilobjektiv hat, ist die Aperturblende B bei dem in Figur 2 gezeigten Ausführungsbeispiel auf dem Konvexspiegel der Transfergruppe - dies ist der Spiegel S3 - angeordnet.

Bei dem in Figur 2 gezeigten System werden drei Teilobjektive 100, 300 und 200 ausgebildet. Das Teilobjektiv 100 umfasst die Spiegel S1, S2, S5 und S6 und bildet ein Zwischenbild Z1 in oder nahe dem Spiegel S4 aus. Das zweite Teilobjektiv 200 umfasst die Spiegel SK1 und SK2 und das dritte Teilobjektiv 300 die Spiegel S3 und S4. Das dritte Teilobjektiv bildet ein Zwischenbild Z2 in oder nahe dem Spiegel S3 aus.

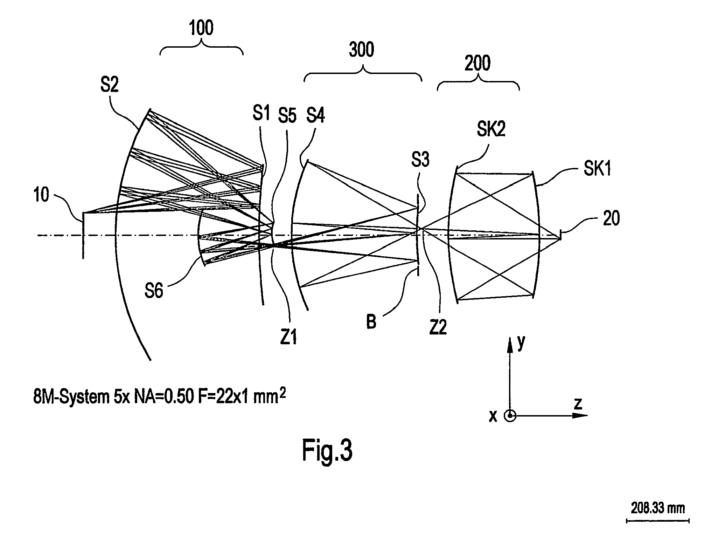

In Figur 3 ist ein ähnliches 8-Spiegel-System wie in Figur 2 dargestellt, jedoch beträgt der Abbildungsmaßstab bzw. der Abbildungsfaktor beim Ausführungsbeispiel in Figur 3 5x d. h. das Bild wird 5-fach gegenüber dem Objekt verkleinert. Die bildseitige numerische Apertur NA ist wiederum 0,5 bei einer Wellenlänge λ=13,5 nm. Das abzubildende Feld, d. h. Bildfeld hat eine Größe von 22 x 1 mm$^2$ in der Bildebene und die Form eines Ringfeldes, wobei $D_x$=22 mm, $D_y$=1mm und $D_r$=12,6 mm. Die Auflösung des Systems beträgt 17 nm, die Baulänge des Systems 1509 mm. Die bildseitige $W_{RMS}$ beträgt 0,01 λ und die bildseitige Feldkrümmung 2 nm.

Der bildseitige freie Arbeitsabstand ist 69 mm und der objektseitige freie Arbeitsabstand 104 mm. Der maximale Einfallswinkel $\Theta_{CR(max)}$ auf die Spiegel S1, S2, S3, S4, S5, S6, SK1 und SK2 des Hauptstrahls zum zentralen Feldpunkt beträgt 23,1°. Der maximale Einfallswinkel $\Theta_{max(max)}$ eines jeden Strahles auf einen Spiegel S1, S2, S3, S4, S5, S6, SK1 und SK2 beträgt 26,6°. Der maximale Einfallsbereich $\Delta\Theta_{max}$ auf irgendeinen Spiegel S1, S2, S3, S4, S5, S6, SK1 und SK2 beträgt 16°. Die Größe des größten Spiegels im Meridionalschnitt beträgt 394 mm und die Größe des größten Spiegels in x-Richtung 669 mm.

Der Obskurationsradius, der für eine feldunabhängige Obskuration sorgt, beträgt 35 % des Aperturradius. Die Spiegel S3, S4, SK1 und SK2 umfassen Öffnungen. Die Spiegel sind so ausgebildet, dass drei Teilobjektive ausgebildet werden. Ein erstes Teilobjektiv 100, ein zweites Teilobjektiv 300 und ein drittes Teilobjektiv 200. Dementsprechend besitzt das dargestellte Projektionsobjektiv 3 Pupillenebenen und zwei Zwischenbilder. Wenigstens eine der Pupillenebenen ist zugänglich zur Positionierung einer Aperturblende. Das erste Teilobjektiv umfasst die Spiegel S1, S2, S5 und S6 und bildet ein Zwischenbild Z1 in oder nahe dem Spiegel S5 aus. Das zweite Teilobjektiv 300 umfasst zwei Spiegel SK1 und SK2. Das dritte Teilobjektiv umfasst zwei Spiegel S3 und S4. Die Blende wird auf dem dritten Spiegel S3 ausgebildet.

Die optischen Daten ergeben sich aus nachfolgender Tabelle 3.

Dabei bezeichnet

Mirror 1: den Spiegel S1
Mirror 2: den Spiegel S2
Mirror 3: den Spiegel S5
Mirror 4: den Spiegel S6
Mirror 5: den Spiegel S3
Mirror 6: den Spiegel S4
Mirror 7: primären Konkavspiegel SK1
Mirror 8: sekundären Konkavspiegel SK2

Der erste Teil von Tabelle 3 gibt die optischen Daten wieder und der zweite Teil von Tabelle 3 die asphärischen Konstanten der jeweiligen Spiegelflächen.

Tabelle 3

| Surface | Radius | Thickness | Mode |
|---------|--------|-----------|------|
| Object | INFINITY | 546.051 | |
| Mirror 1 | 1813.761 | -442.075 | REFL |
| Mirror 2 | 659.925 | 484.056 | REFL |
| Mirror 3 | 124.229 | -230.251 | REFL |
| Mirror 4 | 297.991 | 681.239 | REFL |
| STOP | INFINITY | 0.000 | |
| Mirror 5 | 1044.821 | -388.855 | REFL |
| Mirror 6 | 513.480 | 790.082 | REFL |
| Mirror 7 | -788.712 | -300.808 | REFL |
| Mirror 8 | 679.931 | 369.811 | REFL |
| Image | INFINITY | 0.000 | |

| Surface | K | A | B |
|---------|---|---|---|
| Mirror 1 | 0.00000E+00 | -1.19695E-10 | -8.52500E-16 |
| Mirror 2 | 0.00000E+00 | -3.36861 E-12 | -7.92767E-18 |
| Mirror 3 | 0.00000E+00 | 9.84422E-08 | 1.34188E-11 |
| Mirror 4 | 0.00000E+00 | 1.55138E-09 | 3.79123E-14 |
| Mirror 5 | 0.00000E+00 | -4.54986E-09 | -1.08708E-13 |
| Mirror 6 | 0.00000E+00 | 1.67047E-10 | 5.41737E-16 |
| Mirror 7 | 0.00000E+00 | 5.45494E-10 | 1.78568E-15 |
| Mirror 8 | 0.00000E+00 | -5.70218E-10 | 1.44136E-15 |

| Surface | C | D | E |
|---------|---|---|---|
| Mirror 1 | 7.78764E-22 | 2.36289E-26 | 0.00000E+00 |
| Mirror 2 | -1.47046E-23 | -1.76721 E-28 | 0.00000E+00 |
| Mirror 3 | 1.19275E-15 | 7.18150E-19 | 0.00000E+00 |
| Mirror 4 | 7.88066E-19 | 1.04079E-23 | 8.66992E-28 |
| Mirror 5 | -1.73422E-18 | -5.79768E-23 | 2.10975E-27 |
| Mirror 6 | 1.67663E-21 | 5.27011 E-27 | 2.40781 E-32 |
| Mirror 7 | 9.69823E-21 | 1.84324E-26 | -1.96285E-32 |
| Mirror 8 | 6.92822E-21 | -1.65770E-26 | 4.86553E-32 |

Gleiche Bauteile wie in Figur 1 und 2 sind in Figur 3 mit denselben Bezugsziffern belegt.

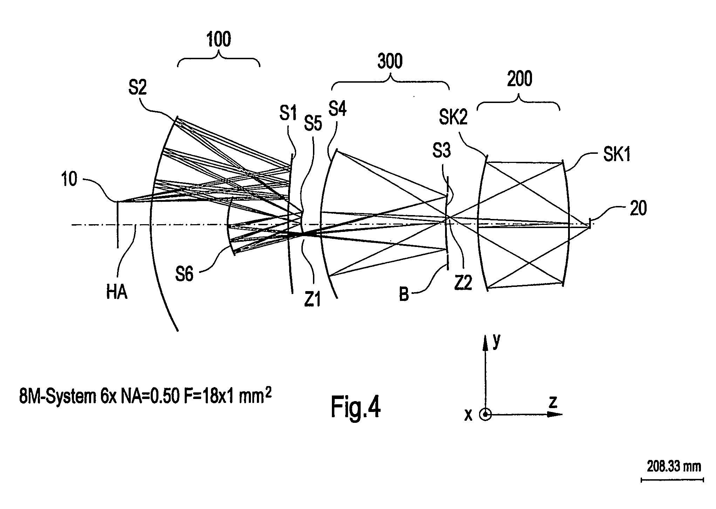

In Figur 4 ist eine vierte Ausführungsform eines 8-Spiegel-Objektives gezeigt, das einen 6x Abbildungsfaktor und eine numerische Apertur NA=0,5 aufweist bei 13,5 nm Wellenlänge. Die Auflösung beträgt 17 nm, die Baulänge des Systems 1508 mm. Die bildseitige $W_{RMS}$ beträgt 0,006 $\lambda$, die bildseitige Feldkrümmung 2 nm. Der resultierende Obskurationsradius, der eine feldunabhängige Obskuration zur Verfügung stellt beträgt 31 % des Aperturradius. Der bildseitige freie Arbeitsabstand beträgt 69 mm und der objektseitige Arbeitsabstand 102 mm. Der maximale Einfallswinkel $\Theta_{CR(max)}$ des Hauptstrahles zum zentralen Feldpunkt auf die Spiegel S1, S2, S3, S4, S5, S6, SK1 und SK2 beträgt 20°. Der maximale Einfallswinkel $\Theta_{max(max)}$ irgendeines Strahles auf die Spiegel S1, S2, S3, S4, S5, S6, SK1 und SK2 beträgt 22,3°. Der maximale Einfallsbereich $\Delta\Theta_{max}$ auf irgendeinen Spiegel S1, S2, S3, S4, S5, S6, SK1 und SK2 beträgt 13,6°. Die Größe des größten Spiegels im meridonalen Schnitt beträgt 396 mm und die Größe des größten Spiegels in x-Richtung 575 mm. Die Spiegelabfolge im Lichtweg von der Objektebene 10 zur Bildebene 20 ist wie folgt:

konvex - konkav - konvex- konkav- konvex- konkav- konkav-konkav.

Die Spiegel S3, S4, SK1 und SK2 umfassen Öffnungen. Die Spiegel S1, S2, S5 und S6 umfassen keine Öffnungen. Das erste Teilobjektiv 100 umfasst die Spiegel S1, S2, S5 und S6. Das erste Teilobjektiv bildet ein Zwischenbild Z1 in der Nähe des Spiegels S5 aus. Das zweite Teilobjektiv 200 umfasst die Spiegel SK1, SK2 und das dritte Teilobjektiv die Spiegel S3 und S4. Das dritte Teilobjektiv 300 bildet ein Zwischenbild Z2 aus. Das System hat drei Pupillenebenen und zwei Zwischenbilder. Wenigstens eine der Pupillenebenen ist zugänglich zur Anordnung einer Apterurblende.

Die optischen Daten sind aus nachfolgender Tabelle 4 entnehmbar.

Dabei bezeichnet

| | |
|---|---|
| Mirror 1: | den Spiegel S1 |
| Mirror 2: | den Spiegel S2 |
| Mirror 3: | den Spiegel S5 |
| Mirror 4: | den Spiegel S6 |
| Mirror 5: | den Spiegel S3 |
| Mirror 6: | den Spiegel S4 |
| Mirror 7: | den primären Konkavspiegel SK1 |
| Mirror 8: | den sekundären Konkavspiegel SK2 |

Der erste Teil von Tabelle 4 gibt die optischen Daten wieder und der zweite Teil von Tabelle 4 die asphärischen Konstanten der jeweiligen Spiegelflächen.

Tabelle 4

| Surface | Radius | Thickness | Mode |
|---|---|---|---|
| Object | INFINITY | 541.176 | |
| Mirror 1 | 1654.286 | -438.932 | REFL |
| Mirror 2 | 662.227 | 486.164 | REFL |
| Mirror 3 | 124.521 | -234.334 | REFL |
| Mirror 4 | 296.656 | 684.148 | REFL |
| STOP | INFINITY | 0.000 | |
| Mirror 5 | 1078.372 | -388.948 | REFL |
| Mirror 6 | 513.362 | 789.957 | REFL |
| Mirror 7 | -788.995 | -300.590 | REFL |
| Mirror 8 | 680.459 | 369.601 | REFL |
| Image | INFINITY | 0.000 | |

| Surface | K | A | B |
|---|---|---|---|
| Mirror 1 | 0.00000E+00 | -2.36631 E-10 | -8.55660E-16 |
| Mirror 2 | 0.00000E+00 | -5.67713E-12 | -1.95884E-17 |
| Mirror 3 | 0.00000E+00 | 1.11517E-07 | 1.37540E-11 |
| Mirror 4 | 0.00000E+00 | 1.49061E-09 | 3.64316E-14 |
| Mirror 5 | 0.00000E+00 | -3.81551 E-09 | -9.20087E-14 |

(fortgesetzt)

| Surface | K | A | B |
|---|---|---|---|
| Mirror 6 | 0.00000E+00 | 1.71591 E-10 | 5.38871 E-16 |
| Mirror 7 | 0.00000E+00 | 5.11749E-10 | 1.71998E-15 |
| Mirror 8 | 0.00000E+00 | -5.78016E-10 | 1.45805E-15 |

| Surface | C | D | E |
|---|---|---|---|
| Mirror 1 | -2.47185E-21 | 7.32017E-26 | 0.00000E+00 |
| Mirror 2 | -5.87523E-23 | -3.53329E-28 | 0.00000E+00 |
| Mirror 3 | 1.28574E-15 | 7.20115E-19 | 0.00000E+00 |
| Mirror 4 | 7.29870E-19 | 1.30379E-23 | 6.71117E-28 |
| Mirror 5 | -1.57361 E-18 | -5.49020E-23 | 1.99214E-27 |
| Mirror 6 | 1.53854E-21 | 4.80288E-27 | 1.35503E-32 |
| Mirror 7 | 9.34714E-21 | 1.84180E-26 | -2.13432E-32 |
| Mirror 8 | 7.06565E-21 | -1.76539E-26 | 4.32302E-32 |

Sowohl bei dem in Figur 3 wie bei dem in Figur 4 gezeigten Ausführungsbeispiel ist wie bei dem in Figur 2 gezeigten Ausführungsbeispiel die Aperturblende B auf dem Spiegel S3 in der Transfergruppe angeordnet. Die Größe des Feldes beträgt beim Ausführungsbeispiel gemäß Figur 4 $18 \cdot 1$ mm$^2$. Die Form ist die eines Ringfeldes mit $D_x$=18 mm, $D_y$=1 mm und $D_r$=10,5 mm.

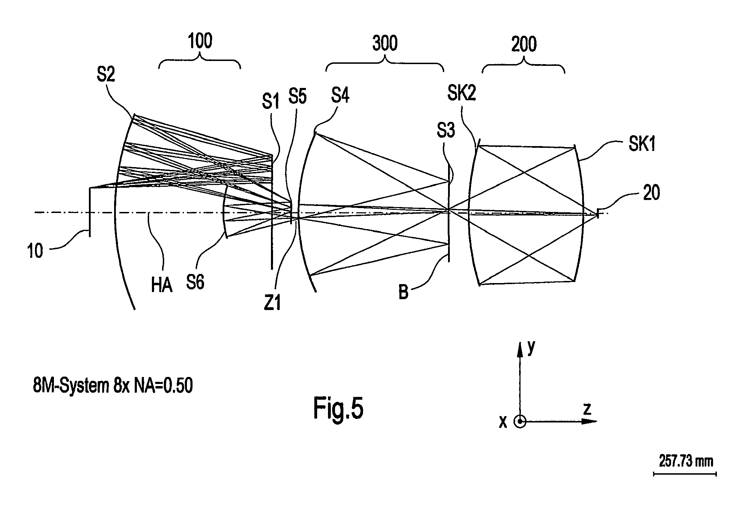

In Figur 5 ist ein weiteres Ausführungsbeispiel eines 8-Spiegel-Projektionsobjektivs gezeigt, mit einer numerischen Apertur NA=0,5 und 8-facher, d.h. 8x Verkleinerung bei einer Wellenlänge von 13,5 nm. Die Feldgröße beim System gemäß Fig. 5 ist 13 x 1 mm$^2$ in der Bildebene, wobei $D_x$=13 mm, $D_y$=1 mm und $D_r$=10,5 mm ist. Die Auflösung des Systems beträgt 17 nm, die Baulänge 2000 mm. Der bildseitige $W_{RMS}$ beträgt 0,033 $\lambda$ und die bildseitige Feldkrümmung 7nm.

Der bildseitige freie Arbeitsabstand beträgt 61 mm und der objektseitige freie Arbeitsabstand 100 mm. Der maximale Einfallswinkel $\Theta_{CR(max)}$ auf einen Spiegel S1, S2, S3, S4, S5, S6, SK1 und SK2 des Hauptstrahles zum zentralen Feldpunkt beträgt 15,9°. Der maximale Einfallswinkel $\Theta_{max(max)}$ eines jeden Strahls auf die Spiegel S1, S2, S3, S4, S5, S6, SK1 und SK2 beträgt 17,9°. Der maximale Bereich $\Delta\Theta_{max}$ der Einfallswinkel auf jeden Spiegel S1, S2, S3, S4, S5, S6, SK1 und SK2 beträgt 10,6°. Die Größe des größten Spiegels im Meridionalschnitt, d. h. in der Meridionalebene beträgt 574 mm und die Größe des größten Spiegels in x-Richtung 602 mm.

Bei dem in Figur 5 gezeigten System ist das erste Teilobjektiv 100 die sog. Feldgruppe, umfassend die Spiegel S1, S2, S5 und S6 im wesentlichen gleich aufgebaut, wie bei den Ausführungsbeispielen gemäß Figur 2, 3 und 4. Die Spiegel S1, S2, S5 und S6 weisen nachfolgende Spiegelabfolge auf: konvex - konkav - konvex - konkav, d. h. der erste Spiegel S1 im Lichtweg von der Objektebene zur Bildebene besitzt eine konvexe Spiegeloberfläche, der zweite Spiegel im Lichtweg von der Bildebene zur Objektebene - der Spiegel S2 - besitzt eine konkave Spiegeloberfläche, der dritte Spiegel im Lichtweg von der Objektebene 10 zur Bildebene 20 - der Spiegel S5 - besitzt eine konvexe Spiegeloberfläche und der vierte Spiegel im Lichtweg von der Objekteben 10 zur Bildebene 20 - der Spiegel S6 - besitzt eine konkave Spiegeloberfläche. Im Gegensatz zu dem Strahlengang innerhalb des ersten Teilobjektives 100 des Ausführungsbeispiels in Figur 1 überkreuzt sich der Strahlengang in der Papierebene, d. h. in der Meridionalebene, die durch die y-, z-Richtung aufgespannt wird, bei den Ausführungsbeispielen 2, 3, 4 und 5 im ersten Teilobjektiv 100. Wie schon bei den Ausführungsbeispielen 2, 3, 4 und 5 befindet sich die Aperturblende auf dem für den Lichtweg von der Objektebene 10 zur Bildebene 20 auf einem Spiegel der Transfergruppe, d. h. im dritten Teilobjektiv 300 nämlich dem fünften Spiegel - dem Spiegel S3.

Das zweite Teilobjektiv 200 umfasst die Spiegel SK1 und SK2 und das dritte Teilobjektiv, die sog. Transfergruppe, die Spiegel S3 und S4. Die Spiegel S3, S4, SK1 und SK2 umfassen Öffnungen, und die Spiegel S1, S2, S5 und S6 umfassen keine Öffnungen.

Bei sämtlichen Ausführungsbeispielen, die in den Figuren 2, 3, 4 und 5 gezeigt sind, ist der Radius des ersten Spiegels im Lichtweg von der Objektebene zur Bildebene, d. h. der Radius des Spiegels S1 sehr groß, bspw. beim Ausführungsbeispiel gemäß Figur 5 größer als 10 m. Der erste Spiegel S1 ist somit nahezu plan ausgebildet und könnte nicht nur konvex ausgebildet sein, in alternativen Ausführungsformen auch einen planen Oberfläche oder eine konkave Oberfläche besitzen.

Der resultierende Obskurationsradius, der eine feldunabhängige Obskuration zur Verfügung stellt, beträgt 21 % des Aperturradius.

Die optischen Daten des in Figur 5 gezeigten Systems sind Tabelle 5 angegeben.

Dabei bezeichnet

| | |
|---|---|
| Mirror 1: | den Spiegel S1 |
| Mirror 2: | den Spiegel S2 |
| Mirror 3: | den Spiegel S5 |
| Mirror 4: | den Spiegel S6 |
| Mirror 5: | den Spiegel S3 |
| Mirror 6: | den Spiegel S4 |
| Mirror 7: | den primären Konkavspiegel SK1 |
| Mirror 8: | den sekundären Konkavspiegel SK2 |

Der erste Teil von Tabelle 5 gibt die optischen Daten wieder und der zweite Teil von Tabelle 5 die asphärischen Konstanten der jeweiligen Spiegelflächen.

Tabelle 5

| Surface | Radius | Thickness | Mode |
|---|---|---|---|
| Object | INFINITY | 718.810 | |
| Mirror 1 | 15385.939 | -618.810 | REFL |
| Mirror 2 | 1044.688 | 695.118 | REFL |
| Mirror 3 | 147.529 | -266.967 | REFL |
| Mirror 4 | 330.139 | 870.985 | REFL |
| STOP | INFINITY | 0.000 | |
| Mirror 5 | 1943.227 | -572.412 | REFL |
| Mirror 6 | 750.946 | 1111.744 | REFL |
| Mirror 7 | -1056.656 | -459.333 | REFL |
| Mirror 8 | 963.397 | 520.863 | REFL |
| Image | INFINITY | 0.000 | |

| Surface | K | A | B | C |
|---|---|---|---|---|
| Mirror 1 | 0.00000E+00 | 1.03935E-09 | 2.87706E-15 | 2.44500E-21 |
| Mirror 2 | 0.00000E+00 | 1.49306E-10 | 4.00929E-18 | 1.48243E-22 |
| Mirror 3 | 0.00000E+00 | 1.18016E-07 | -3.53495E-12 | -4.55098E-17 |
| Mirror 4 | 0.00000E+00 | -2.54082E-09 | 5.38905E-15 | -4.39113E-19 |
| Mirror 5 | 0.00000E+00 | -4.90575E-10 | -1.53636E-14 | -6.47129E-19 |
| Mirror 6 | 0.00000E+00 | 1.36782E-10 | 1.60457E-16 | -3.92581 E-25 |
| Mirror 7 | 0.00000E+00 | 1.87167E-10 | 7.58028E-16 | 1.89696E-21 |
| Mirror 8 | 0.00000E+00 | -3.76514E-10 | 1.37610E-15 | 1.26961 E-21 |

| Surface | D | E | F | G |
|---|---|---|---|---|
| Mirror 1 | -2.92087E-26 | 1.22174E-30 | -2.07471 E-36 | 0.00000E+00 |
| Mirror 2 | 4.70420E-28 | -1.12401 E-33 | 1.99786E-39 | 0.00000E+00 |
| Mirror 3 | 4.31101 E-19 | -1.46428E-31 | 2.97986E-26 | 0.00000E+00 |
| Mirror 4 | 1.06326E-23 | -1.79423E-28 | -1.59791 E-33 | 0.00000E+00 |
| Mirror 5 | -3.42940E-24 | -1.75351 E-28 | 8.76415E-33 | 0.00000E+00 |
| Mirror 6 | -2.81150E-29 | -4.22172E-33 | 2.23604E-38 | 0.00000E+00 |
| Mirror 7 | 7.95754E-27 | -8.87929E-33 | -5.33665E-40 | 0.00000E+00 |
| Mirror 8 | -6.32171 E-27 | -3.06485E-32 | 1.56764E-37 | 0.00000E+00 |

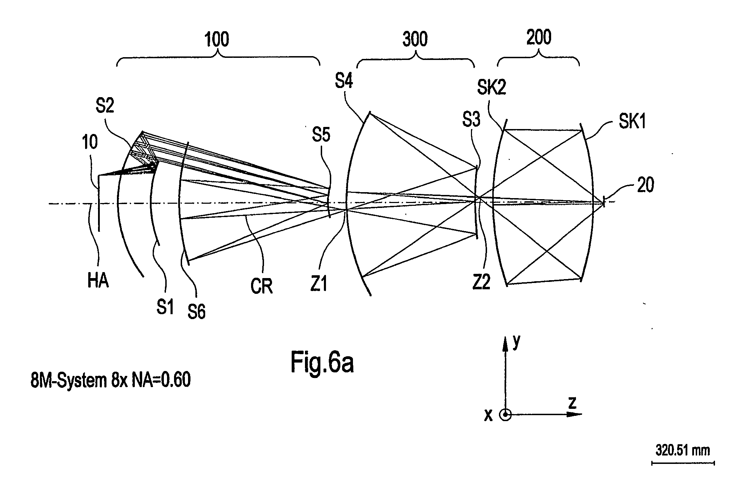

In Figur 6a ist ein weiteres Ausführungsbeispiel eines 8-Spiegel-Systems dargestellt, bei dem das erste Teilobjektiv 100, d. h. die Feldgruppe dieselbe Spiegelabfolge wie die vorigen Ausführungsbeispiele aufweist, jedoch ergeben sich auch Unterschiede. So ist. wie bei den Ausführungsbeispielen gemäß Figuren 2 bis 5, die Spiegelabfolge der vier

**EP 1 828 829 B1**

Spiegel S1, S2, S5 und S6 des ersten Teilobjektives 100 konvex - konkav - konvex - konkav. Im Gegensatz zum 8-Spiegel-System gemäß den vorgenannten Figuren 2 bis 5, überkreuzt sich der Strahlengang im ersten Teilobjektiv 100 jedoch nicht. Aufgrund der unterschiedlichen Strahlführung im ersten Teilobjektiv 100 kann der erste Spiegel S1 im gezeigten Ausführungsbeispiel gemäß Figur 6a nicht alternativ plan bzw. konkav ausgebildet werden. Die bildseitige Apertur des Systems gemäß Figur 6a beträgt NA=0,6 und der Abbildungsfaktor 8x, sowie die Betriebswellenlänge 13,5 nm.

Die Auflösung des Systems beträgt 14 nm, die Baulänge 2500 mm. Die bildseitige $W_{RMS}$ beträgt 0,017 λ. Die bildseitige Feldkrümmung 1 nm. Der resultierende Obskurationsradius, der eine feldunabhängige Obskurations zur Verfügung stellt, beträgt 22 % des Aperturradius. Der bildseitige freie Arbeitsabstand beträgt 55 mm, der objektseitige freie Arbeitsabstand 100 mm. Der maximale Einfallswinkel $\Theta_{CR(max)}$ auf die Spiegel S1, S2, S3, S4, S5, S6, SK1 und SK2 des Hauptstrahls zum zentralen Feldpunkt beträgt 28,3°. Der maximale Einfallswinkel $\Theta_{max(max)}$ eines jeden Strahles auf die Spiegel S1, S2, S3, S4, S5, S6, SK1 und SK2 beträgt 36,6°. Der maximale Winkelbereich $\Delta\Theta_{max}$ der einfallenden Strahlen auf jeden Spiegel S1, S2, S3, S4, S5, S6, SK1 und SK2 beträgt 16,6°. Die Größe des größten Spiegels im meridonalen Schnitt beträgt 778 mm. Die Größe des größten Spiegels in x-Richtung beträgt 806 mm.

Die Größe des Bildfeldes beträgt 13 x 1 mm$^2$ in der Bildebene, wobei $D_x$=13mm, $D_y$=1mm und $D_r$=15 mm ist.

Das System umfasst drei Teilobjektive, ein erstes Teilobjektiv 100, ein zweites Teilobjektiv 300 und ein drittes Teilobjektiv 200. Das erste Teilobjektiv 100 umfasst die Spiegel S1, S2, S5 und S6 und bildet ein Zwischenbild Z1 nahe dem Spiegel S4 aus. Das zweite Teilobjektiv umfasst die Spiegel SK1 und SK2 und das dritte Teilobjektiv umfasst die Spiegel S3, S4 und bildet ein Zwischenbild Z2 aus. Die Spiegel S3, S4, SK1 und SK2 umfassen Öffnungen, die Spiegel S1, S2, S5 und S6 umfassen keine Öffnungen. Die Spiegelabfolge im Lichtweg von der Objektebene 10 zur Bildebene 20 ist wie folgt:

konvex - konkav - konvex - konkav - konvex - konkav - konkav - konkav.

In dem in Figur 6a gezeigten System werden drei Pupillenebenen ausgebildet und zwei Zwischenbilder, wobei wenigstens eine Pupillenebene zur Anordnung einer Aperturblende zugänglich ist.

Die optischen Daten des Systems gemäß Figur 6a sind aus Tabelle 6a zu entnehmen:

Dabei bezeichnet

Mirror 1:    den Spiegel S1
Mirror 2:    den Spiegel S2
Mirror 3:    den Spiegel S5
Mirror 4:    den Spiegel S6
Mirror 5:    den Spiegel S3
Mirror 6:    den Spiegel S4
Mirror 7:    den primären Konkavspiegel SK1
Mirror 8:    den sekundären Konkavspiegel SK2

Der erste Teil von Tabelle 6a gibt die optischen Daten wieder und der zweite Teil von Tabelle 6a die asphärischen Konstanten der jeweiligen Spiegelflächen.

Tabelle 6a

| Surface | Radius | Thickness | Mode |
|---------|--------|-----------|------|
| Object | INFINITY | 257.565 | |
| Mirror 1 | 384.091 | -157.565 | REFL |
| Mirror 2 | 503.282 | 1033.640 | REFL |
| Mirror 3 | 319.62 | -732.625 | REFL |
| Mirror 4 | 847.883 | 1465.334 | REFL |
| STOP | INFINITY | 0.000 | |
| Mirror 5 | 2114.302 | -643.385 | REFL |
| Mirror 6 | 842.763 | 1221.637 | REFL |
| Mirror 7 | -1165.231 | -498.252 | REFL |
| Mirror 8 | 1000.806 | 553.650 | REFL |
| Image | INFINITY | 0.000 | |

27

(fortgesetzt)

| Surface | Radius | Thickness | Mode | |
|---|---|---|---|---|
| | | | | |
| Surface | K | A | B | C |
| Mirror 1 | 0.00000E+00 | -1.77573E-09 | 3.48952E-15 | -6.57559E-19 |
| Mirror 2 | 0.00000E+00 | -1.90688E-10 | -1.12202E-16 | -8.55933E-21 |
| Mirror 3 | 0.00000E+00 | 8.18543E-09 | 1.94772E-13 | -1.20733E-17 |
| Mirror 4 | 0.00000E+00 | -6.32144E-11 | -3.16379E-17 | -1.24533E-22 |
| Mirror 5 | 0.00000E+00 | 5.20532E-10 | -3.03678E-15 | 5.56242E-21 |
| Mirror 6 | 0.00000E+00 | 8.24359E-11 | 1.21698E-16 | 1.72019E-22 |
| Mirror 7 | 0.00000E+00 | 1.04209E-10 | 5.94759E-17 | 3.29996E-22 |
| Mirror 8 | 0.00000E+00 | -2.52357E-10 | 8.47992E-17 | 5.92488E-22 |
| Surface | D | E | F | G |
| Mirror 1 | 2.03449E-23 | -3.58406E-28 | 2.56981 E-33 | 0.00000E+00 |
| Mirror 2 | 4.01912E-26 | -1.85143E-31 | 0.00000E+00 | 0.00000E+00 |
| Mirror 3 | 5.33524E-21 | -1.38304E-24 | 1.60705E-28 | 0.00000E+00 |
| Mirror 4 | 2.11929E-28 | -1.37968E-33 | 4.50488E-39 | 0.00000E+00 |
| Mirror 5 | -2.48900E-25 | 4.49855E-30 | -1.02965E-34 | 0.00000E+00 |
| Mirror 6 | 2.88661 E-28 | 2.26755E-34 | 1.46632E-39 | 0.00000E+00 |
| Mirror 7 | -9.32494E-29 | 7.01284E-34 | 1.83576E-39 | 0.00000E+00 |
| Mirror 8 | -1.30631 E-27 | 1.75865E-33 | 6.32541 E-40 | 0.00000E+00 |

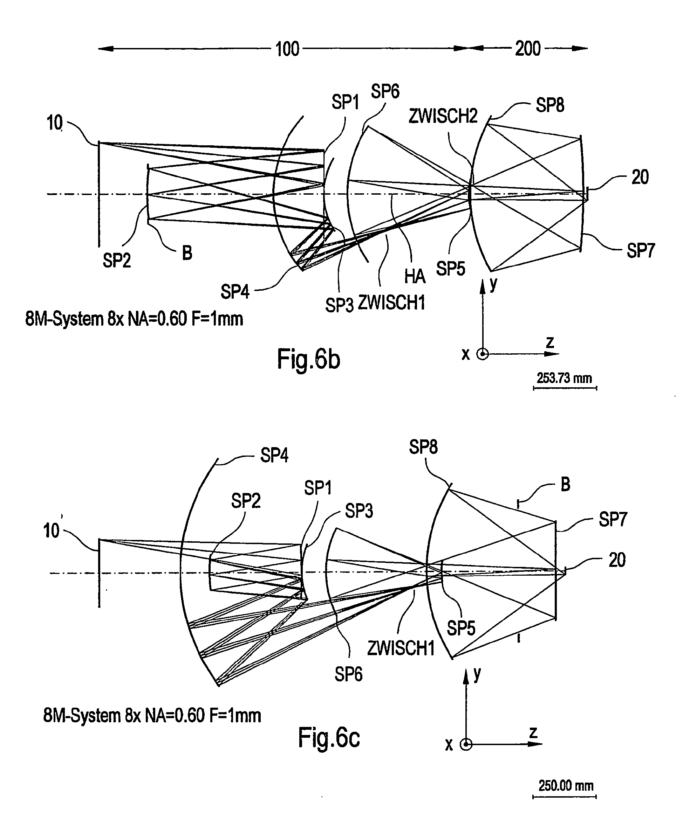

In Figur 6b ist ein weiteres Ausführungsbeispiel eines 8-Spiegel-Systems mit einer numerischen, bildseitigen Apertur von NA=0,6 dargestellt bei einer Wellenlänge von 13,5 nm. Das in Figur 6b dargestellte Objektiv weist im Gegensatz zu dem in Figur 6a gezeigten Objektiv keine Transfergruppe auf, sondern nur eine Feldgruppe, d.h. ein erstes Teilobjektiv 100 und ein zweites Teilobjektiv 200, das auch als Relaygruppe bezeichnet wird. Die Relaygruppe umfasst zwei Konkavspiegel SK1 und SK2. Die Feldgruppe umfasst die Spiegel SP1, SP2, SP3, SP4, SP5 und SP6. Durch den Wegfall der Transfergruppe wird gegenüber den nachfolgend beschriebenen 10-Spiegel-Systemen mit einer 6-spiegligen Feldgruppe, einer 2-spiegligen Transfergruppe und einer 2-spiegligen Relaygruppe die Transmission des Objektives erhöht und der Herstellaufwand verringert. Die Spiegelabfolge der sechs Spiegel der Feldgruppe SP1, SP2, SP3, SP4, SP5 und SP6 des ersten Teilobjektives 100 ist konkav-konkav-konvex-konkav-konvex-konkav. Sämtliche Spiegel SP1, SP2, SP3, SP4, SP5 und SP6 der Feldgruppe sind off-axis Spiegelsegmente. Keiner der Spiegel weist eine Öffnung für einen Durchtritt eines Strahlbüschels auf. Das in Figur 6b dargestellte System weist zwei Zwischenbilder ZWISCH1 und ZWISCH2 auf. Die Blende B ist im ersten Teilsystem 100 auf oder nahe dem zweiten Spiegel SP2 angeordnet. Sie kann aber auch in diesem System zwischen den beiden Konkavspiegeln der Aperturgruppe gelegt werden, da sich dort eine konjugierte Blendenebene befindet. Der Abbildungsfaktor des Systems in Figur 6b beträgt 8x. Wenigstens eine Dimension des Bildfeldes ist 1 mm, die andere besitzt einen größeren Wert, konkret ist das Bildfeld 13 x 1 mm$^2$ in der Bildebene, wobei $D_x$=13 mm, $D_y$=1 mm und $D_r$= 26,5 mm ist. Die Auflösung beträgt 14 nm, die bildseitige $W_{RMS}$ 0,018 λ, die bildseitige Feldkrümmung 2 nm. Der bildseitige freie Arbeitsabstand beträgt 15 mm und der objektseitige freie Arbeitsabstand 100 mm. Der resultierende Obskurationsradius, der eine feldunabhängige Obskuration zur Verfügung stellt, beträgt 22 % des Aperturradius. Der maximale Einfallswinkel $\Theta_{CR(max)}$ auf die Spiegel SP1 bis SP8 eines Hauptstrahles zu einem zentralen Feldpunkt beträgt 30,1°. Der maximale Einfallswinkel $\Theta_{max(max)}$ eines jeden Strahls auf einen Spiegel SP1 bis SP8 beträgt 31,5°. Der maximale Einfallswinkelbereich $\Delta\Theta_{max}$ der einfallenden Strahlen auf irgendeinen Spiegel SP1 bis SP8 beträgt 29°. Die Größe des größten Spiegels im meridonalen Schnitt beträgt 621 mm und die Größe des größten Spiegels in x-Richtung 668 mm. Die Baulänge des Systems beträgt 2000 mm.

Die optischen Daten des Systems gemäß Figur 6b sind aus Tabelle 6b zu entnehmen: Dabei bezeichnet

|  |  |
|---|---|
| Mirror 1: | den Spiegel SP1 |
| Mirror 2: | den Spiegel SP2 |
| Mirror 3: | den Spiegel SP3 |
| Mirror 4: | den Spiegel SP4 |

(fortgesetzt)

| Mirror 5: | den Spiegel SP5 |
|---|---|
| Mirror 6: | den Spiegel SP6 |
| Mirror 7: | den primären Konkavspiegel SK1 |
| Mirror 8: | den sekundären Konkavspiegel SK2 |

Der erste Teil von Tabelle 6b gibt die optischen Daten wieder und der zweite Teil von Tabelle 6b die asphärischen Konstanten der jeweiligen Spiegelflächen.

Tabelle 6b: Optische Daten für das System gemäß Figur 6b:

| Surface | Radius | Thickness | Mode |
|---|---|---|---|
| Object | INFINITY | 922.791 | |
| Mirror 1 | -3699.835 | -722.791 | REFL |
| STOP | INFINITY | 0.000 | |
| Mirror 2 | 1396.642 | 722.791 | REFL |
| Mirror 3 | 326.694 | -209.599 | REFL |
| Mirror 4 | 495.849 | 808.165 | REFL |
| Mirror 5 | 268.532 | -498.566 | REFL |
| Mirror 6 | 545.559 | 962.209 | REFL |
| Mirror 7 | -1362.684 | -455.200 | REFL |
| Mirror 8 | 753.748 | 470.200 | REFL |
| Image | INFINITY | 0.000 | |

| Surface | K | A | B | C |
|---|---|---|---|---|
| Mirror 1 | 0.00000E+00 | 4.62106E-10 | -1.60960E-15 | 5.15302E-21 |
| Mirror 2 | 0.00000E+00 | 5.34180E-11 | -1.73246E-15 | 8.91595E-20 |
| Mirror 3 | 0.00000E+00 | -3.78083E-09 | -1.60946E-14 | 1.44926E-18 |
| Mirror 4 | 0.00000E+00 | 1.29725E-10 | -4.33242E-15 | 3.55197E-20 |
| Mirror 5 | 0.00000E+00 | -5.41995E-09 | 5.52456E-13 | 2.52759E-17 |
| Mirror 6 | 0.00000E+00 | -3.73334E-11 | -1.02668E-16 | -2.99968E-22 |
| Mirror 7 | 0.OOOOOE+00 | 7.83478E-10 | 1.90282E-15 | 4.06118E-21 |
| Mirror 8 | 0.00000E+00 | 1.12087E-10 | 2.96721 E-16 | 6.94605E-22 |

| Surface | D | E | F | G |
|---|---|---|---|---|
| Mirror 1 | -4.68484E-26 | 7.39174E-31 | -4.68562E-36 | 0.00000E+00 |
| Mirror 2 | -1.14886E-23 | 5.55335E-28 | -1.14958E-32 | 0.00000E+00 |
| Mirror 3 | -6.49583E-23 | 1.53314E-27 | -1.44417E-32 | 0.00000E+00 |
| Mirror 4 | -1.55220E-25 | 2.37719E-32 | 1.28111 E-36 | 0.00000E+00 |
| Mirror 5 | 8.89081 E-22 | 3.94133E-26 | -4.47051E-30 | 0.00000E+00 |
| Mirror 6 | -1.44127E-27 | 2.92660E-33 | -3.35888E-38 | 0.00000E+00 |
| Mirror 7 | 8.72416E-27 | 4.28608E-32 | 2.15963E-37 | 0.00000E+00 |
| Mirror 8 | 1.93827E-27 | -5.92415E-34 | 2.66223E-38 | 0.00000E+00 |

In Figur 6c ist eine Variante des in Figur 6b gezeigten Ausführungsbeispieles gezeigt. Die Spiegelabfolge in der Feldgruppe mit den Spiegel SP1, SP2, SP3, SP4, SP5 und SP6 ist gleich wie beim Ausführungsbeispiel in Figur 6b, nämlich konkav - konkav - konvex - konkav - konvex - konkav. Die Aperturgruppe besteht aus zwei Konkavspiegeln SP7 und SP8. Im Gegensatz zur Ausführungsform gemäß Figur 6b liegt die Aperturblende nicht auf den Spiegel SP2 sondern zwischen den Konkavspiegeln SP7 und SP8 der Aperturgruppe. Der Spiegel mit dem kleinsten axialen Abstand entlang der Hauptachse HA des Objektives zur Objektebene 10 ist nicht der zweite Spiegel SP2 der Feldgruppe sondern der vierte Spiegel SP4 der Feldgruppe. Hierdurch wird eine besonders lange Driftstrecke zwischen dem vierten Spiegel SP4 und dem fünften Spiegel SP5 zur Verfügung gestellt, was sehr kleine Einfallswinkel auf den Spiegeln SP4 und SP5 zur Folge hat. Der maximale Winkel des Hauptstrahles zum zentralen Feldpunkt tritt auf dem dritten Spiegel SP3 auf und beträgt lediglich 21°.

Die Größe des Bildfeldes beträgt 13 x 1 mm$^2$ in der Bildebene, wobei $D_x$=13 mm, $D_y$=1 mm, $D_r$= 16,25 mm ist. Die Auflösung des Systems beträgt 14 nm. Die Verkleinerung des Systems 8x, und die Baulänge 1846 mm. Der bildseitige $W_{RMS}$ beträgt 0,015 λ und die bildseitige Feldkrümmung 1 nm. Der resultierende Obskurationsradius, der eine feldunabhängige Obskuration zur Verfügung stellt, beträgt 29° des Aperturradius. Der bildseitige freie Arbeitsabstand beträgt 40 mm und der objektseitige freie Arbeitsabstand 322 mm. Der maximale Winkel $\Theta_{CR(max)}$ des Hauptstrahls zum zentralen Feldpunkt auf irgendeinen Spiegel SP1 bis SP8 beträgt 21°. Der maximale Winkel $\Theta_{max(max)}$ irgendeines Strahls auf irgendeinen Spiegel SP1 bis SP8 beträgt 25,2°. Der maximale Winkelbereich $\Delta\Theta_{max}$ auf irgendeinen Spiegel SP1 bis SP8 beträgt 24,9°. Die Größe des größten Spiegels im Meridionalschnitt beträgt 682 mm und die Größe des größten Spiegels in x-Richtung 694 mm. Das Objektiv umfasst wiederum zwei Teilobjektive, ein erstes Teilobjektiv umfassend die Spiegel SP1, SP2, SP3, SP4, SP5 und SP6 sowie ein zweites Teilobjektiv umfassend die Spiegel SP7 und SP8.

Die optischen Daten des Systems gemäß Figur 6c sind aus Tabelle 6c zu entnehmen:
Dabei bezeichnet

| | |
|---|---|
| Mirror 1: | den Spiegel SP1 |
| Mirror 2: | den Spiegel SP2 |
| Mirror 3: | den Spiegel SP3 |
| Mirror 4: | den Spiegel SP4 |
| Mirror 5: | den Spiegel SP5 |
| Mirror 6: | den Spiegel SP6 |
| Mirror 7: | den primären Konkavspiegel SK1 |
| Mirror 8: | den sekundären Konkavspiegel SK2 |

Der erste Teil von Tabelle 6c gibt die optischen Daten wieder und der zweite Teil von Tabelle 6c die asphärischen Konstanten der jeweiligen Spiegelflächen.

Tabelle 6c: Optische Daten für das System gemäß Figur 6c:

| Surface | Radius | Thickness | Mode |
|---|---|---|---|
| Object | INFINITY | 798.296 | |
| Mirror 1 | -1827.312 | -361.283 | REFL |
| Mirror 2 | 2771.147 | 361.283 | REFL |
| Mirror 3 | 316.676 | -476.449 | REFL |
| Mirror 4 | 775.124 | 1039.440 | REFL |
| Mirror 5 | 372.661 | -462.991 | REFL |
| Mirror 6 | 471.732 | 908.105 | REFL |
| Mirror 7 | -8480.523 | -146.460 | REFL |
| STOP | INFINITY | -357.622 | |
| Mirror 8 | 715.42 | 544.082 | REFL |
| Image | INFINITY | 0.000 | |

| Surface | K | A | B | C |
|---|---|---|---|---|
| Mirror 1 | 0.00000E+00 | -1.45626E-09 | 6.40290E-16 | 2.94780E-20 |
| Mirror 2 | 0.00000E+00 | 9.31344E-09 | 1.78433E-13 | 6.07073E-18 |
| Mirror 3 | 0.00000E+00 | 1.20767E-09 | 4.63422E-14 | 1.06360E-18 |
| Mirror 4 | 0.00000E+00 | -3.94048E-12 | -4.34341E-18 | -2.29083E-24 |
| Mirror 5 | 0.00000E+00 | 7.23867E-08 | 4.59128E-12 | 4.03493E-16 |
| Mirror 6 | 0.00000E+00 | 4.58357E-10 | 4.09942E-15 | 3.25541E-20 |
| Mirror 7 | 0.00000E+00 | 7.13645E-10 | -4.17082E-15 | 1.96723E-20 |
| Mirror 8 | 0.00000E+00 | -2.07223E-11 | -3.53129E-17 | -8.11682E-23 |

(fortgesetzt)

| Surface | D | E | F | G |
|---|---|---|---|---|
| Mirror 1 | 3.73960E-25 | -1.56367E-30 | 0.00000E+00 | 0.00000E+00 |
| Mirror 2 | -1.28696E-21 | 1.16367E-25 | -4.40517E-30 | 0.00000E+00 |
| Mirror 3 | 1.78247E-23 | 4.71695E-28 | 1.30944E-32 | 0.00000E+00 |
| Mirror 4 | -6.39796E-30 | 1.00689E-35 | 0.00000E+00 | 0.00000E+00 |
| Mirror 5 | 4.83186E-20 | -2.96561 E-32 | 1.74256E-27 | 0.00000E+00 |
| Mirror 6 | 2.52331 E-25 | 2 36217E-30 | 1 50441E-35 | 0.00000E+00 |

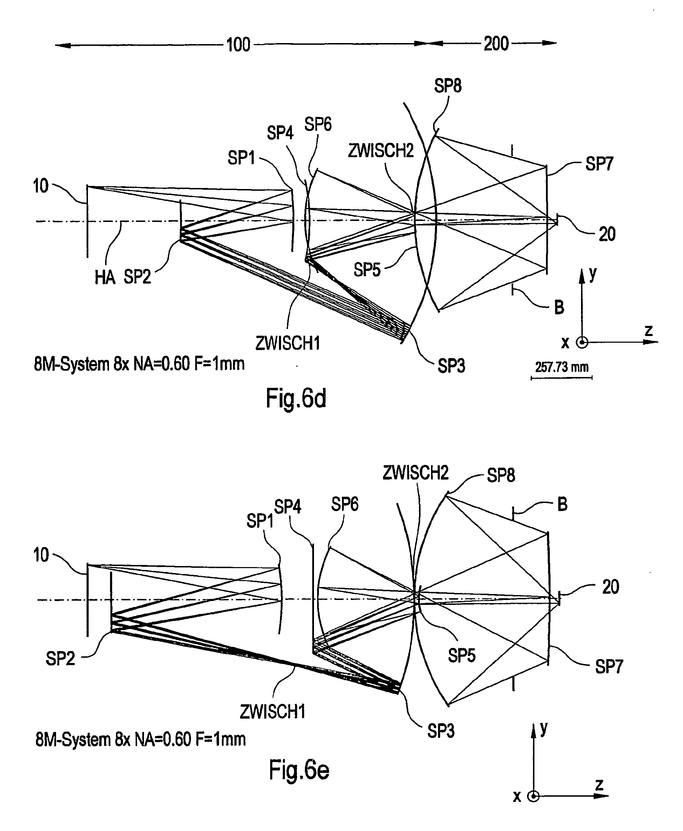

In Figur 6d ist ein weiteres Ausführungsbeispiel eines 8-Spiegel-Systems mit einer numerischen, bildseitigen Apertur von NA=0,6 dargestellt. Das in Figur 6d dargestellte Objektiv weist wie die Ausführungsform zu Figur 6b im Gegensatz zu dem in Figur 6a gezeigten Objektiv keine Transfergruppe auf, sondern nur eine Feldgruppe, d.h. ein erstes Teilobjektiv 100 und ein zweites Teilobjektiv 200, das auch als Relaygruppe bezeichnet wird. Die Relaygruppe, d. h. das zweite Teilobjektiv 200 umfasst zwei Konkavspiegel SK1 und SK2. Die Feldgruppe, d. h. das Teilobjektiv 100 umfasst die Spiegel SP1, SP2, SP3, SP4, SP5 und SP6, die als off-axis Segmente ausgebildet sind. Die Spiegelabfolge der sechs Spiegel der Feldgruppe SP1, SP2, SP3, SP4, SP5 und SP6 des ersten Teilobjektives 100 ist konkav-konvex-konkav-konvex-konvex-konkav. Das in Figur 6d gezeigte System umfasst zwei Zwischenbilder ZWISCH1 und ZWISCH2. Im Gegensatz zu dem in Figur 6b gezeigten System ist die Blende B zwischen dem ersten Konkavspiegel SK1 und dem zweiten Konkavspiegel SK2 des zweiten Teilobjektives 200 angeordnet. Die Aperturblende kann in einem solchen System aber auch zwischen dem ersten und dem zweiten Spiegel oder direkt auf dem ersten oder direkt auf dem zweiten Spiegel gelegt werden. Die bildseitige Apertur des Systems gemäß Figur 6d beträgt NA=0,6 und der Abbildungsfaktor 8x bei einer Wellenlänge von $\lambda$=13,4 nm. Die Größe des Bildfeldes beträgt 13 x 1 mm$^2$ in der Bildebene, wobei $D_x$=13mm, $D_y$=1 mm, $D_r$=18,75 mm ist. Die Auflösung beträgt 14 nm und die Länge des Systems, d. h. die Baulänge 2000 mm. Die bildseitige $W_{RMS}$ beträgt 0,025 $\lambda$ und die bildseitige Feldkrümmung, d. h. die Bildfeldkrümmung 5 nm. Die resultierende Obskurationsradius, der eine feldunabhängige Obskuration zu Verfügung stellt, beträgt 26 % des Aperturradius. Der bildseitige freie Arbeitsabstand beträgt 41 mm. Der objektseitige Arbeitsabstand beträgt 402 mm. Der maximale Einfallswinkel $\Theta_{CR(max)}$ auf einem Spiegel SP1 bis SP8 eines Haupstrahles eines zentralen Feldpunktes beträgt 26,1°. Der maximale Einfallswinkel $\Theta_{max(max)}$ irgendeines Strahls auf die Spiegel SP1 bis SP8 beträgt 29,8°. Der maximale Einfallswinkelbereich $\Delta\Theta_{max}$ auf irgendeinen, Spiegel SP1 bis SP8 beträgt 21°.Die Größe des größten Spiegels im Meridionalschnitt beträgt 753 mm und die Größe des größten Spiegels in x-Richtung 765 mm.

Die optischen Daten des Systems gemäß Figur 6d sind aus Tabelle 6d zu entnehmen:
Dabei bezeichnet

|  |  |
|---|---|
| Mirror 1: | den Spiegel SP1 |
| Mirror 2: | den Spiegel SP2 |
| Mirror 3: | den Spiegel SP3 |
| Mirror 4: | den Spiegel SP4 |
| Mirror 5: | den Spiegel SP5 |
| Mirror 6: | den Spiegel SP6 |
| Mirror 7: | den primären Konkavspiegel SK1 |
| Mirror 8: | den sekundären Konkavspiegel SK2 |

Der erste Teil von Tabelle 6d gibt die optischen Daten wieder und der zweite Teil von Tabelle 6d die asphärischen Konstanten der jeweiligen Spiegelflächen.

Tabelle 6d: Optische Daten für das System gemäß Figur 6d:

| Surface | Radius | Thickness | Mode |
|---|---|---|---|
| Object | INFINITY | 880.361 |  |
| Mirror 1 | -875.368 | -478.259 | REFL |
| Mirror 2 | -690.520 | 1092.679 | REFL |
| Mirror 3 | -977.378 | -551.779 | REFL |
| Mirror 4 | -833.448 | 458.600 | REFL |
| Mirror 5 | 358.753 | -471.240 | REFL |

(fortgesetzt)

| Surface | Radius | Thickness | Mode |
|---------|--------|-----------|------|
| Mirror 6 | 523.860 | 1028.166 | REFL |
| Mirror 7 | -5262.591 | -149.862 | REFL |
| STOP | INFINITY | -407.152 | |
| Mirror 8 | 814.485 | 598.487 | REFL |
| Image | INFINITY | 0.000 | |

| Surface | K | A | B | C |
|---------|---|---|---|---|
| Mirror 1 | 0 .00000E+00 | -9.68983E-11 | 1.30663E-15 | -4.94071 E-20 |
| Mirror 2 | 0.00000E+00 | 2.94527E-09 | 9.63566E-14 | -4.32741 E-18 |
| Mirror 3 | 0.00000E+00 | -1.03936E-10 | 5.36156E-16 | -1.65908E-21 |
| Mirror 4 | 0.00000E+00 | 1.24373E-09 | 2.24555E-14 | -3.21919E-18 |
| Mirror 5 | 0.00000E+00 | 4.32193E-08 | 1.67170E-12 | 9.36696E-17 |
| Mirror 6 | 0.00000E+00 | 6.52219E-12 | -3.83205E-16 | -1.68489E-21 |
| Mirror 7 | 0.00000E+00 | 4.88652E-10 | 1.07810E-15 | 2.49482E-21 |
| Mirror 8 | 0.00000E+00 | 1.69034E-11 | 8.05549E-17 | 1.52452E-22 |

| Surface | D | E | F | G |
|---------|---|---|---|---|
| Mirror 1 | -3.11075E-25 | 7.43387E-30 | -1.22653E-34 | 0.00000E+00 |
| Mirror 2 | -1.24960E-22 | 1.48734E-26 | -4.81981 E-31 | 0.00000E+00 |
| Mirror 3 | 3.13335E-27 | -3.65847E-33 | 2.78395E-39 | 0.00000E+00 |
| Mirror 4 | 1.45549E-22 | -2.80273E-27 | 1.97890E-32 | 0.00000E+00 |
| Mirror 5 | 1.12895E-20 | -5.38537E-25 | 2.00528E-28 | 0.00000E+00 |
| Mirror 6 | -4.41623E-27 | 5.82970E-33 | -9.43009E-38 | 0.00000E+00 |
| Mirror 7 | 7.45586E-27 | 1.58318E-33 | 2.42322E-37 | 0.00000E+00 |
| Mirror 8 | 3.07949E-28 | 3.98761 E-35 | 2.18360E-39 | 0.00000E+00 |

In Figur 6e ist eine Variante des in Figur 6d gezeigten Ausführungsbeispiels dargestellt. Das Ausführungsbeispiel gemäß Figur 6e besitzt eine ähnliche Spiegelfolge in der Feldgruppe, d. h. dem ersten Teilobjektiv mit den Spiegeln SP1, SP2, SP3, SP4, SP5 und SP6 wie das Ausführungsbeispiel gemäß Figur 6d, nämlich konkav-konkav-konkav-konvex-konvex-konkav, wobei der Radius des Spiegels 2 (Mirror 2) so groß ist, dass dieser Spiegel auch plan oder konvex ausgelegt werden kann. Im Gegensatz zum Ausführungsbeispiel gemäß Figur 6d beträgt die bildseitige Apertur NA=0,70 bei einer Wellenlänge $\lambda$=13,5nm. Das Zwischenbild ZWISCH1 liegt innerhalb der Feldgruppe zwischen dem Spiegel SP2 und SP3 und physikalisch am unteren Rand des Spiegels SP4. Durch diese Ausgestaltung kann der Strahlbündelquerschnitt am Spiegel SP4 sehr klein gehalten werden und die Feldgruppe weist eine besonders kompakte Bauweise auf. Des Weiteren zeichnet sich die Ausführungsform durch sehr niedrige Einfallswinkel des Hauptstrahles zum zentralen Feldpunkt aus. Der größte Einfallswinkel des Hauptstrahls zum zentralen Feldpunkt tritt auf dem Spiegel SP4 auf und beträgt lediglich 24°. Die Baulänge des Objektives beträgt 1974 mm.

Die Größe des Bildfeldes beträgt 13 x 1 mm$^2$ in der Bildebene, wobei $D_x$=13 mm, $D_y$=1 mm, $D_r$=18 mm ist. Die Auflösung beträgt 12 nm und die Baulänge des Systems 1974 mm. Die bildseitige $W_{RMS}$ beträgt 0,021 $\lambda$ und die bildseitige Feldkrümmung 1 nm. Der bildseitige freie Arbeitsabstand beträgt 41 mm und der objektseitige freie Arbeitsabstand 100 mm. Der maximale Einfallswinkel $\Theta_{CR(max)}$ auf einen Spiegel SP1 bis SP8 eines Hauptstrahls zu einem zentralen Feldpunkt beträgt 22,9°. Der maximale Einfallswinkel $\Theta_{max(max)}$ irgendeines Strahls auf einen Spiegel SP1 bis SP8 beträgt 26,7°. Der maximale Einfallswinkelbereich $\Delta\Theta_{max}$ auf irgendeinen Spiegel SP1 bis SP8 beträgt 23,3°. Der resultierende Obskurationsradius, der eine feldunabhängige Obskuration zur Verfügung stellt beträgt 23 % des Aperturradius. Die Größe des größten Spiegels im Meridionalschnitt beträgt 904 mm, die Größe des größten Spiegels in x-Richtung beträgt 916 mm.

Die optischen Daten des Systems gemäß Figur 6e sind aus Tabelle 6e zu entnehmen:
Dabei bezeichnet

<div style="text-align:center">

Mirror 1:  den Spiegel SP1
Mirror 2:  den Spiegel SP2

</div>

(fortgesetzt)

| Mirror 3: | den Spiegel SP3 |
| Mirror 4: | den Spiegel SP4 |
| Mirror 5: | den Spiegel SP5 |
| Mirror 6: | den Spiegel SP6 |
| Mirror 7: | den primären Konkavspiegel SK1 |
| Mirror 8: | den sekundären Konkavspiegel SK2 |

Der erste Teil von Tabelle 6e gibt die optischen Daten wieder und der zweite Teil von Tabelle 6e die asphärischen Konstanten der jeweiligen Spiegelflächen.

Tabelle 6e: Optische Daten für das System gemäß Figur 6e

| Surface | Radius | Thickness | Mode |
|---|---|---|---|
| Object | INFINITY | 810.260 | |
| Mirror 1 | -1005.764 | -710.260 | REFL |
| Mirror 2 | 9426.007 | 1272.991 | REFL |
| Mirror 3 | -1182.815 | -429.596 | REFL |
| Mirror 4 | -11133.428 | 450.166 | REFL |
| Mirror 5 | 186.619 | -433.300 | REFL |
| Mirror 6 | 477.126 | 972.102 | REFL |
| Mirror 7 | -4183.615 | -150.374 | REFL |
| STOP | INFINITY | -408.999 | |
| Mirror 8 | 818.267 | 600.845 | REFL |
| Image | INFINITY | 0.000 | |

| Surface | K | A | B | C |
|---|---|---|---|---|
| Mirror 1 | 0.00000E+00 | 3.11825E-10 | 3.24549E-15 | -6.83571E-20 |
| Mirror 2 | 0.00000E+00 | -2.27912E-09 | -4.60552E-15 | -2.48079E-19 |
| Mirror 3 | 0.00000E+00 | -5.54875E-11 | 1.84013E-16 | -8.66678E-22 |
| Mirror 4 | 0.00000E+00 | -3.87307E-10 | 1.79298E-15 | -3.85784E-20 |
| Mirror 5 | 0.00000E+00 | -5.50749E-10 | -6.08907E-13 | 4.73842E-17 |
| Mirror 6 | 0.00000E+00 | 4.07407E-10 | 2.55564E-15 | 1.36374E-20 |
| Mirror 7 | 0.00000E+00 | 3.47533E-10 | 3.22160E-16 | 1.16439E-21 |
| Mirror 8 | 0.00000E+00 | -1.97225E-11 | 2.09194E-17 | 8.09962E-23 |

| Surface | D | E | F | G |
|---|---|---|---|---|
| Mirror 1 | 1.72371 E-24 | -4.87613E-29 | 5.82893E-34 | 0.00000E+00 |
| Mirror2 | 6.51533E-24 | -1.43666E-28 | 1.04325E-33 | 0.00000E+00 |
| Mirror 3 | 1.11987E-27 | 0.00000E+00 | 0.00000E+00 | 0.00000E+00 |
| Mirror 4 | 3.55401 E-25 | -1.54989E-30 | 0.00000E+00 | 0.00000E+00 |
| Mirror 5 | -1.32381 E-20 | 2.64772E-24 | -2.26591 E-28 | 0.00000E+00 |
| Mirror 6 | 9.58842E-26 | -5.38128E-32 | 7.68501 E-36 | 0.00000E+00 |
| Mirror 7 | 6.85290E-28 | 3.55319E-33 | 2.83137E-38 | 0.00000E+00 |
| Mirror 8 | 9.92467E-29 | 6.06015E-34 | -1.21955E-39 | 3.99272E-45 |

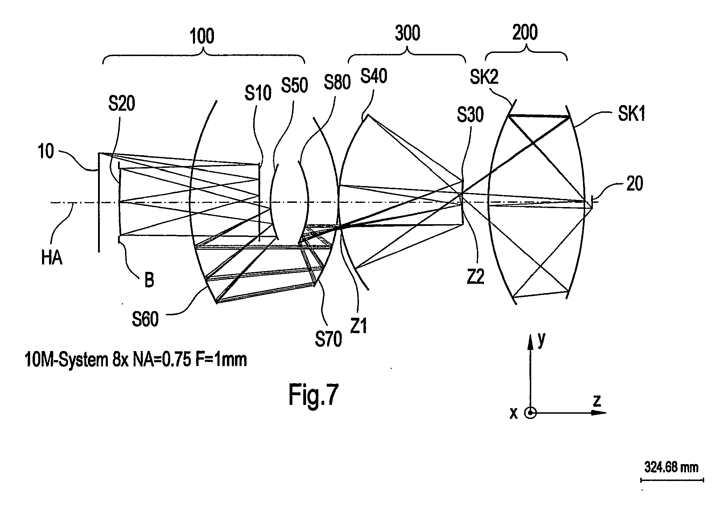

In Figur 7 ist ein erstes Ausführungsbeispiel gezeigt, das ein 10-Spiegel-System mit einer bildseitigen Apertur von NA=0,75 bei einer Wellenlänge λ=13,5 nm sowie einem Abbildungsfaktor von 8x darstellt. Dieses System besitzt zwei Zwischenbilder. Gleiche Bauteile wie in Figur 1 sind mit denselben Bezugsziffern gekennzeichnet.

Hierbei bezeichnet 100 das erste Teilobjektiv, 200 das zweite Teilobjektiv und 300 das dritte Teilobjektiv. Das erste Teilobjektiv 100 umfasst einen Spiegel S10, einen Spiegel S20, einen Spiegel S50, einen Spiegel S60, einen Spiegel S70 und einen Spiegel S80. Der Spiegel S10 ist ein Konvexspiegel mit einem sehr großen Radius von mehr als 10000 mm. Aufgrund dieses großen Radius kann der Spiegel S1 sowohl plan als auch konkav ausgebildet werden. Der im Lichtweg folgende Spiegel S20 ist ein Konkavspiegel, der Spiegel S70 ist ein Konvexspiegel, der Spiegel S80 ist ein Konkavspiegel, der Spiegel S90 ist ein Konkavspiegel und der Spiegel S100 ist ein Konvexspiegel, so dass sich die Spiegelfolge konvex - konkav - konvex - konkav - konkav- konvex ergibt. Alternativ wären auch noch die Spiegelabfolgen konkav - konkav - konvex - konkav - konkav - konvex oder plan - konkav - konvex - konkav - konkav - konvex möglich.

Bei dem in Figur 7 gezeigten Ausführungsbeispiel ist die Aperturblende B auf dem Spiegel S20 angeordnet. Der Abbildungsfaktor des ersten Teilobjektives 100 beträgt 1,85x, der Abbildungsfaktor des dritten Teilobjektives 300 beträgt 3,38x und der Abbildungsfaktor des zweiten Teilobjektives 200 beträgt 1,3. Die Feldgröße des abzubildenden Feldes beträgt bei dem in Figur 7 gezeigten System 26 x 1 mm$^2$ in der Bildebene, wobei $D_x$=26 mm, $D_y$=1 mm und $D_r$=30,75 mm ist. Die Baulänge des Systems ist 2508 mm. Bei dem in Figur 7 dargestellten System ist die Wellenfront auf einen mittleren Wellenfrontfehler $W_{ms}$=0,013 λ korrigiert. Die Auflösung des Systems beträgt ungefähr 11 nm, die bildseitige Feldkrümmung weniger als 1 nm. Der resultierende Obskurationsradius, der eine feldunabhängige Obskuration zur Verfügung stellt, beträgt 55 % des Aperturradius. Der bildseitige freie Arbeitsabstand beträgt 41 mm und der objektseitige freie Arbeitsabstand 100 mm. Der maximale Winkel $\Theta_{CR(max)}$ auf den auf einen Spiegel S10, S20, S30, S40, S50, S60, S70, S80, SK1 und SK2 der Hauptstrahl eines zentralen Feldpunktes auftrifft beträgt 32,9°. Der maximale Einfallswinkel $\Theta_{max(max)}$ irgendeinen Strahles auf einen Spiegel S10, S20, S30, S40, S50, S60, S70, S80, SK1 und SK2 beträgt 45,1 °. Der maximale Einfallswinkelbereich $\Delta\Theta_{max}$ auf irgendeinen Spiegel S10, S20, S30, S40, S50, S60, S70, S80, SK1 und SK2 beträgt 28°. Die Größe des größten Spiegels im Meridionalschnitt beträgt 932 mm und die Größe des größten Spiegels in x-Richtung 1034 mm.

Die Spiegel S30, S40, S70, SK1 und SK2 umfassen Öffnungen. Die Spiegel S10, S20, S50, S60, S80 weisen keine Öffnungen auf. Das erste Teilobjektiv 100 umfasst die Spiegel S10, S20, S50, S60, S70 und S80. Das erste Teilobjektiv bildet das Zwischenbild Z1 in einer Position zwischen dem Spiegel S40 und S70 aus. Das zweite Teilobjektiv umfasst die Spiegel SK1 und SK2 und das dritte Teilobjektiv die Spiegel S30 und S40.

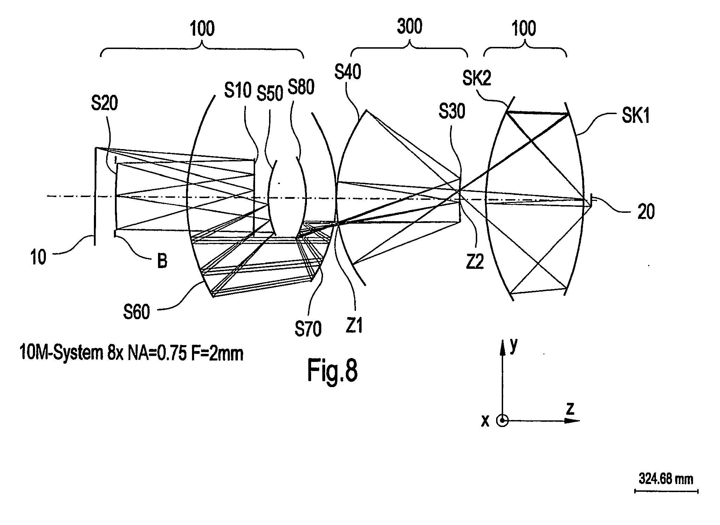

Des Weiteren zeichnet sich das System gemäß Figur 7 und auch Figur 8 dadurch aus, dass es sich um ein pupillenobskuriertes System mit wenigstens einem Spiegel mit einer Öffnung für den Durchtritt eines Strahlbüschels handelt, wobei die Aperturblende B, die vorliegend auf dem zweiten Spiegel S20 angeordnet ist, vor dem Zwischenbild Z2 angeordnet ist. Dadurch, dass die Aperturblende vor dem letzten Zwischenbild (Z2) angeordnet ist, liegt zwischen der Aperturblende B und der Bildebene 20 mindestens ein Zwischenbild.

Die optischen Daten des in Figur 7 gezeigten Systems sind aus Tabelle 7 entnehmbar.

Dabei bezeichnet

| | |
|---|---|
| Mirror 1: | den Spiegel S10 |
| Mirror 2: | den Spiegel S20 |
| Mirror 3: | den Spiegel S50 |
| Mirror 4: | den Spiegel S60 |
| Mirror 5: | den Spiegel S70 |
| Mirror 6: | den Spiegel S80 |
| Mirror 7: | den Spiegel S30 |
| Mirror 8: | den Spiegel S40 |
| Mirror 9: | den primären Konkavspiegel SK1 |
| Mirror 10: | den sekundären Konkavspiegel SK2 |

Im zweiten Teil von Tabelle 7 sind die asphärischen Konstanten der einzelnen Spiegelflächen angegeben.

Tabelle 7

| Surface | Radius | Thickness | Mode |
|---|---|---|---|
| Object | INFINITY | 808.072 | |
| Mirror 1 | 12007.16 | -708.072 | REFL |
| STOP | INFINITY | 0.000 | |
| Mirror 2 | 1319.376 | 769.858 | REFL |
| Mirror 3 | 433.361 | -403.578 | REFL |
| Mirror 4 | 987.208 | 756.549 | REFL |
| Mirror 5 | -693.043 | -152.971 | REFL |

(fortgesetzt)

| Surface | Radius | Thickness | Mode |
|---|---|---|---|
| Mirror 6 | -376.637 | 770.120 | REFL |
| Mirror 7 | 772.539 | -617.149 | REFL |
| Mirror 8 | 734.604 | 1245.295 | REFL |
| Mirror 9 | -1353.169 | -488.680 | REFL |
| Mirror 10 | 976.954 | 528.680 | REFL |
| Image | INFINITY | 0.000 | |

| Surface | K | A | B | C | D |
|---|---|---|---|---|---|
| Mirror 1 | 0.00000E+00 | 9.27937E-10 | -4.60321 E-15 | 1.33022E-20 | -1.46239E-25 |
| Mirror 2 | 0.00000E+00 | -1.48167E-10 | -6.18894E-16 | -1.75227E-21 | -8.39234E-26 |
| Mirror 3 | 0.00000E+00 | -1.73010E-09 | -1.18347E-14 | 9.68679E-20 | -9.07327E-25 |
| Mirror 4 | 0.00000E+00 | -6.37553E-11 | -1.11337E-16 | -1.06013E-22 | 2.52238E-29 |
| Mirror 5 | 0.00000E+00 | 6.33779E-10 | -6.54703E-16 | 3.63365E-21 | -5.36932E-27 |
| Mirror 6 | 0.00000E+00 | 6.43612E-09 | -5.82502E-14 | 1.35839E-18 | -2.25462E-23 |
| Mirror 7 | 0.00000E+00 | 3.09804E-09 | 1.48684E-14 | -4.03834E-19 | -5.72817E-24 |
| Mirror 8 | 0.00000E+00 | 6.55194E-11 | 1.29992E-16 | 2.37143E-22 | 4.46073E-28 |
| Mirror 9 | 0.00000E+00 | 6.94725E-11 | 7.74511 E-17 | 2.33861 E-22 | 9.32544E-29 |
| Mirror 10 | 0.00000E+00 | -1.35922E-10 | -3.07250E-17 | 1.86948E-22 | 2.92915E-28 |

| Surface | E | F | G | H | J |
|---|---|---|---|---|---|
| Mirror 1 | 1.39879E-30 | -1.37935E-36 | 0.00000E+00 | 0.00000E+00 | 0.00000E+00 |
| Mirror 2 | 3.00921 E-30 | -3.04597E-35 | 0.00000E+00 | 0.00000E+00 | 0.00000E+00 |
| Mirror 3 | -2.20201 E-29 | 2.31377E-34 | 0.00000E+00 | 0.00000E+00 | 0.00000E+00 |
| Mirror 4 | -8.15911 E-34 | 2.59261 E-39 | -6.08607E-45 | 0.00000E+00 | 0.00000E+00 |
| Mirror 5 | 6.45614E-33 | -1.77221 E-38 | 5.08599E-44 | 0.00000E+00 | 0.00000E+00 |
| Mirror 6 | 3.31937E-28 | -3.44267E-33 | 1.68365E-38 | 0.00000E+00 | 0.00000E+00 |
| Mirror 7 | -1.99674E-28 | 3.88481 E-33 | -3.50397E-38 | 0.00000E+00 | 0.00000E+00 |
| Mirror 8 | 3.95152E-34 | 3.88746E-39 | -9.08040E-45 | 2.70091 E-50 | 0.00000E+00 |
| Mirror 9 | 8.50266E-34 | -1.88020E-40 | 4.25518E-46 | 4.36378E-51 | 0.00000E+00 |
| Mirror 10 | -3.23938E-34 | 1.34899E-39 | -3.15465E-45 | 6.54274E-51 | 0.00000E+00 |

In Figur 8 ist eine Variation des Ausführungsbeispieles wie in Figur 7 dargestellt gezeigt. Im Gegensatz zu Figur 7 beträgt die Feldgröße des Feldes in der Bildebene 20 26 x 2 mm², d. h. $D_x$=26 mm, $D_y$= 2 mm, $D_r$= 29,75 mm und entspricht damit einer Feldgröße, die für Lithographiesysteme ausreichend ist. Bei dem in Figur 8 dargestellten System ist die Wellenfront auf einen mittleren Wellenfrontfehler $W_{rms}$ von 0,024 λ und die Auflösung beträgt 11 nm und die Baulänge des Systems 2511 mm. Die bildseitige Feldkrümmung beträgt 3 nm. Der resultierende Obskurationsradius, der eine feldunabhängige Obskuration zur Verfügung stellt, beträgt 55 % des Aperturradius. Der bildseitige freie Arbeitsabstand beträgt 40 mm und der objektseitige freie Arbeitsabstand 100 mm. Der maximale Einfallswinkel $\Theta_{CR(max)}$ auf einen Spiegel S10 bis S80, SK1 und SK2 eines Hauptstrahls zu einem zentralen Feldpunkt beträgt 32,5°. Der maximale Einfallswinkel $\Theta_{max(max)}$ irgendeines Strahls auf einen Spiegel S10 bis S80, SK1 und SK2 beträgt 45,1°. Der maximale Einfallswinkelbereich $\Delta\Theta_{max}$ auf irgendeinen Spiegel S10 bis S80, SK1 und SK2 beträgt 28,9°. Die Größe des größten Spiegels im Meridionalschnitt beträgt 933 mm, die Größe des größten Spiegels in x-Richtung beträgt 1028 mm.

Gleiche Bauteile wie in Figur 7 werden mit denselben Bezugsziffern belegt.

Das dritte Teilobjektiv sowohl in Figur 7 wie in Figur 8 wird mit 300 bezeichnet und umfasst den Konvexspiegel S30 und den Konkavspiegel S40. Das erste Zwischenbild ist mit Z1 bezeichnet, das zweite Zwischenbild mit Z2. Das zweite Teilobjektiv 200 umfasst zwei Konkavspiegel, nämlich den primären Konkavspiegel SK1 und den sekundären Konkavspiegel SK2. Der sekundäre Konkavspiegel SK2 ist der im Lichtweg letzte Spiegel und der Spiegel S30 der im Lichtweg viertletzte Spiegel bezogen auf die Bildebene 20.

Das System in Figur 8 ist in drei Teilobjektive, ein erstes Teilobjektiv 100, ein zweites Teilobjektiv 200 und ein drittes Teilobjektiv 300 unterteilt. Das erste Teilobjektiv umfasst die Spiegel S10, S20, S50, S60, S70 und S80, das zweite Teilobjektiv die Spiegel SK1 und SK2 und das dritte Teilobjektiv die Spiegel S30 und S40.

Der Spiegel S10 ist ein Konvexspiegel, der Spiegel S20 ist ein Konkavspiegel, der Spiegel S50 ist ein Konvexspiegel, der Spiegel S60 ist ein Konkavspiegel, der Spiegel S70 ist ein Konkavspiegel, der Spiegel S80 ist ein Konvexspiegel, der Spiegel S30 ist ein Konvexspiegel, der Spiegel S40 ist ein Konkavspiegel, der Spiegel SK1 ist ein Konkavspiegel und der Spiegel SK2 ist ein Konkavspiegel. Die Spiegel S30, S40, S70, SK1 und SK2 umfassen Öffnungen. Die Spiegel S10, S20, S50, S60 und S80 umfassen keine Öffnungen. Die Aperturblende B ist auf dem zweiten Spiegel angeordnet.

Die optischen Daten des in Figur 8 gezeigten Systems sind in Tabelle 8 angegeben.

Dabei bezeichnet

| Mirror 1: | den Spiegel S10 |
| Mirror 2: | den Spiegel S20 |
| Mirror 3: | den Spiegel S50 |
| Mirror 4: | den Spiegel S60 |
| Mirror 5: | den Spiegel S70 |
| Mirror 6: | den Spiegel S80 |
| Mirror 7: | den Spiegel S30 |
| Mirror 8: | den Spiegel S40 |
| Mirror 9: | den primären Konkavspiegel SK1 |
| Mirror 10: | den sekundären Konkavspiegel SK2 |

Im zweiten Teil von Tabelle 8 sind die asphärischen Konstanten der einzelnen Spiegelflächen angegeben.

Tabelle 8

| Surface | Radius | Thickness | Mode |
|---------|--------|-----------|------|
| Object | INFINITY | 800.266 | |
| Mirror 1 | 10314.848 | -700.266 | REFL |
| STOP | INFINITY | 0.000 | |
| Mirror 2 | 1313.221 | 772.471 | REFL |
| Mirror 3 | 435.263 | -403.381 | REFL |
| Mirror 4 | 987.208 | 756.370 | REFL |
| Mirror 5 | -693.635 | -152.988 | REFL |
| Mirror 6 | -376.671 | 770.162 | REFL |
| Mirror 7 | 773.821 | -617.174 | REFL |
| Mirror 8 | 734.569 | 1245.278 | REFL |
| Mirror 9 | -1353.223 | -488.675 | REFL |
| Mirror 10 | 976.962 | 528.674 | REFL |
| Image | INFINITY | 0.000 | |

| Surface | K | A | B | C | D |
|---------|---|---|---|---|---|
| Mirror 1 | 0.00000E+00 | 9.53114E-10 | -4.86644E-15 | 1.31711E-20 | -1.00791E-25 |
| Mirror 2 | 0.00000E+00 | -1.47585E-10 | -6.60664E-16 | -1.36568E-21 | -4.71682E-26 |
| Mirror 3 | 0.00000E+00 | -1.70365E-09 | -1.16839E-14 | 9.85514E-20 | -9.70081E-25 |
| Mirror 4 | 0.00000E+00 | -6.35387E-11 | -1.10979E-16 | -1.03841E-22 | 2.37479E-29 |
| Mirror 5 | 0.00000E+00 | 6.32087E-10 | -6.50351E-16 | 3.64943E-21 | -5.41639E-27 |
| Mirror 6 | 0.00000E+00 | 6.40969E-09 | -5.76722E-14 | 1.35569E-18 | -2.25614E-23 |
| Mirror 7 | 0.00000E+00 | 3.10697E-09 | 1.51614E-14 | -4.09300E-19 | -6.19233E-24 |
| Mirror 8 | 0.00000E+00 | 6.56531E-11 | 1.29850E-16 | 2.37674E-22 | 4.38690E-28 |
| Mirror 9 | 0.00000E+00 | 6.93646E-11 | 7.77340E-17 | 2.35663E-22 | 8.87991E-29 |
| Mirror 10 | 0.00000E+00 | -1.36095E-10 | -2.99886E-17 | 1.86689E-22 | 2.94132E-28 |

(fortgesetzt)

| Surface | E | F | G | H | J |
|---------|---|---|---|---|---|
| Mirror 1 | 3.35912E-31 | 8.78178E-36 | 0.00000E+00 | 0.00000E+00 | 0.00000E+00 |
| Mirror 2 | 1.70095E-30 | -1.74271 E-35 | 0.00000E+00 | 0.00000E+00 | 0.00000E+00 |
| Mirror 3 | -1.98157E-29 | 2.10542E-34 | 0.00000E+00 | 0.00000E+00 | 0.00000E+00 |
| Mirror 4 | -7.95278E-34 | 2.56682E-39 | -6.07013E-45 | 0.00000E+00 | 0.00000E+00 |
| Mirror 5 | 6.29468E-33 | -1.72403E-38 | 5.01025E-44 | 0.00000E+00 | 0.00000E+00 |
| Mirror 6 | 3.33377E-28 | -3.47620E-33 | 1.70289E-38 | 0.00000E+00 | 0.00000E+00 |
| Mirror 7 | -7.67239E-29 | -2.04991 E-33 | 6.19397E-38 | 0.00000E+00 | 0.00000E+00 |
| Mirror 8 | 4.29719E-34 | 3.75714E-39 | -8.71022E-45 | 2.66200E-50 | 0.00000E+00 |
| Mirror 9 | 8.17352E-34 | 1.07822E-41 | 1.12329E-47 | 4.63290E-51 | 0.00000E+00 |
| Mirror 10 | -3.16654E-34 | 1.18038E-39 | -2.51249E-45 | 5.75859E-51 | 0.00000E+00 |

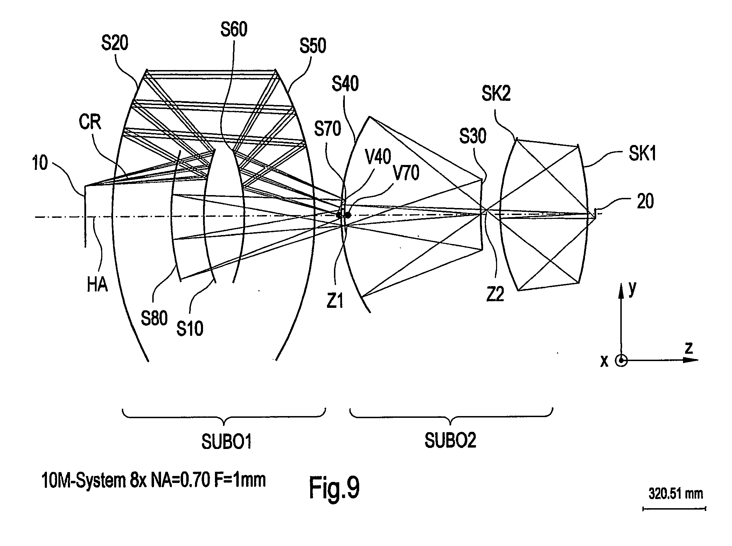

In Fig. 9 ist ein drittes Ausführungsbeispiel eines Objektives, insbesondere eines Projektionsobjektiv mit 10 Spiegeln und mit zwei Zwischenbildern gezeigt mit NA=0,7 und einer Verkleinerung 8x bei einer Wellenlänge λ=13,5 nm. Die Größe des Bildfeldes beträgt 13 x 1 mm$^2$ in der Bildebene, d. h. $D_x$= 13mm, $D_y$=1 mm, $D_r$= 17,15 mm. Die Auflösung beträgt 12 nm und die Baulänge des Systems 2494 mm. Der bildseitige $W_{rms}$ beträgt 0,018 λ und die bildseitige Feldkrümmung weniger als 1 nm. Der resultierende Obskurationsradius, der eine feldunabhängige Obskuration zur Verfügung stellt beträgt 26 % des Aperturradius. Der bildseitige freie Arbeitsabstand beträgt 40 mm und der objektseitige freie Arbeitsabstand 100 mm. Der maximale Einfallswinkel $\Theta_{CR(max)}$ auf einen Spiegel S10 bis S80, SK1 und SK2 eines Hauptstrahls zu einem zentralen Feldpunkt beträgt 32,7°. Der maximale Einfallswinkel $\Theta_{max(max)}$ irgendeines Strahls auf einen Spiegel S10 bis S80, SK1 und SK2 beträgt 42,3°. Der maximale Einfallswinkelbereich $\Delta\Theta_{max}$ auf irgendeinen Spiegel S10 bis S80, SK1 und SK2 beträgt 18,8°. Die Größe des größten Spiegels im Meridionalschnitt beträgt 858 mm, die Größe des größten Spiegels in x-Richtung beträgt 891 mm.

Das System gemäß Figur 9 umfasst drei Teilobjektive. Das erste Teilobjektiv umfasst die Spiegel S10, S20, S50, S60, S70 und S80 und bildet ein Zwischenbild Z1 nahe oder beim Spiegel S40. Das zweite Teilobjektiv umfasst die Spiegel SK1 und SK2. Das dritte Teilobjektiv umfasst die Spiegel S30 und S40 und bildet ein Zwischenbild Z2 zwischen dem Spiegel S30 und SK2 aus. Im Lichtweg von der Objektebene 10 zur Bildebene 20 ist der Spiegel S10 ein Konvexspiegel, der Spiegel S20 ein Konkavspiegel, der Spiegel S50 ein Konkavspiegel, der Spiegel S60 ein Konvexspiegel, der Spiegel S70 ein Konvexspiegel, der Spiegel S80 ein Konkavspiegel, der Spiegel S30 ein Konvexspiegel, der Spiegel S40 ein Konkavspiegel, der Spiegel SK1 ein Konkavspiegel und der Spiegel SK2 ein Konkavspiegel.

Die optischen Daten des Systems gemäß Figur 9 sind aus Tabelle 9 zu entnehmen.

Dabei bezeichnet

| | |
|---|---|
| Mirror 1: | den Spiegel S10 |
| Mirror 2: | den Spiegel 520 |
| Mirror 3: | den Spiegel S50 |
| Mirror 4: | den Spiegel S60 |
| Mirror 5: | den Spiegel S70 |
| Mirror 6: | den Spiegel S80 |
| Mirror 7: | den Spiegel S30 |
| Mirror 8: | den Spiegel S40 |
| Mirror 9: | den primären Konkavspiegel SK1 |
| Mirror 10: | den sekundären Konkavspiegel SK2 |

Im zweiten Teil von Tabelle 9 sind die asphärischen Konstanten der einzelnen Spiegelflächen angegeben.

Tabelle 9

| Surface | Radius | Thickness | Mode |
|---------|--------|-----------|------|
| Object | INFINITY | 576.457 | |
| Mirror 1 | 743.152 | -443.481 | REFL |
| Mirror 2 | 1348.018 | 992.889 | REFL |

(fortgesetzt)

| Surface | Radius | Thickness | Mode |
|---|---|---|---|
| Mirror 3 | -1386.925 | -349.408 | REFL |
| Mirror 4 | -1014.795 | 496.732 | REFL |
| Mirror 5 | 324.055 | -856.578 | REFL |
| Mirror 6 | 941.81 | 1510.551 | REFL |
| STOP | INFINITY | 0.000 | |
| Mirror 7 | 2311.955 | -670.058 | REFL |
| Mirror 8 | 862.319 | 1196.518 | REFL |
| Mirror 9 | -1133.435 | -426.460 | REFL |
| Mirror 10 | 831.304 | 466.461 | REFL |
| Image | INFINITY | 0.000 | |

| Surface | K | A | B | C | D |
|---|---|---|---|---|---|
| Mirror 1 | 0.00000E+00 | -1.74588E-09 | 5.73560E-15 | -2.18120E-20 | 8.88355E-26 |
| Mirror 2 | 0.00000E+00 | -8.27033E-11 | -3.72143E-17 | 6.51400E-24 | 5.62567E-30 |
| Mirror 3 | 0.00000E+00 | -8.58288E-12 | 3.92829E-18 | -4.18276E-24 | -1.25792E-29 |
| Mirror 4 | 0.00000E+00 | 2.07266E-11 | -4.52705E-16 | -2.17586E-21 | -1.01747E-26 |
| Mirror 5 | 0.00000E+00 | 4.76733E-09 | -2.14786E-13 | -1.18998E-17 | -8.08930E-22 |
| Mirror6 | 0.00000E+00 | 1.65766E-11 | 2.69419E-17 | 5.87911E-24 | 3.46720E-29 |
| Mirror 7 | 0.00000E+00 | 8.89937E-10 | 1.82131 E-15 | 7.16217E-21 | -5.94918E-25 |
| Mirror 8 | 0.00000E+00 | 3.72408E-11 | 3.09842E-17 | 3.10857E-23 | 4.92719E-29 |
| Mirror 9 | 0.00000E+00 | 1.94111E-10 | 4.16355E-16 | 1.11547E-21 | 4.33879E-27 |
| Mirror 10 | 0.00000E+00 | -1.69879E-10 | 2.55525E-16 | 6.73274E-22 | -2.01071E-28 |

| Surface | E | F | G | H | J |
|---|---|---|---|---|---|
| Mirror 1 | -1.89149E-31 | 2.05598E-37 | 0.00000E+00 | 0.00000E+00 | 0.00000E+00 |
| Mirror 2 | 0.00000E+00 | 0.00000E+00 | 0.00000E+00 | 0.00000E+00 | 0.00000E+00 |
| Mirror 3 | 8.61573E-36 | 5.91202E-42 | -2.37686E-48 | 5.37118E-55 | 0.00000E+00 |
| Mirror 4 | 3.23938E-32 | 0.00000E+00 | 0.00000E+00 | 0.00000E+00 | 0.00000E+00 |
| Mirror 5 | 2.17082E-25 | -2.89803E-29 | 2.55500E-33 | -9.16686E-38 | 0.00000E+00 |
| Mirror 6 | -1.13782E-35 | 1.27000E-39 | 0.00000E+00 | 0.00000E+00 | 0.00000E+00 |
| Mirror 7 | -2.13013E-29 | 5.53859E-34 | -1.47815E-38 | 1.00232E-43 | 0.00000E+00 |
| Mirror 8 | 1.90775E-35 | 1.35114E-40 | -5.54544E-47 | 2.44701 E-52 | 0.00000E+00 |
| Mirror 9 | -5.57552E-34 | 3.06849E-38 | 1.07483E-43 | -3.56612E-49 | 0.00000E+00 |
| Mirror 10 | 6.55890E-33 | -1.22949E-38 | 2.98699E-44 | 2.63597E-50 | 0.00000E+00 |

Die Systeme gemäß den Figuren 2,3,4,5,6,7,8 und 9 haben des weiteren die vorteilhafte Eigenschaft, dass das Objektiv, insbesondere das Mikrolithographie Projektionsobjektiv ein erstes Subobjektiv, welches keinen Spiegel mit einer Öffnung für den Durchtritt eines Strahlbüschels aufweist, d.h. keinen durchbohrten Spiegel aufweist, sowie ein zweites Subobjektiv, welches keinen Spiegel ohne eine Öffnung für den Durchtritt eines Strahlbüschels aufweist, umfasst und der geometrische Abstand zwischen dem ersten Subobjektiv und dem zweiten Subobjektiv wenigstens 10% einer Baulänge des Projektionssystems beträgt. Unter der Baulänge eines Objektives wird in vorliegender Anmeldung der Abstand entlang der optischen Achse HA von der Objektebene 10 zur Bildebene 20 verstanden. Unter dem geometrischen oder räumlichen Abstand zwischen dem ersten Subobjektiv SUBO1 und dem zweiten Subobjektiv SUBO2 wird in vorliegender Anmeldung der Abstand vom Scheitelpunkt bzw. der Vertex des Spiegels des ersten Subobjektivs, der den geringsten Abstand zur Bildebene aufweist, zum Scheitelpunkt des Spiegels des zweiten Subobjektives, der den geringsten Abstand zur Objektebene aufweist, verstanden. Der Spiegel des zweiten Suobjektivs, der den geringsten Abstand zur Objektebene aufweist, wird auch als retikelnächster Spiegel des zweiten Subobjektivs bezeichnet, der Spiegel des ersten Subobjektivs, der den geringsten Abstand zur Bildebene aufweist, als wafernächster Spiegel des ersten Subobjektivs bezeichnet.

Gemäß dem Ausführungsbeispiel in Figur 9 wäre dies der Abstand des Scheitelpunktes V70 des Spiegels S70 zum Scheitelpunkt V40 des Spiegels S40 entlang der optischen Achse HA. Bei dem Ausführungsbeispiel gemäß Figur 9 ist der Abstand zwischen den beiden Subobjektiven SUBO1 SUBO2 negativ, da die beiden Subobjektive räumlich ineinander verschachtelt sind, d.h.der Spiegel S70 liegt räumlich im Bereich des zweiten Subobjektives.

Eine derartige Anordnung hat den Vorteil, dass wenn der retikelnächste Spiegel des zweiten Subobjektivs nur einen geringen Abstand zum wafemächsten Spiegel des ersten Subobjektivs aufweist, der innere Ringfeldradius und damit die Obskuration klein gehalten werden kann.

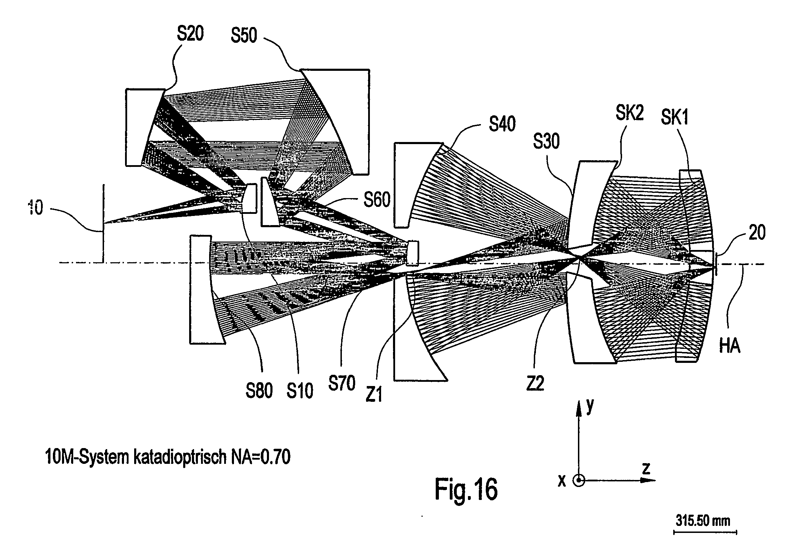

Des Weiteren zeichnen sich die Systeme gemäß den Figuren 2, 3, 4, 5, 6a, 9 sowie den in den nachfolgenden Figuren 16, 17 und 18 dargestellten durch eine negative Schnittweite der Eintrittspupille aus. Eine negative Schnittweite der Eintrittspupille bedeutet, dass die Hauptstrahlen der verschiedenen Feldpunkte in Lichtrichtung von der Objektebene startend divergent in das Objektiv, d.h. in Lichtrichtung, hineinlaufen. Dies bedeutet, dass die Eintrittspupille des Projektionsobjektives im Lichtweg von einer Lichtquelle eines Beleuchtungssystems zur Objektebene, in der ein reflektives Retikel angeordnet ist, vor der Objektebene angeordnet ist. Derartige Projektionsobjektive und Projektionsbelichtungsanlagen sind beispielsweise in der WO2004/010224 gezeigt, deren Offenbarungsgehalt vollumfänglich in die vorliegende Anmeldung mit eingeschlossen wird.

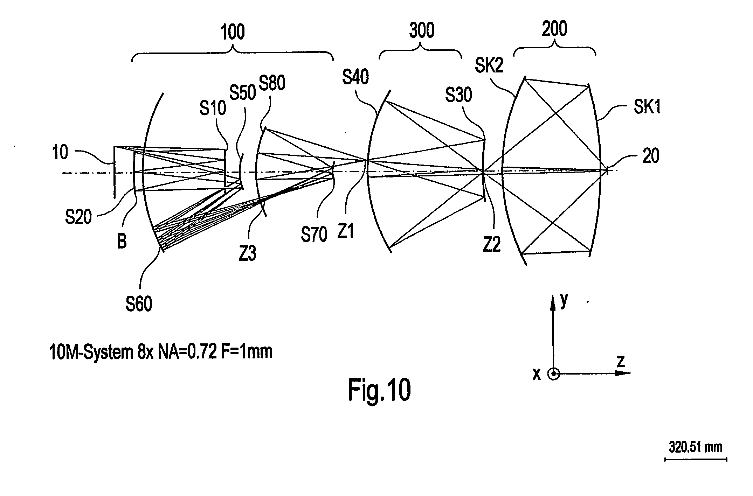

In Figur 10 ist ein viertes Ausführungsbeispiel eines 10-Spiegel-Systems mit einer bildseitigen Apertur von NA=0,72 bei einer Wellenlänge von 13,5nm gezeigt. Das erste Teilsystem 100 besteht aus 6 Spiegeln S10, S20, S50, S60, S70, S80 in der Spiegelabfolge konvex - konkav - konvex - konkav - konvex- konkav. Die Aperturblende B liegt auf dem zweiten Spiegel S20 des ersten Teilobjektives 100. Auch bei dem in Figur 10 gezeigten Ausführungsbeispiel ist der Radius des ersten Spiegels so groß, dass der Spiegel S10 nicht nur konvex, sondern auch plan oder konkav ausgebildet werden kann. Daher sind nachfolgende Spiegelabfolgen auch möglich:

konkav - konkav - konvex - konkav - konvex - konkav
plan - konkav - konvex - konkav - konvex - konkav

Im Gegensatz zu den in den vorausgegangenen Ausführungsbeispielen gezeigten Systemen mit einem ersten Teilsystem, besitzt das erste Teilsystem 100 dieses Projektionsobjektives ein Zwischenbild Z3 welches zwischen dem im Lichtweg von der Objektebene zur Bildebene vierten und dem fünften Spiegel, den Spiegeln S60 und S70 angeordnet ist.

Durch ein derartiges drittes Zwischenbild Z3 wird erreicht, dass die Querschnitte der Strahlbündel und damit auch die Nutzbereiche der Spiegel klein gehalten werden können.

Die Abbildungsmaßstäbe des ersten Teilobjektivs 100, des dritten Teilobjektivs 300 und des zweiten Teilobjektivs 200 betragen jeweils 2,78x, 2,24x und 1,29x. Das Ausführungsbeispiel gemäß Figur 10 zeichnet sich dadurch aus, dass die Einfallswinkel des Hauptstrahles des zentralen Feldpunktes des abzubildenden Feldes in der Feldebene in dem vorliegenden Beispiel besonders klein ausgebildet sind. Des Weiteren zeichnet sich das System dadurch aus, dass der Flächenanteil der Obskuration in der Pupille nur 10% beträgt. Gleiche Bauteile wie in den Figuren 7 und 8 sind mit denselben Bezugsziffern belegt. Die Aperturblende B liegt auf dem zweiten Spiegel S20. Die Größe des Bildfeldes beträgt 13 x 1 mm$^2$ in der Bildebene, wobei $D_x$=13 mm, $D_y$=1 mm, $D_r$=15,125 mm ist. Die Auflösung beträgt 12 nm und die Baulänge des Systems 2500 mm. Der bildseitige $W_{rms}$ beträgt 0,041 $\lambda$. Die bildseitige Feldkrümmung beträgt 4 nm. Der resultierende Obskurationsradius, der eine feldunabhängige Obskuration zur Verfügung stellt beträgt 27 % des Aperturradius. Der bildseitige freie Arbeitsabstand beträgt 40 mm und der objektseitige freie Arbeitsabstand 100 mm. Der maximale Einfallswinkel $\Theta_{CR(max)}$ auf einen Spiegel S10 bis S80, SK1 und SK2 eines Hauptstrahls CR zu einem zentralen Feldpunkt beträgt 20°. Der maximale Einfallswinkel $\Theta_{max(max)}$ irgendeines Strahls auf einen Spiegel S10 bis S80, SK1 und SK2 beträgt 27,7°. Der maximale Einfallswinkelbereich $\Delta\Theta_{max}$ auf irgendeinen Spiegel S10 bis S80, SK1 und SK2 beträgt 20,9°. Die Größe des größten Spiegels im Meridionalschnitt beträgt 884 mm, die Größe des größten Spiegels in x-Richtung beträgt 927 mm.

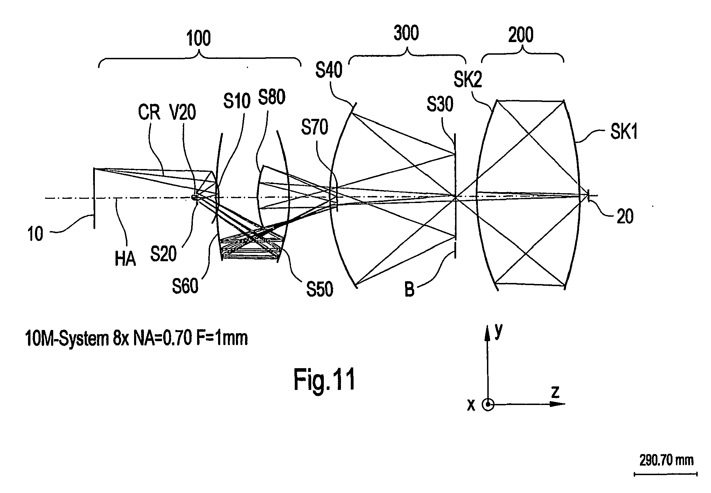

Das in Figur 11 gezeigte Objektiv umfasst drei Teilobjektive, ein erstes Teilobjektiv 100 mit den Spiegeln S10, S20, S50, S60, S70 und S80, einem zweiten Teilobjektiv mit den Spiegeln SK1 und SK2 sowie einem dritten Teilobjektiv mit den Spiegeln S30 und S40.

Im Lichtweg von der Objektebene zur Bildebene weisen die Spiegel die folgende Spiegelabfolge auf:

konvex - konkav - konvex - konkav - konvex - konkav - konvex - konkav - konkav - konkav.

Die optischen Daten des in Figur 10 dargestellten Systems sind in Tabelle 10 angegeben.

Dabei bezeichnet

Mirror 1:     den Spiegel S10
Mirror 2:     den Spiegel S20
Mirror 3:     den Spiegel S80

(fortgesetzt)

| | |
|---|---|
| Mirror 4: | den Spiegel S60 |
| Min-or 5: | den Spiegel S70 |
| Mirror 6: | den Spiegel S80 |
| Mirror 7: | den Spiegel S30 |
| Mirror 8: | den Spiegel S40 |
| Mirror 9: | den primären Konkavspiegel SK1 |
| Mirror 10: | den sekundären Konkavspiegel SK2 |

Im zweiten Teil von Tabelle 10 sind die asphärischen Konstanten der einzelnen Spiegelflächen angegeben.

Tabelle 10

| Surface | Radius | Thickness | Mode |
|---|---|---|---|
| Object | INFINITY | 565.102 | |
| Mirror 1 | 55533.824 | -465.102 | REFL |
| STOP | INFINITY | 0.000 | |
| Mirror 2 | 852.374 | 542.952 | REFL |
| Mirror 3 | 281.088 | -498.503 | REFL |
| Mirror 4 | 759.16 | 966.921 | REFL |
| Mirror 5 | 309.453 | -386.183 | REFL |
| Mirror 6 | 515.051 | 1141.014 | REFL |
| Mirror 7 | 1674.294 | -583.849 | REFL |
| Mirror 8 | 758.67 | 1177.650 | REFL |
| Mirror 9 | -1322.155 | -496.668 | REFL |
| Mirror 10 | 927.879 | 536.666 | REFL |
| Image | INFINITY | 0.000 | |

| Surface | K | A | B | C |
|---|---|---|---|---|
| Mirror 1 | 0.00000E+00 | 1.52016E-09 | -3.52459E-14 | 6.75945E-19 |
| Mirror 2 | 0.00000E+00 | 1.08280E-10 | -6.34141E-15 | 5.18470E-19 |
| Mirror 3 | 0.00000E+00 | -5.96955E-09 | 1.74672E-13 | -6.30562E-19 |
| Mirror 4 | 0.00000E+00 | -1.08435E-11 | -1.00947E-16 | 8.75041 E-22 |
| Mirror 5 | 0.00000E+00 | -2.51202E-09 | 7.56313E-12 | -6.05145E-16 |
| Mirror 6 | 0.00000E+00 | -2.60613E-10 | -1.98309E-16 | -1.19381 E-21 |
| Mirror 7 | 0.00000E+00 | 6.30349E-10 | -3.39796E-15 | 1.21242E-19 |
| Mirror 8 | 0.00000E+00 | 1.23547E-10 | 2.57281 E-16 | 4.94742E-22 |
| Mirror 9 | 0.00000E+00 | 1.05621 E-10 | 1.30680E-17 | 4.34693E-22 |
| Mirror 10 | 0.00000E+00 | -2.03140E-10 | -2.32499E-17 | 2.98416E-22 |

| Surface | D | E | F | G |
|---|---|---|---|---|
| Mirror 1 | -9.26171 E-24 | 0.00000E+00 | 0.00000E+00 | 0.00000E+00 |
| Mirror 2 | -1.66660E-23 | 0.00000E+00 | 0.00000E+00 | 0.00000E+00 |
| Mirror 3 | 1.33871 E-22 | -2.49248E-28 | 0.00000E+00 | 0.00000E+00 |
| Mirror 4 | -3.90330E-27 | 8.80258E-33 | 0.00000E+00 | 0.00000E+00 |
| Mirror 5 | 6.70343E-20 | 0.00000E+00 | 0.00000E+00 | 0.00000E+00 |
| Mirror 6 | 2.15204E-27 | 0.00000E+00 | 0.00000E+00 | 0.00000E+00 |
| Mirror 7 | -1.06347E-24 | -2.29594E-29 | 0.00000E+00 | 0.00000E+00 |
| Mirror 8 | 7.10013E-28 | 2.49635E-33 | 0.00000E+00 | 0.00000E+00 |

(fortgesetzt)

| Surface | D | E | F | G |
|---------|------|------|------|------|
| Mirror 9 | -3.96448E-28 | 1.80389E-33 | 0.00000E+00 | 0.00000E+00 |
| Mirror 10 | -2.49605E-28 | 8.14302E-34 | 0.00000E+00 | 0.00000E+00 |

Im Ausführungsbeispiel, das in Figur 11 dargestellt ist, ist wiederum ein 10-Spiegel-System gezeigt. Im Unterschied zum System gemäß Figur 10 umfasst das erste Teilobjektiv 100 sechs Spiegel S10, S20, S50, S60, S70, S80 mit der Spiegelabfolge konkav - konvex - konkav - konkav - konvex - konkav.

Die Spiegel SK1, SK2 des zweiten Teilobjektives 200 sind zwei Konkavspiegel.

Der Spiegel S30 ist ein Konvexspiegel und der Spiegel S40 ein Konkavspiegel.

Die Aperturblende B ist im Ausführungsbeispiel gemäß Figur 11 auf dem im Lichtweg siebten Spiegel, d. h. dem Spiegel S30, angeordnet und damit in das dritte Teilobjektiv 300, d. h. die Transfergruppe verlegt.

Das in Figur 11 gezeigte System mit einer Apertur von NA=0,7 einer Verkleinerung 8x einer Betriebswellenlänge von 13,5 nm zeichnet sich dadurch aus, dass ein besonders geringer Flächenanteil der Pupillenobskuration auftritt, der bei einem Ringfeld von 13 x 1 mm$^2$ unterhalb von 4% liegt. Die Größe des Bildfeldes beträgt 13 x 1 mm$^2$, d. h. $D_x$= 13 mm, $D_y$=1 mm, $D_r$=16,25 mm. Die Auflösung beträgt 12 nm und die Baulänge des Systems 2246 mm. Der bildseitige $W_{rms}$ beträgt 0,3 λ. Die bildseitige Feldkrümmung 27 nm. Der resultierende Obskurationsradius, der eine feldunabhängige Obskuration zur Verfügung stellt beträgt 28 % des Aperturradius. Der bildseitige freie Arbeitsabstand beträgt 40 mm und der objektseitige freie Arbeitsabstand 468 mm. Der maximale Einfallswinkel $\Theta_{CR(max)}$ auf einen Spiegel S10 bis S80, SK1 und SK2 eines Hauptstrahls zu einem zentralen Feldpunkt beträgt 35,3°. Der maximale Einfallswinkel $\Theta_{max(max)}$ irgendeines Strahls auf einen Spiegel S10 bis S80, SK1 und SK2 beträgt 42,4°. Der maximale Einfallswinkelbereich $\Delta\Theta_{max}$ auf irgendeinen Spiegel S10 bis S80, SK1 und SK2 beträgt 18,9°. Die Größe des größten Spiegels im Meridionalschnitt beträgt 836 mm, die Größe des größten Spiegels in x-Richtung beträgt 834 mm.

Die optischen Daten sind aus Tabelle 11 entnehmbar.

Dabei bezeichnet

| | |
|---|---|
| Mirror 1: | den Spiegel S10 |
| Mirror 2: | den Spiegel S20 |
| Mirror 3: | den Spiegel S50 |
| Mirror 4: | den Spiegel S60 |
| Mirror 5: | den Spiegel S70 |
| Mirror 6: | den Spiegel S80 |
| Mirror 7: | den Spiegel S30 |
| Mirror 8: | den Spiegel S40 |
| Mirror 9: | den primären Konkavspiegel SK1 |
| Mirror 10: | den sekundären Konkavspiegel SK2 |

Im zweiten Teil von Tabelle 11 sind die asphärischen Konstanten der einzelnen Spiegelflächen angegeben.

Tabelle 11

| Surface | Radius | Thickness | Mode |
|---------|--------|-----------|------|
| Object | INFINITY | 559.181 | |
| Mirror 1 | -245.847 | -91.621 | REFL |
| Mirror 2 | -106.241 | 409.943 | REFL |
| Mirror 3 | -797.047 | -329.100 | REFL |
| Mirror 4 | 1288.083 | 544.097 | REFL |
| Mirror 5 | 471.444 | -352.779 | REFL |
| Mirror 6 | 391.18 | 895.651 | REFL |
| STOP | INFINITY | 0.000 | |
| Mirror 7 | 89550.706 | -575.938 | REFL |
| Mirror 8 | 769.632 | 1146.221 | REFL |
| Mirror 9 | -1294.759 | -470.344 | REFL |
| Mirror 10 | 921.525 | 510.244 | REFL |

(fortgesetzt)

| Surface | Radius | Thickness | Mode |
|---------|--------|-----------|------|
| Image | INFINITY | 0.000 | |

| Surface | K | A | B | C |
|---------|---|---|---|---|
| Mirror 1 | 0.00000E+00 | 7.66254E-09 | 2.77417E-14 | 1.36582E-18 |
| Mirror 2 | 0.00000E+00 | 7.08392E-07 | 8.77265E-11 | -1.08467E-13 |
| Mirror 3 | 0.00000E+00 | 3.26115E-10 | 3.33584E-16 | -5.68189E-21 |
| Mirror 4 | 0.00000E+00 | 2.50220E-10 | -4.02328E-15 | 3.97478E-20 |
| Mirror 5 | 0.00000E+00 | 8.20670E-08 | 8.14545E-12 | 4.31824E-16 |
| Mirror 6 | 0.00000E+00 | 1.46218E-09 | 2.25940E-14 | 5.19142E-19 |
| Mirror 7 | 0.00000E+00 | 4.23423E-09 | -7.06964E-14 | 9.09880E-19 |
| Mirror 8 | 0.00000E+00 | 6.41818E-11 | 1.25081E-16 | 4.78443E-23 |
| Mirror 9 | 0.00000E+00 | -2.72326E-10 | 1.27303E-15 | -6.33084E-21 |
| Mirror 10 | 0.00000E+00 | -2.43581E-10 | -6.44997E-16 | 3.73803E-22 |

| Surface | D | E | F | G |
|---------|---|---|---|---|
| Mirror 1 | 1.60505E-23 | 0.00000E+00 | 0.00000E+00 | 0.00000E+00 |
| Mirror 2 | 0.00000E+00 | 0.00000E+00 | 0.00000E+00 | 0.00000E+00 |
| Mirror 3 | 1.08127E-25 | -4.00572E-31 | 0.00000E+00 | 0.00000E+00 |
| Mirror 4 | -1.61324E-25 | 2.23312E-31 | 0.00000E+00 | 0.00000E+00 |
| Mirror 5 | 1.12366E-19 | 0.00000E+00 | 0.00000E+00 | 0.00000E+00 |
| Mirror 6 | -2.84570E-24 | 3.72190E-28 | 0.00000E+00 | 0.00000E+00 |
| Mirror 7 | -9.81546E-24 | 1.27493E-29 | -6.38729E-35 | 0.00000E+00 |
| Mirror 8 | 1.99269E-27 | -5.19669E-33 | 2.07669E-38 | 0.00000E+00 |
| Mirror 9 | 2.30570E-26 | -5.38480E-32 | 6.82514E-38 | 0.00000E+00 |
| Mirror 10 | 1.59378E-27 | -2.26603E-32 | 7.46453E-38 | 0.00000E+00 |

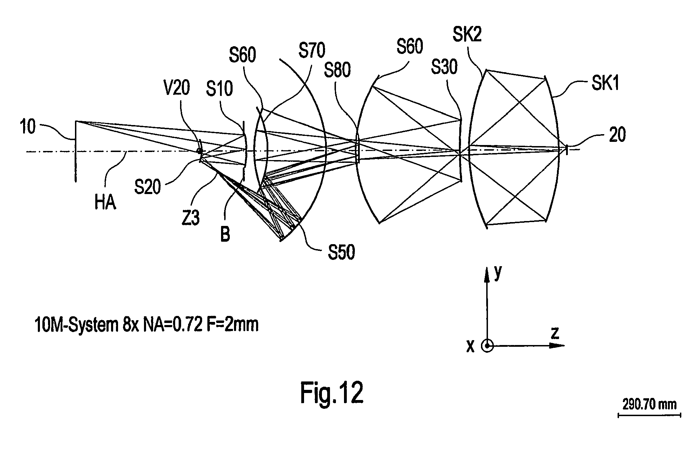

Bei dem Ausführungsbeispiel gemäß Figur 12 handelt es sich wiederum um ein 10-Spiegel-System mit einer Apertur NA=0,7 bei einer Wellenlänge von 13,4nm und einer Verkleinerung von 8x.

Das erste Teilobjektiv umfasst wie schon in den vorausgegangenen Beispielen sechs Spiegel, nämlich die Spiegel S10, S20, S50, S60, S70, S80. Die Spiegelabfolge ist konkav - konvex - konkav - konvex - konvex - konkav. Wie schon beim Ausführungsbeispiel gemäß Figur 11 wird hier im ersten Teilsystem ein Zwischenbild Z3 ausgebildet und zwar zwischen dem zweiten Spiegel S20 im Lichtweg von Objekt zum Bild und dem dritten Spiegel S50 im Lichtweg vom Objekt zum Bild. Die Aperturblende B ist in dem dargestellten Ausführungsbeispiel auf dem Spiegel S10 angeordnet. Die Größe des Bildfeldes beträgt 13 x 1 mm$^2$ in der Bildebene, wobei $D_x$=13 mm, $D_y$=1 mm, $D_r$=21,25 mm. Die Auflösung beträgt 12 nm und die Baulänge des Systems 2800 mm. Der bildseitige $W_{rms}$ beträgt 0,052 $\lambda$ und der bildseitige Feldradius 7 nm. Der bildseitige freie Arbeitsabstand beträgt 41 mm und der objektseitige freie Arbeitsabstand 729 mm. Der maximale Einfallswinkel $\Theta_{CR(max)}$ auf einen Spiegel S10 bis S80, SK1 und SK2 eines Hauptstrahls zu einem zentralen Feldpunkt beträgt 35°. Der maximale Einfallswinkel $\Theta_{max(max)}$ irgendeines Strahls auf einen Spiegel S10 bis S80, SK1 und SK2 beträgt 39,6°. Der maximale Einfallswinkelbereich $\Delta\Theta_{max}$ auf irgendeinen Spiegel S10 bis S80, SK1 und SK2 beträgt 24,5°. Die Größe des größten Spiegels im Meridionalschnitt beträgt 871 mm, die Größe des größten Spiegels in x-Richtung beträgt 918 mm. Die Spiegel S30, S40, SK1 und SK2 umfassen Öffnungen, die Spiegel S10, S20, S50, S60, S70 und S80 weisen keine Öffnungen auf.

Die optischen Daten des Systems im Code-V-Format können der Tabelle 12 entnommen werden.

Dabei bezeichnet

|  |  |
|---|---|
| Mirror 1: | den Spiegel S10 |
| Mirror 2: | den Spiegel S20 |
| Mirror 3: | den Spiegel S50 |
| Mirror 4: | den Spiegel S60 |
| Mirror 5: | den Spiegel S70 |
| Mirror 6: | den Spiegel S80 |

(fortgesetzt)

Mirror 7:     den Spiegel S30
Mirror 8:     den Spiegel S40
Mirror 9:     den primären Konkavspiegel SK1
Mirror 10:    den sekundären Konkavspiegel SK2

Im zweiten Teil von Tabelle 12 sind die asphärischen Konstanten der einzelnen Spiegelflächen angegeben.

Tabelle 12

| Surface | Radius | Thickness | Mode |
|---------|--------|-----------|------|
| Object | INFINITY | 984.370 | |
| STOP | INFINITY | 0.000 | |
| Mirror 1 | -487.824 | -255.596 | REFL |
| Mirror 2 | -203.99 | 720.214 | REFL |
| Mirror 3 | -618.943 | -342.547 | REFL |
| Mirror 4 | -467.367 | 522.697 | REFL |
| Mirror 5 | 1517.781 | -594.768 | REFL |
| Mirror 6 | 691.924 | 1170.936 | REFL |
| Mirror 7 | 2075.314 | -583.106 | REFL |
| Mirror 8 | 756.671 | 1136.329 | REFL |
| Mirror 9 | -1247.404 | -502.341 | REFL |
| Mirror 10 | 947.118 | 543.813 | REFL |
| Image | INFINITY | 0.000 | |

| Surface | K | A | B | C |
|---------|---|---|---|---|
| Mirror 1 | 0.00000E+00 | 3.07073E-10 | -2.63762E-14 | -4.75987E-19 |
| Mirror 2 | 0.00000E+00 | -5.92526E-09 | -1.01630E-12 | 3.61436E-16 |
| Mirror 3 | 0.00000E+00 | 1.01014E-10 | -8.68729E-16 | 4.12943E-21 |
| Mirror 4 | 0.00000E+00 | 1.63695E-09 | 3.55194E-14 | -6.73526E-19 |
| Mirror 5 | 0.00000E+00 | 3.47124E-08 | 1.00844E-12 | 4.12785E-17 |
| Mirror 6 | 0.00000E+00 | 2.82522E-11 | 1.38881E-16 | -6.42306E-23 |
| Mirror 7 | 0.00000E+00 | -2.11518E-10 | -4.61053E-15 | -1.12662E-19 |
| Mirror 8 | 0.00000E+00 | 6.09426E-11 | 8.83052E-17 | 8.08906E-23 |
| Mirror 9 | 0.00000E+00 | 7.30445E-11 | 1.71628E-16 | 3.00636E-22 |
| Mirror 10 | 0.00000E+00 | -1.78072E-10 | -6.22611 E-17 | 3.97686E-22 |

| Surface | D | E | F | G |
|---------|---|---|---|---|
| Mirror 1 | 1.15793E-22 | -2.70203E-26 | 1.70913E-30 | 0.00000E+00 |
| Mirror 2 | -1.06065E-19 | 1.63883E-23 | -1.10394E-27 | 0.00000E+00 |
| Mirror 3 | -7.94689E-27 | 1.74105E-33 | 1.29251 E-38 | 0.00000E+00 |
| Mirror4 | 7.84526E-24 | -4.94145E-29 | 1.32806E-34 | 0.00000E+00 |
| Mirror 5 | 6.94133E-21 | -6.19939E-25 | 9.05297E-29 | 0.00000E+00 |
| Mirror6 | 8.71534E-27 | -1.78347E-31 | 7.69324E-37 | 0.00000E+00 |
| Mirror 7 | 8.47783E-26 | -5.55624E-30 | -2.20618E-34 | 0.00000E+00 |
| Mirror 8 | 2.92953E-29 | 2.28833E-34 | -1.14558E-40 | 0.00000E+00 |
| Mirror 9 | 2.96880E-28 | 1.02229E-33 | 1.04271E-39 | 0.00000E+00 |
| Mirror 10 | 5.02383E-28 | -2.14813E-33 | 3.31869E-39 | 0.00000E+00 |

Die in den Figuren 11 und 12 gezeigten Systeme zeichnen sich des weiteren dadurch aus, dass es sich um Systeme mit sechs oder mehr Spiegeln handelt, wobei wenigstens ein Spiegel keine Öffnung für den Durchtritt eines Strahlbüschels aufweist und der Spiegel, der keine Öffnung aufweist und den geringsten Abstand zur Objektebene 10 hat, einen Abstand zur Objektebene aufweist, der größer als 15 % der Baulänge des Objektives ist. Durch einen solch großen objektseitigen Arbeitsabstand ergibt sich ausreichender Bauraum für mechanische Komponenten ,z.B. eine Reticlestage oder aber zusätzliche optische Komponenten, z.B. optische Filterelemente, die eine feldabhängige Wirkung erzielen sollen und daher in der Nähe einer Feldebene angeordnet werden müssen. In dem in Figur 11 bzw. Figur 12 gezeigten Ausführungsbeispiel ist der Spiegel, der keine Öffnung aufweist und den geringsten Abstand zur Objektebene entlang der optischen Achse aufweist der Spiegel S20. Der Abstand des Spiegels S20 zur Objektebene 10 ist wiederum durch den Abstand der Vertex V20 des Spiegels S20 zur Objektebene 10 definiert, die Baulänge wie zuvor angegeben.

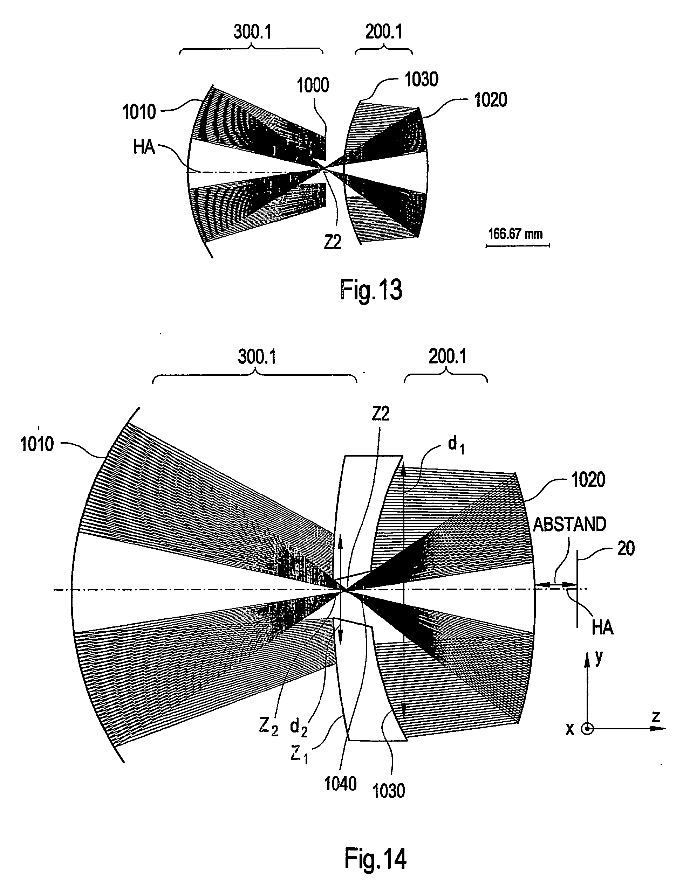

In Figur 13 ist detailliert das zweite Teilsystem 200 und das dritte Teilsystem 300 der in der Anmeldung beschriebenen Projektionsobjektive dargestellt. Beim in Figur 13 dargestellten System bestehend aus zweiten Teilsystem 200 und dritten Teilsystem 300 ist das Zwischenbild Z2 am Ort des Konvexspiegels 1000 des dritten Teilobjektives 300 angeordnet. Das Zwischenbild am Ort des Konvexspiegels gemäß Figur 13 führt zu einer Flächenobskuration von 10% in der Pupille des Projektionsobjektives. Wird hingegen das Zwischenbild Z2 wie in Figur 14 dargestellt so zwischen dem im Lichtweg von der Objektebene zur Bildebene letzten Spiegel 1030 und dem im Lichtweg viertletzten Spiegel 1000 gerechnet von der Bildebene her angeordnet, dass die Bedingung

$$\frac{d1}{d2} = \frac{z1}{z2}$$

eingehalten wird, wobei d1 der Durchmesser des letzten Spiegels 1030 ist und d2 der Durchmesser des viertletzten Spiegels 1000 sowie z1 der Abstand des Zwischenbildes von der ersten Spiegeloberfläche entlang der optischen Achse HA und z2 der Abstand des Zwischenbildes Z2 von der optischen Fläche des Spiegels 1000 entlang der optischen Achse HA ist, so wird die Flächenobskuration minimal und beträgt anstelle von 10% beim Ausführungsbeispiel in Figur 13 beim Ausführungsbeispiel in Figur 14 nur 8%.

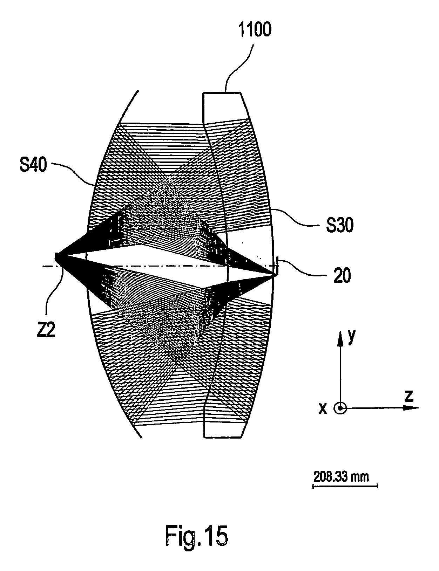

In Figur 15 ist ein System gezeigt, bei dem anstelle eines Spiegelelementes 1020 ein Mangin-Spiegel eingesetzt wird. Ein System mit einem Mangin-Spiegel hat den Vorteil, dass der zur Fassung des Spiegels notwendige Bauraum durch das optische Element 1100 zur Verfügung gestellt wird, durch das das Licht hindurchtreten muss und sich die reflektierende Oberfläche, d. h. die Spiegelfläche auf der Rückseite des optischen Elementes 1100 befindet. Hierdurch kann der wafernächste Spiegel ohne dass die Stabilität beeinträchtigt wird, sehr nahe an der Bildebene angeordnet werden.

Allerdings ist die Verwendung eines Mangin-Spiegels lediglich für Systeme möglich, die mit DUV- oder VUV-Wellenlängen arbeiten, da ein Durchtritt des Lichtes durch das optische Element 1100 notwendig ist und dieses insoweit eine gewisse Transparenz aufweisen muss.

In Figur 16 ist eine Ausführungsform eines Projektionsobjektives mit einem Mangin-Spiegel 1100 gezeigt. Das System ist ein 10-Spiegel-System mit NA=0,7 bei einer Wellenlänge von 193,3 nm. Das erste Objektivteil 100 umfasst sechs Spiegel S10, S20, S50, S60, S70, S80, der dritten Objektivteil umfasst zwei Spiegel S30 und S40 und der zweiten Objektivteil umfasst zwei Konkavspiegel SK1 und SK2, wobei der der Bildebene am nächsten liegende primäre Konkavspiegel SK1 wie zuvor beschrieben ein Mangin-Spiegel 1100 ist. Die Verkleinerung des Systems beträgt 8x und die Auflösung 100 nm. Die Baulänge des Systems 2500 mm. Das ausgeleuchtete Feld in der Bildebene ist ein Ringfeldsegment mit folgenden Größen $D_x$=13mm, $D_y$=1 mm, $D_r$=18,75mm. Der bildseitige $W_{rms}$ beträgt 0,023 λ und die bildseitige Feldkrümmung 59 nm. Der resultierende Obskurationsradius beträgt 28 % des Aperturradius. Der bildseitige optische freie Arbeitsabstand beträgt 10 mm und der objektseitige freie Arbeitsabstand 100 mm. Der maximale Einfallswinkel $\Theta_{CR(max)}$ auf einen Spiegel S10 bis S80, SK1 und SK2 eines Hauptstrahls zu einem zentralen Feldpunkt beträgt 37,6°. Der maximale Einfallswinkel $\Theta_{max(max)}$ irgendeines Strahls auf einen Spiegel S10 bis S80, SK1 und SK2 beträgt 49,4°. Der maximale Einfallswinkelbereich $\Delta\Theta_{max}$ auf irgendeinen Spiegel S10 bis S80, SK1 und SK2 beträgt 22,4°. Die Größe des größten Spiegels im Meridionalschnitt beträgt 889 mm, die Größe des größten Spiegels in x-Richtung beträgt 883 mm.

Die Spiegelabfolge von der Objektebene 10 zur Bildebene 20 ist wie folgt:

konvex - konkav - konkav - konvex - konvex - konkav - konvex - konkav - konkav.

Der Spiegel SK1 ist ein Mangin-Spiegel wie zuvor beschrieben. Der objektseitige Arbeitsabstand beträgt 100 mm und der bildseitige Arbeitsabstand 10 mm. Das erste Teilobjektiv umfasst die Spiegel S10, S20, S50, S60, S70 und S80 und bildet ein Zwischenbild Z1 nahe dem Spiegel S40 aus. Das zweite Teilobjektiv umfasst die Spiegel SK1 und SK2. Das dritte Teilobjektiv umfasst die Spiegel S30 und S40. Die Spiegel S30, S40, SK1 und SK2 umfassen Öffnungen. Die Spiegel S10, S20, S50, S60, S70 und S80 umfassen keine Öffnungen.

Die optischen Daten des Systems gemäß Figur 16 sind in Tabelle 13 angegeben.

Dabei bezeichnet

Mirror 1: den Spiegel S10
Mirror 2: den Spiegel S20
Mirror 3: den Spiegel S50
Mirror 4: den Spiegel S60
Mirror 5: den Spiegel S70
Mirror 6: den Spiegel S80
Mirror 7: den Spiegel S30
Mirror 8: den Spiegel S40
Mirror 9: den primäre Konkavspiegel SK1
Mirror 10: den sekundäre Konkavspiegel SK2

Im zweiten Teil von Tabelle 13 sind die asphärischen Konstanten der einzelnen Spiegelflächen angegeben.

Tabelle 13

| Surface | Radius | Thickness | Mode | n |
|---|---|---|---|---|
| Object | INFINITY | 533.185 | | |
| Mirror 1 | 998.875 | -433.185 | REFL | |
| Mirror 2 | 1507.19 | 966.402 | REFL | |
| Mirror 3 | -1186.286 | -333.216 | REFL | |
| Mirror 4 | -774.298 | 492.401 | REFL | |
| Mirror 5 | 345.555 | -796.615 | REFL | |
| Mirror 6 | 875.806 | 1462.434 | REFL | |
| STOP | INFINITY | 0.000 | | |
| Mirror 7 | 2012.09 | -663.855 | REFL | |
| Mirror 8 | 868.41 | 1161.917 | REFL | |
| Sphere | -1142.612 | 99.999 | REFR | 1.560491 |
| Mirror 9 | -1173.131 | -99.999 | REFL | 1.560491 |
| Sphere | -1142.612 | -398.063 | REFR | |
| Mirror 10 | 864.134 | 398.063 | REFL | |
| Sphere | -1142.612 | 99.999 | REFR | 1.560491 |
| Asphere | -1173.131 | 9.950 | REFR | |
| Image | INFINITY | 0.000 | | |

| Surface | K | A | B | C |
|---|---|---|---|---|
| Mirror 1 | 0.00000E+00 | -4.63661 E-10 | 1.49173E-15 | 1.17129E-20 |
| Mirror 2 | 0.00000E+00 | -6.57662E-11 | -4.99638E-17 | 4.57647E-23 |
| Mirror 3 | 0.00000E+00 | 1.36485E-11 | -1.81657E-17 | 5.69451E-23 |
| Mirror 4 | 0.00000E+00 | 4.34663E-10 | -1.84433E-15 | 1.91302E-20 |
| Mirror 5 | 0.00000E+00 | -2.90145E-10 | -4.30363E-14 | 2.45843E-17 |
| Mirror 6 | 0.00000E+00 | -8.22539E-11 | 5.31955E-18 | -3.31349E-22 |
| Mirror 7 | 0.00000E+00 | 8.95414E-10 | 0.00000E+00 | 0.00000E+00 |
| Mirror 8 | 0.00000E+00 | 6.40715E-11 | 7.25579E-17 | 1.14913E-22 |
| Mirror 9 | 0.00000E+00 | 1.11862E-10 | 9.94515E-17 | 3.86584E-22 |
| Mirror 10 | 0.00000E+00 | -1.92745E-10 | 3.60396E-16 | 2.01867E-22 |
| Asphere | 0.00000E+00 | 1.11862E-10 | 9.94515E-17 | 3.86584E-22 |

| Surface | D | E | F | G |
|---|---|---|---|---|
| Mirror 1 | -1.03763E-25 | -3.90507E-32 | 0.00000E+00 | 0.00000E+00 |

(fortgesetzt)

| Surface | D | E | F | G |
|---|---|---|---|---|
| Mirror 2 | -5.45358E-30 | -1.74383E-34 | 0.00000E+00 | 0.00000E+00 |
| Mirror 3 | -7.91336E-29 | 9.23378E-36 | 0.00000E+00 | 0.00000E+00 |
| Mirror 4 | -1.21633E-25 | 3.53832E-31 | 0.00000E+00 | 0.00000E+00 |
| Mirror 5 | -1.57578E-21 | 2.19218E-25 | 0.00000E+00 | 0.00000E+00 |
| Mirror 6 | 3.61420E-28 | 5.96686E-34 | 0.00000E+00 | 0.00000E+00 |
| Mirror 7 | 9.11424E-25 | -4.57429E-30 | 0.00000E+00 | 0.00000E+00 |
| Mirror 8 | 2.64566E-28 | -1.96096E-34 | 1.92729E-39 | 0.00000E+00 |
| Mirror 9 | 5.06626E-28 | -1.28846E-33 | 1.47731E-38 | 0.00000E+00 |
| Mirror 10 | 7.88027E-28 | -2.94908E-33 | 2.20072E-38 | 0.00000E+00 |
| Asphere | 5.06626E-28 | -1.28846E-33 | 1.47731 E-38 | 0.00000E+00 |

Um niedrige Einfallswinkel bei einem hochaperturigen System realisieren zu können, ist es vorteilhaft, wenn der im Lichtweg zweite Spiegel im ersten Teilobjektiv nicht konvex wie in der US 6,750,948 ausgebildet ist, sondern als Konkavspiegel. Die Ausbildung des im Lichtweg zweiten Spiegels des ersten Teilobjektives als Konkavspiegel führt zu niedrigen Einfallswinkeln auf allen Spiegeln. Niedrige Einfallswinkel erleichtern das Herstellen der Beschichtung, da in diesem Fall keine laterale Schichtdickenvariation auf dem Spiegel hergestellt werden muß, sondern die Schichten eine über dem Spiegel konstante Dicke aufweisen können. Außerdem ergibt sich für niedrige Einfallswinkel eine größere Reflektivität.

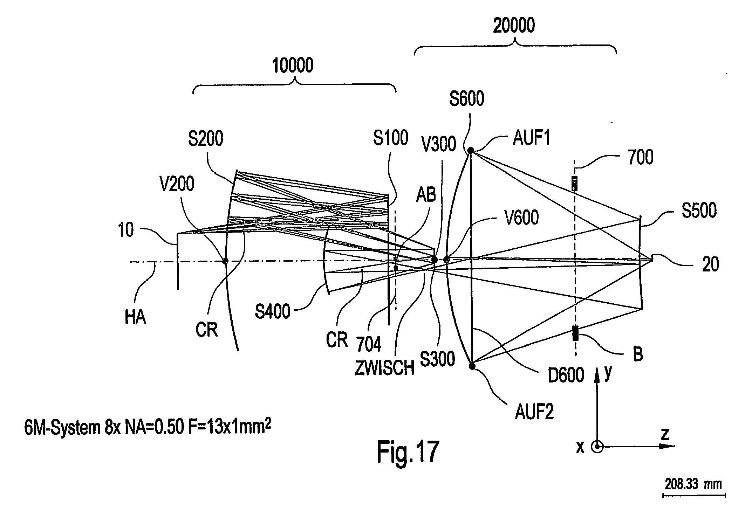

In Figur 17 ist ein Ausführungsbeispiel eines 6-Spiegelsystems gezeigt, bei dem, um niedrige Einfallswinkel zu erhalten, der zweite Spiegel S200 im Strahlengang von der Objektebene 10 zur Bildebene 20 konkav ausgebildet ist. Das in Figur 14 gezeigte 6-Spiegelsystem weist einen Abbildungsfaktor von 8x und eine bildseitige numerische Apertur von NA=0.5 bei einer Betriebswellenlänge von 13,5 nm auf. Die Aperturblende B ist im Strahlengang zwischen den im Lichtweg von der Objektebene zur Bildebene fünften Spiegel S500 und dem sechsten Spiegel S600 angeordnet. Die die Obskuration definierende Abschattungsblende AB liegt im Strahlengang zwischen dem dritten Spiegel S300 und dem vierten Spiegel S400. Durch die Anordnung der Abschattungsblende AB zwischen dem dritten Spiegel S300 und dem vierten Spiegel S400 wird eine feldunabhängige Obskuration von ungefähr 25 % bei voller Aperturöffnung erreicht.

Das Bildfeld hat eine Größe von 13 x 1 mm, d. h. die bildseitige Feldbreite $D_x$ beträgt 13 mm, die bildseitige Feldlänge $D_y$ beträgt 1 mm und der bildseitige Feldradius $D_r$ 9,75 mm. Die Auflösung beträgt 17 nm, die Baulänge des Systems 1521 mm. Der bildseitige $W_{rms}$ beträgt 0,025 λ, die bildseitige Feldkrümmung 10 nm. Der resultierende Obskurationsradius, der eine feldunabhängige Obskuration zur Verfügung stellt beträgt 25 % des Aperturradius. Der bildseitige freie Arbeitsabstand beträgt 39 mm und der objektseitige freie Arbeitsabstand 158 mm. Der maximale Winkel $\Theta_{CR(max)}$ auf einen der Spiegel S100, S200, S300, S400, S500 und S600 zum Hauptstrahl CR des zentralen Feldpunktes beträgt 12,3°. Der maximale Einfallswinkel $\Theta_{max(max)}$ auf irgendeinen Spiegel S100, S200, S300, S400, S500 und S600 beträgt 16,9°. Der maximale Winkelbereich $\Delta\Theta_{max}$ der Einfallswinkel auf irgendeinen Spiegel S100, S200, S300, S400, S500 und S600 beträgt 7,5°. Die Größe des größten Spiegels im Meridionalschnitt beträgt 675 mm. Die Größe des größten Spiegels in x-Richtung beträgt 687 mm. Wie zuvor beschrieben, beträgt der Einfallswinkel des Hauptstrahles zum zentralen Feldpunkt auf beiden Spiegeln deutlich weniger als 20° relativ zur lokalen Oberflächennormalen. Der maximale Einfallswinkel des Hauptstrahls auf den zentralen Feldpunkt tritt auf dem Spiegel S300 auf und beträgt 12,3° wie oben beschrieben. Wie oben beschrieben wird durch den niedrigen Einfallswinkel eine hohe Transmissivität des gesamten Systems erreicht. Insbesondere nimmt die Reflektivität der p-polarisierten Komponente des Lichtes ab, in dem Maß in dem der Einfallswinkel wächst.

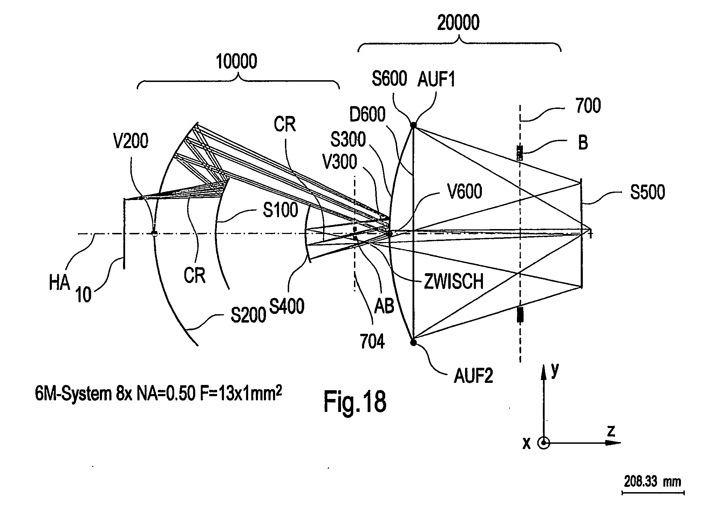

Die in den Figuren 17 und 18 gezeigten 6-Spiegel-Systeme können auch in Systeme mit Teilobjektiven aufgeteilt werden.

Hierbei umfasst das erste Teilobjektiv 10000 die Spiegel S100, S200, S300, S400 und das zweite Teilobjektive 20000 die Spiegel S500 und S600. Das erste Teilobjektiv 10000 entspricht im wesentlichen dem ersten Teilobjektiv 100 aus den Figuren 1 bis 12 und das zweite Teilobjektiv dem dritten Teilobjektiv 300 aus den Figuren 1 bis 12, d.h. die 6-Spiegelobjektive gemäß der Figuren 17 und 18 haben keine Relay-Gruppe. Durch die Aufteilung in zwei Teilobjektive werden 2 Pupillenebenen und ein Zwischenbild zur Verfügung gestellt. Der Spiegel S100 ist ein Konkavspiegel, der Spiegel S200 ist ein Konkavspiegel, der Spiegel S300 ist ein Konvexspiegel, der Spiegel S400 ist ein Konkavspiegel, der Spiegel S500 ist ein Konvexspiegel und der Spiegel S600 ist ein Konkavspiegel. Die Spiegel S500 und S600 umfassen Öffnungen, wohingegen die Spiegel S100, S200, S300 und S400 keine Öffnungen aufweisen.

Durch die Anordnung der Abschattungsblende, die den inneren Radius des ausgeleuchteten Feldes und damit die Obskuration festlegt, zwischen zwei Spiegeln, d.h. entfernt von einem Spiegel, wird erreicht, dass die Abschattungsblende nur ein einziges Mal im Lichtweg des abbildenden Lichtbündels durchlaufen wird und dadurch keine Vignettierungseffekte auftreten, mechanisch einen genügend großen Bauraum zur Verfügung hat, der nicht durch Spiegelbauräume eingeengt wird, und zudem leicht auswechselbar ist, da die Abschattungsblende nicht durch eine auf einem Spiegel aufgebrachte Antireflexbeschichtung realisiert wird.

Bei den im Stand der Technik gezeigten Systemen lag die Abschattungsblende, die die feldunabhängige Obskuration definiert, stets auf einem Spiegel und wurde durch eine Antireflexbeschichtung realisiert, so dass eine Variation der Abschattungsblende nur durch Auswechseln der Blende möglich ist.

Das in Figur 17 gezeigte System zeigt die Aperturblende B und die Abschattungsblende AB in zwei verschiedenen zueinander konjugierten Blendenebenen, wobei diese Ebenen entfernt zu einem Spiegel sind. Die Aperturblende B liegt in der Blendenebene 700 und die Abschattungsblende in der Blendenebene 704. Die Blendenebenen sind konjugiert zur Eintrittspupille des Projektionsobjektives und ergeben sich als Schnittpunkt des Hauptstrahles, des sog. Chief-rays CR mit der optischen Achse HA des Mikrolithographie-Projektionsobjektives.

Die genauen Daten des in Figur 17 gezeigten Systems sind in Tabelle 14 wiedergegeben. In Tabelle 14 bezeichnet:

Objekt: die Objektebene
Mirror 1: Spiegel S100
Mirror 2: Spiegel S200
Mirror 3: Spiegel S300
Mirror 4: Spiegel S400
Mirror 5: Spiegel S500
STOP: Aperturblende
Mirror 6: Spiegel S600
Image: die Bildebene

Im unteren Teil der Tabelle 14 sind die asphärischen Konstanten angeben.

Tabelle 14:

| Surface | Radius | Thickness | Mode |
|---------|--------|-----------|------|
| Object | INFINITY | 670.918 | |
| Mirror 1 | -119254.844 | -513.109 | REFL |
| Mirror 2 | 1058.494 | 657.514 | REFL |
| Mirror 3 | 236.520 | -352.038 | REFL |
| Mirror 4 | 406.062 | 1018.792 | REFL |
| Mirror 5 | 2416.511 | -213.326 | REFL |
| STOP | INFINITY | -406.623 | |
| Mirror 6 | 813.393 | 659.142 | REFL |
| Image | INFINITY | 0 | |

| Surface | K | A | B |
|---------|---|---|---|
| Mirror 1 | 0.00000E+00 | -1.71227E-10 | 1.21604E-16 |
| Mirror 2 | 0.00000E+00 | -3.98375E-11 | -5.16759E-17 |
| Mirror 3 | 0.00000E+00 | 2.49910E-09 | 5.14762E-13 |
| Mirror 4 | 0.00000E+00 | 6.84051E-10 | 5.83113E-15 |
| Mirror 5 | 0.00000E+00 | 1.05935E-09 | 2.78882E-15 |
| Mirror 6 | 0.00000E+00 | 2.33770E-11 | 5.31421 E-17 |

| Surface | C | D | E |
|---------|---|---|---|
| Mirror 1 | -1.63049E-21 | 4.61626E-27 | 0.00000E+00 |
| Mirror 2 | -1.23197E-22 | -2.34001 E-28 | 0.00000E+00 |

(fortgesetzt)

| Surface | C | D | E |
|---|---|---|---|
| Mirror 3 | -1.78225E-17 | 7.40434E-22 | 0.00000E+00 |
| Mirror 4 | 5.23435E-20 | 3.88486E-25 | 5.48925E-30 |
| Mirror 5 | 1.34567E-20 | 5.03919E-26 | 8.14921 E-31 |
| Mirror 6 | 9.34234E-23 | 1.04943E-28 | 4.61313E-34 |

In Figur 18 eines 6-Spiegel-Systems gezeigt, bei dem der zweite Spiegel S200 als Konkavspiegel zur Erzeugung niedriger Einfallswinkel ausgebildet ist. Das in Figur 18 gezeigte 6-Spiegel-System weist einen Abbildungsfakor von 8x und eine bildseitige numerische Apertur von NA=0,5 bei einer Wellenlänge von 13,5 nm auf. Die Größe des Bildfeldes beträgt 13 x 1 mm$^2$, d. h. die bildseitige Feldbreite $D_x$ beträgt 13 mm, die bildseitige Feldlänge $D_y$ beträgt 1 mm und der bildseitige Feldradius $D_r$ 12,5 mm. Die Auflösung beträgt 17 nm, die Baulänge des Objektives 1500 mm. Der bildseitige $W_{rms}$ beträgt 0,02 λ, die bildseitige Feldkrümmung 7 nm.

Die Spiegel S500 und S600 umfassen Öffnungen. Die Spiegel S100, S200, S300, S400 weisen keine Öffnungen auf. Der resultierende Obskurationsradius, der eine feldunabhängige Obskuration zur Verfügung stellt beträgt 22 % des Aperturradius. Der bildseitige freie Arbeitsabstand beträgt 30 mm und der objektseitige freie Arbeitsabstand 100 mm. Der maximale Einfallswinkel $\Theta_{CR(max)}$ auf einen der Spiegel S100, S200, S300, S400, S500 und S600 zum Hauptstrahl CR des zentralen Feldpunktes beträgt 27,4°. Der maximale Winkel $\Theta_{max(max)}$ auf irgendeinen Spiegel S100, S200, S300, S400, S500 und S600 beträgt 34,9°. Der maximale Winkelbereich $\Delta\Theta_{max}$ auf irgendeinen Spiegel S100, S200, S300, S400, S500 und S600 beträgt 15°. Die Größe des größten Spiegels im Meridionalschnitt beträgt 664 mm. Die Größe des größten Spiegels in x-Richtung beträgt 677 mm.

Auch bei diesem Ausführungsbeispiel liegt die Aperturblende B zwischen dem fünften Spiegel S500 und dem sechsten Spiegel S600 und die Abschattungsblende AB zwischen dem dritten Spiegel S300 und dem vierten Spiegel S400. Zwischen den Spiegeln S500 und S600 ist die Aperturblende B positioniert.

Der Unterschied des in Figur 16 und 17 gezeigten System liegt in der Strahlführung im Bereich der ersten beiden Spiegel S100, S200. Während beim Ausführungsbeispiel gemäß Figur 17 der dritte Spiegel physikalisch zwischen dem ersten und zweiten Spiegel liegt und sich die Strahlengänge im Bereich zwischen erstem und zweitem Spiegel überschneiden, sind beim Ausführungsbeispiel gemäß Figur 18 die Spiegelgruppen voneinander getrennt und die Strahlengänge überschneiden sich nicht.

Die Systemdaten des in Figur 18 gezeigten Ausführungsbeispiel können der nachfolgenden Tabelle 15 entnommen werden.

In Tabelle 15 bezeichnet:

Objekt: Objektebene
Mirror 1: Spiegel S100
Mirror 2: Spiegel S200
Mirror 3: Spiegel S300
Mirror 4: Spiegel S400
Mirror 5: Spiegel S500
STOP: Aperturblende
Mirror 6: Spiegel S600
Image: Bildebene

Die asphärischen Konstanten der einzelnen Spiegelflächen sind im unteren Teil von Tabelle 15 angegeben.

| Surface | Radius | Thickness | Mode |
|---|---|---|---|
| Object | INFINITY | 294.339 | |
| Mirror 1 | 343.317 | -194.339 | REFL |
| Mirror 2 | 485.792 | 754.54 | REFL |
| Mirror 3 | 270.258 | -275.539 | REFL |
| Mirror 4 | 290.188 | 890.999 | REFL |
| Mirror 5 | 9383.676 | -194.679 | REFL |
| STOP | INFINITY | -420.681 | |
| Mirror 6 | 841.549 | 645.36 | REFL |

(fortgesetzt)

| Surface | Radius | Thickness | Mode | |
|---------|--------|-----------|------|---|
| Image | INFINITY | 0 | | |

| Surface | K | A | B | C |
|---------|---|---|---|---|
| Mirror 1 | 0.00000E+00 | -4.96680E-09 | 8.07536E-14 | -5.21657E-18 |
| Mirror 2 | 0.00000E+00 | -2.08389E-10 | 9.04247E-16 | -1.82476E-20 |
| Mirror 3 | 0.00000E+00 | -8.58156E-10 | -1.09899E-14 | 1.23347E-16 |
| Mirror 4 | 0.00000E+00 | -3.90441 E-10 | -7.66964E-15 | 8.88342E-20 |
| Mirror 5 | 0.00000E+00 | 9.99387E-10 | 2.33248E-15 | 8.58665E-21 |
| Mirror 6 | 0.00000E+00 | 4.04329E-11 | 7.49328E-17 | 1.16246E-22 |

| Surface | D | E | F | G |
|---------|---|---|---|---|
| Mirror 1 | 1.71166E-22 | -3.14607E-27 | 2.43204E-32 | 0.00000E+00 |
| Mirror 2 | 9.83920E-26 | -3.32658E-31 | 0.00000E+00 | 0.00000E+00 |
| Mirror 3 | -9.03339E-20 | 3.25799E-23 | -4.65457E-27 | 0.00000E+00 |
| Mirror 4 | -3.20552E-23 | 3.31626E-27 | -1.39847E-31 | 0.00000E+00 |
| Mirror 5 | 3.37347E-26 | 3.00073E-31 | 3.53144E-37 | 0.00000E+00 |
| Mirror 6 | 1.88402E-28 | 1.78827E-34 | 9.03324E-40 | 0.00000E+00 |

Die in den Figuren 17 und 18 gezeigten 6-Spiegel Systeme mit einem ersten Subobjektiv, weisen nur ein Zwischenbild aufweist, weswegen das erste Subobjektiv mit dem ersten Teilobjektiv 10000 und das zweite Subobjektiv mit dem zweiten Teilobjektiv 20000 zusammenfällt. Das erste Subobjektiv umfasst die vier Spiegel S100, S200, S300, S400 und das zweite Subobjektiv die Spiegel S500 und S600. Die in den Figuren 17 und 18 gezeigten Objektive haben folgende im nachfolgenden beschriebenen vorteilhafte Eigenschaften.

Zum ersten weist das System gemäß Figur 17 eine bildseitige numerische Apertur NA größer 0,4 und die Einfallswinkel des Hauptstrahles des zentralen Feldpunktes sind auf allen Spiegeln kleiner 20° zur lokalen Flächennormalen. Der maximale Einfallswinkel des Hauptstrahles des zentralen Feldpunktes tritt bei dem in Figur 17 gezeigten System auf dem dritten Spiegel S300 auf und beträgt lediglich 12.3°.Dadurch, dass die Einfallswinkeln auf den Spiegeln klein gehalten werden, ,ergibt sich eine höhere Reflektivität des Spiegels, so daß eine höhere Transmission des Gesamtsystems erreicht wird. Insbesondere verringert sich die Reflektivität der p-Polarisationskomponente des Lichts mit zunehmendem Einfallswinkel

Sowohl das System gemäß Figur 17 wie das System gemäß Figur 18 zeichnen sich durch die nachfolgenden vorteilhaften Eigenschaften aus,

Um eine möglichst kleine Obskuration zu erreichen, beträgt der Abstand entlang der optischen Achse HA des Zwischenbildes ZWISCH zum geometrisch nächstenliegenden Spiegel der Feldgruppe, also des ersten Teilobjektives 10000 weniger als 15 % der Baulänge des Systems. Der geometrisch nächstliegende Spiegel der Feldgruppe ist in den vorliegenden Ausführungsbeispielen gemäß Figur 17 und 18 der Spiegel S300. Der Abstand vom Zwischenbild ZWISCH zum nächstliegendem Spiegel S300 wird wie in allen vorangegangenen Ausführungsbeispielen durch den Abstand der Vertex V300 des Spiegels S300 zum Zwischenbild ZWISCH entlang der optischen Achse gegeben.

Alternativ oder zusätzlich zu der obigen Maßnahme kann, um eine kleine Obskuration zu erreichen vorgesehen sein, dass der Abstand entlang der optischen Achse HA des Zwischenbildes ZWISCH zum geometrisch nächstenliegenden Spiegel der Aperturgruppe, also des zweiten Teilobjektives 20000 weniger als 8 % der Baulänge des Systems beträgt. Der geometrisch nächstliegende Spiegel der Aperturgruppe ist in den vorliegenden Ausführungsbeispielen gemäß Figur 17 oder 18 der Spiegel S600. Der Abstand von Zwischenbild ZWISCH zum nächstliegendem Spiegel S600 wird wie in allen vorangegangenen Ausführungsbeispielen durch den Abstand der Vertex V600 des Spiegels S600 zum Zwischenbild ZWISCH entlang der optischen Achse gegeben.

Eine weitere vorteilhafte Maßnahme gemäß der Erfindung ist, dass die Feldgruppe der in den Figuren 17 und 18 gezeigten Systeme eine räumliche Ausdehnung, d.h. der Abstand von der Vertex V200 des der Objektebene 10 am nächsten liegenden Spiegels S200 der Feldgruppe zur Vertex V300 des der Bildebene 20 am nächsten liegenden Spiegels S300 größer als 16% insbesondere größer als 18% der Baulänge des Systems ist.

Ganz bevorzugt ist bei den in den Figuren 17 und 18 gezeigten Systemen, dass das Verhältnis des Durchmessers D600 des Spiegels S600 mit dem größten Durchmesser im Projektionsobjektives zur Baulänge des Systems kleiner ist als das 0.9-fache der bildseitigen numerische Apertur. Unter dem Durchmesser eines Spiegels wird in dieser Anmeldung der senkrecht zur optischen Achse gemessene Abstand zwischen den Auftreffpunkten AUF1, AUF2 der Randstrahlen auf den Spiegel S600 in der Meridionalebene verstanden.

Mit den zuvor angegeben Mikrolithographie-Projektionsobjektiven können für Systeme mit sechs und mehr Spiegeln Objektive mit einer hohen numerischen Apertur, bevorzugt im Bereich NA=0,4-0,8, insbesondere NA=0,5 - 0,75 angegeben werden. Des Weiteren zeichnen sich diese Systeme durch sehr große Abbildungsfaktor, d.h. Verkleinerungen aus, größer als 4x. Durch besonders geeignete Maßnahmen wie die Wahl des Ortes des Zwischenbildes lässt sich der obskurierte Flächenanteil in der Pupille auf unter 5% beschränken.

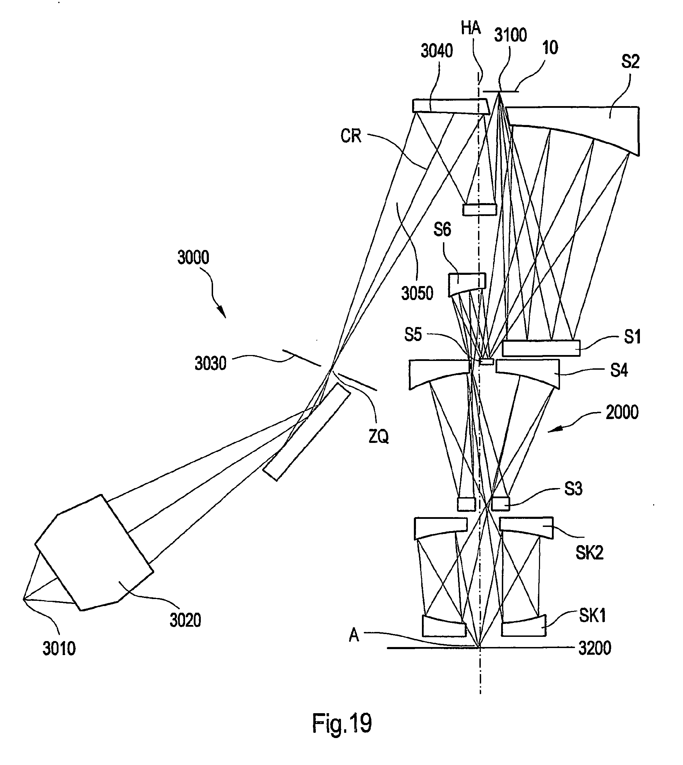

In Figur 19 ist der Aufbau einer Projektionsbelichtungsanlage mit einem weiteren erfindungsgemäßen 8-Spiegel-Objektiv mit obskurierter Pupille dargestellt.

Das 8-Spiegel-Objektiv ist mit der Bezugsziffer 2000 gekennzeichnet und das Beleuchtungssystem mit der Bezugsziffer 3000.

Das Beleuchtungssystem 3000 umfasst eine Lichtquelle 3010 sowie einen grazing-incidence-Kollector 3010, wie er beispielsweise in der EP 1 225 481 beschrieben ist. An diesen schließt sich ein spektrales Filterelement 3020 an, das als diffraktiver Spektralfilter ausgelegt sein kann. Zusammen mit einer Blende 3030 in der Nähe eines Zwischenbildes ZQ der Lichtquelle kann damit unerwünscht Strahlung mit beispielsweise Wellenlängen wesentlich größer als der gewünschen Wellenlänge vom Eintritt in den Teil des hinter der Blende 3030 liegende Beleuchtungssystems abgehalten werden. Im Beleuchtungssystem ist im Strahlengang nach dem diffraktiven Spektralfilter 3030 ein erster gerasteter Spiegel mit ersten Rasterelementen, sog. Feldfacetten 3040 angeordnet. Die Feldfacetten zerlegen das vom Spektralfilter einfallende Lichtbüschel 3050 in eine Vielzahl von Einzellichtbüscheln mit jeweils zugeordneter sekundärer Lichtquelle. Die sekundären Lichtquellen kommen in der Nähe der einzelnen Rasterelemte des zweiten gerasterten Spiegels zum Liegen. Die Rasterelemente des zweiten gerasterten Spiegels werden als Pupillenfacetten bezeichnet.

Doppel facettierte Beleuchtungssysteme sind beispielsweise aus der US 6,195,201 bekannt geworden, bei denen die sog. Feldrasterelemente bzw. Feldfacetten die Form des auszuleuchtenden Feldes in der Objektebene aufweisen und damit die Form des Feldes in der Objektebene bestimmen. Ist das Feld in der Objektebene bspw. ein kreisbogenförmiges Feld, so sind die Feldfacetten ebenfalls bogenförmig ausgebildet.

Alternativ können die Feldrasterelemente rechteckig ausgebildet sein. Ein derartiges Beleuchtungssystem ist in der US 6,198,793 gezeigt. Bei diesem Beleuchtungssytem wird die Feldformung mit Hilfe eines feldformenden Spiegels vorgenommen.

Die Objektebene 3100 in die das Feld ausgebildet wird, fällt mit der Objektebene des Projektionsobjektives zusammen. Diese bildet das Feld in der Objektebene in ein Feld in der Bildebene 3200 ab. Bei dem Projektionsobjektives 2000 handelt es sich um ein Projektionsobjektiv gemäß Ausführungsbeispiel in Figur 2. Demgemäß sind die Spiegel mit den selben Bezugsziffern bezeichnet wie im Ausführungsbeispiel Figur 2, d.h. beispielsweise der im Lichtweg erste Spiegel ist mit S1 bezeichnet. Betreffend die Einzelheiten des Projektionsobjektives wird auf die Beschreibung zu Figur 2 verwiesen. Das Projektionsobjektiv 2000 umfasst 8 Spiegel S1 bis S6, SK1 und SK2 und weist eine bildseitige numerische Apertur NA=0,5 bei einer Betriebswellenlänge von 13,5 nm auf. Die Spiegel S1 bis S6, SK1 und SK2 sind alle asphärische Spiegel. Das Projektionsobjektiv projiziert Strahlung aus der Objektebene 3100 in die Bildebene 3200 mit einer Verkleinerung bzw. einem Abbildungsfaktor 4x und einer Auflösung von 17 nm. Die optische Achse, zu der das Projektionsobjektiv symmetrisch ist, ist mit HA bezeichnet und die Gesamtlänge des Systems von der Objektebene 2100 bis zur Bildebene 3200 beträgt 1711 mm. Das Projektionsobjektiv 2000 weist ein Ringfeldsegment auf. Die bildseitige Breite des Ringfeldsegments $D_x$ beträgt 13 mm, die bildseitige Feldlänge $D_y$ beträgt 1 mm und der bildseitige Feldradius $D_r$ 13 mm. Der bildseitige $W_{rms}$ beträgt 0,04 $\lambda$, die bildseitige Feldkrümmung 12 nm.

Die Spiegelabfolge im Lichtweg bzw. Strahlengang von der Objektebene zur Bildebene ist wie folgt:

Spiegel S1 ist ein Konvexspiegel
Spiegel S2 ist ein Konkavspiegel
Spiegel S5 ist ein Konvexspiegel
Spiegel S6 ist ein Konkavspiegel
Spiegel S3 ist ein Konvexspiegel
Spiegel S4 ist ein Konkavspiegel
Spiegel SK1 ist ein Konkavspiegel
Spiegel SK2 ist ein Konkavspiegel.

Die Spiegel S3, S4, SK1 und SK2 umfassen Öffnungen. Die Spiegel S1, S2, S5 und S6 weisen keine Öffnungen auf. Der resultierende Obskurationsradius, der eine feldunabhängige Obskuration zur Verfügung stellt beträgt 36 % des Aperturradius. Der bildseitige freie Arbeitsabstand beträgt 69 mm und der objektseitige freie Arbeitsabstand 100 mm. Der maximale Einfallswinkel $\Theta_{CR(max)}$ auf einen der Spiegel S1 bis S6, SK1 und SK2 zum Hauptstrahl CR des zentralen Feldpunktes beträgt 19,4°. Der maximale Winkel $\Theta_{max(max)}$ auf irgendeinen Spiegel S1 bis S6, SK1 und SK2 beträgt 21,8°. Der maximale Winkelbereich $\Delta\Theta_{max}$ auf irgendeinen Spiegel S1 bis S6, SK1 und SK2 beträgt 15°. Die Größe des größten Spiegels im Meridionalschnitt beträgt 385 mm. Die Größe des größten Spiegels in x-Richtung beträgt 616 mm. Das Projektionsobjektiv 2000 ist in insgesamt 3 Teilobjektivs geteilt und hat demgemäß drei Pupillenebenen und zwei Zwischenbilder. Wenigstens eine der Pupillenebene ist zur Anordnung einer Aperturblende zugänglich. Wenigstens eine weitere Pupillenebene ist zugänglich zur Anordnung der Obskurationsblende bzw. Abschattungsblende, bspw. kann eine Abschattungsblende zwischen den Spiegeln S1 und S2 angeordnet werden.

In der Bildebene 3200 kann ein Substrat mit einer lichtempfindlichen Schicht, beispielsweise ein Wafer angeordnet sein.

Die in Figur 19 gezeigte Projektionsbelichtungsanlage zeichnet sich dadurch aus, dass die Hauptstrahlen divergent in die Eintrittspupille des Projektionsobjektives, die mit der Austrittspupille des Beleuchtungssystems zusammenfällt eintreten. Dies bedeutet, dass die Eintrittspupille des Projektionsobjektives im Lichtweg von der Lichtquelle zur Objektebene 3100 vor der Objektebene 3100 angeordnet ist.

Betreffend Projektionssysteme mit negativer Eintrittspupille wird auf die WO2004/010224 verwiesen, deren Offenbarungsgehalt vollumfänglich in die vorliegende Anmeldung mit aufgenommen wird.

Mit der erfindungsgemäßen Projektionsbelichtungsanlage kann dann durch sukzessive Belichtung von einer oder mehreren lichtempfindlichen Schichten und deren ausschließende Entwicklung ein mikroelektronisches Bauteil hergestellt werden.

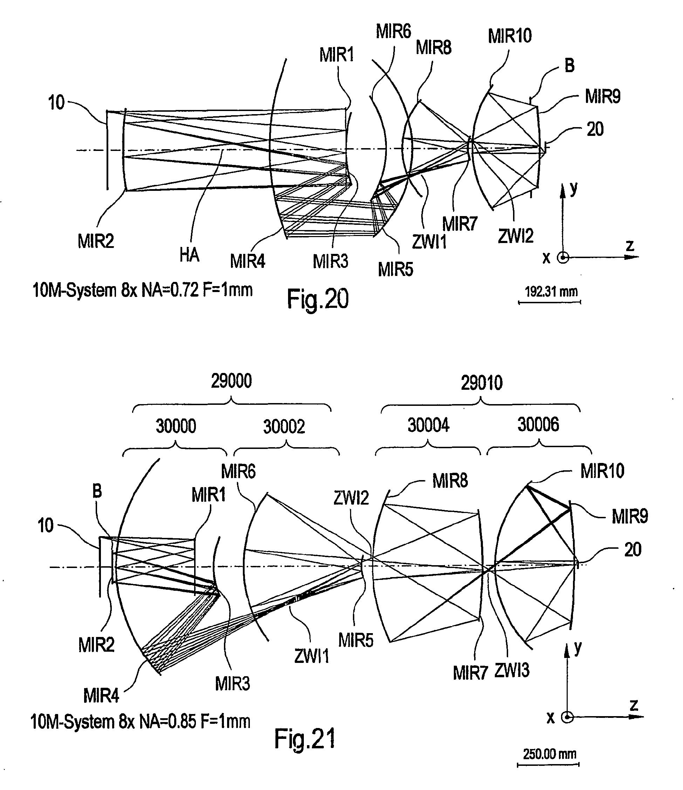

In den Figuren 20 bis 22 sind Ausführungsbeispiele für Objektive dargestellt, die bei einer Wellenlänge von $\leq$ 193 nm, insbesondere im Wellenlängenbereich $\leq$ 157 nm, insbesondere $\leq$ 100 nm Wellenlänge die Abbildung von Strukturen mit Strukturgrößen kleiner 50 nm erlauben, wobei bildseitige Aperturen NA größer 0,7 vorliegen.

In Figur 20 ist ein erstes Ausführungsbeispiel eines derartigen Objektives gezeigt. Das Objektiv umfasst zehn Spiegel, einen ersten Spiegel MIR1, einen zweiten Spiegel MIR2, einen dritten Spiegel MIR3, einen vierten Spiegel MIR4, einen fünften Spiegel MIR5, einen sechsten Spiegel MIR6, einen siebten Spiegel MIR7, einen achten Spiegel MIR8, einen neunten Spiegel MIR9 sowie einen zehnten Spiegel MIR10. Das erste Ausführungsbeispiel besteht aus einem ersten Subobjektiv mit den acht Spiegeln MIR1, MIR2, MIR3, MIR4, MIR5, MIR6, MIR7, MIR8 und der Spiegelfolge konkav-konkav-konvex-konkav-konkav-konkav-konvex-konvex-konkav. Das zweite Subobjektiv umfasst die Spiegel MIR9 und MIR10, die als Konkavspiegel ausgebildet sind. Die bildseitige numerische Apertur ist NA=0.72 bei einer Verkleinerung, d.h. einem Abbildungsmaßstab von 8x und einer Betriebswellenlänge von 100 nm. Die optischen Daten des Systems sind in Tabelle 16 angegeben. Das System weist zwei Zwischenbilder ZWI1 und ZWI2 auf. Die Objektebene ist wie in den vorangegangenen Figuren mit 10, die Bildebene mit 20, die Aperturblende mit B bezeichnet. Die Bildfeldgröße beträgt 13 x 1 mm$^2$ in der Bildebene . Dieses Ausführungsbeispiel zeichnet sich durch eine gute Korrekturmöglichkeit für feldabhängige Bildfehler aus. Die bildseitige Feldbreite $D_x$ beträgt 13 mm, die bildseitige Feldlänge $D_y$ beträgt 1 mm und der bildseitige Feldradius $D_r$ 15 mm. Die Auflösung des Projektionssystems gemäß Tabelle 16 beträgt 49 nm. Der bildseitige $W_{RMS}$=0,0036 $\lambda$, die bildseitige Feldkrümmung 2 nm und die Baulänge 1374 mm. Die Spiegel MIR7, MIR8, MIR9 und MIR 10 umfassen Öffnungen. Die Spiegel MIR1, MIR2, MIR3, MIR4, MIR5 und MIR6 umfassen keine Öffnungen. Der resultierende Obskurationsradius, der eine feldunabhängige Obskuration zur Verfügung stellt beträgt 32 % des Aperturradius. Der bildseitige freie Arbeitsabstand beträgt 20 mm und der objektseitige freie Arbeitsabstand 50 mm. Der maximale Einfallswinkel auf einen der Spiegel MIR1 bis MIR10 zum Hauptstrahl des zentralen Feldpunktes beträgt 48°. Der maximale Winkel auf irgendeinen Spiegel MIR1 bis MIR10 beträgt 48,9°. Der maximale Winkelbereich auf irgendeinen Spiegel MIR1 bis MIR10 beträgt 35,6°. Die Größe des größten Spiegels im Meridionalschnitt beträgt 366 mm. Die Größe des größten Spiegels in x-Richtung beträgt 378 mm.

Die Spiegel des Projektionsobjektives sind derart aufgebaut, dass zwei Teilobjektive ausgebildet werden. Das erste Teilobjektiv umfasst die Spiegel MIR1 bis MIR8 und bildet ein erstes Zwischenbild ZWI1 zwischen dem Spiegel MIR6 und MIR7 aus. Das erste Teilobjektiv bildet des Weiteren ein zweites Zwischenbild ZWI2 in einer Position nahe dem Spiegel MIR7 aus. Das zweite Teilobjektiv umfasst zwei Spiegel, die Spiegel MIR9 und MIR10. Zwischen dem Spiegel MIR9 und MIR10 kann eine Aperturblende B angeordnet sein.

Des Weiteren bezeichnen:

| Object: | die Objektebene |
| Mirror 1: | den Spiegel MIR1 |
| Mirror 2: | den Spiegel MIR2 |
| Mirror 3: | den Spiegel MIR3 |
| Mirror 4: | den Spiegel MIR4 |
| Mirror 5: | den Spiegel MIR5 |
| Mirror 6: | den Spiegel MIR6 |
| Mirror 7: | den Spiegel MIR7 |
| Mirror 8: | den Spiegel MIR8 |

(fortgesetzt)

| | |
|---|---|
| Mirror 9: | den Spiegel MIR9 |
| Mirror 10: | den Spiegel MIR10 |
| STOP: | die Aperturblende |
| Image: | die Bildebene |

Im unteren Teil von Tabelle 16 sind die asphärischen Konstanten der Spiegelflächen der einzelnen Spiegel angegeben:

Tabelle 16: Optische Daten des Systems gemäß Figur 20

| Surface | Radius | Thickness | Mode |
|---|---|---|---|
| Object | INFINITY | 750.158 | |
| Mirror 1 | -3645.207 | -700.158 | REFL |
| Mirror 2 | 1388.693 | 700.158 | REFL |
| Mirror 3 | 421.919 | -239.680 | REFL |
| Mirror 4 | 928.703 | 450.888 | REFL |
| Mirror 5 | -316.927 | -82.283 | REFL |
| Mirror 6 | -232.317 | 253.878 | REFL |
| Mirror 7 | 138.033 | -203.878 | REFL |
| Mirror 8 | 231.384 | 424.892 | REFL |
| Mirror 9 | -631.742 | -28.814 | REFL |
| STOP | INFINITY | -179.600 | |
| Mirror 10 | 359.774 | 228.408 | REFL |
| Image | INFINITY | 0.000 | |

| Surface | K | A | B | C |
|---|---|---|---|---|
| Mirror 1 | -6.06373E+01 | 0.00000E+00 | 1.35009E-14 | -2.59993E-19 |
| Mirror 2 | 2.31409E+01 | 0.00000E+00 | -1.13367E-14 | -1.77547E-19 |
| Mirror 3 | 7.66282E+00 | 0.00000E+00 | -1.35197E-13 | -3.76649E-18 |
| Mirror 4 | 3.19172E+00 | 0.00000E+00 | -3.50329E-15 | 1.79751 E-20 |
| Mirror 5 | -8.19082E-01 | 0.00000E+00 | -3.63599E-15 | 1.44815E-20 |
| Mirror 6 | -2.80654E+00 | 0.00000E+00 | -1.90563E-13 | 7.53932E-18 |
| Mirror 7 | -4.36872E+00 | 0.00000E+00 | -5.57748E-11 | 9.38288E-15 |
| Mirror 8 | -7.83804E-02 | 0.00000E+00 | -3.99246E-15 | 1.05336E-20 |
| Mirror 9 | -2.02616E+01 | 0.00000E+00 | 3.77305E-13 | -5.08163E-18 |
| Mirror 10 | 6.67169E-01 | 0.00000E+00 | 2.85323E-16 | -4.15075E-20 |

| Surface | D | E | F | G |
|---|---|---|---|---|
| Mirror 1 | 4.09829E-24 | -2.02663E-29 | -1.37613E-33 | 0.00000E+00 |
| Mirror 2 | 6.90094E-24 | -1.55471 E-28 | 0.00000E+00 | 0.00000E+00 |
| Mirror 3 | 1.52791 E-22 | -1.47257E-26 | 0.00000E+00 | 0.00000E+00 |
| Mirror 4 | 2.37312E-26 | -3.74208E-31 | 0.00000E+00 | 0.00000E+00 |
| Mirror 5 | 7.93942E-26 | 2.39496E-30 | 0.00000E+00 | 0.00000E+00 |
| Mirror 6 | -1.22667E-22 | 7.73753E-28 | 0.00000E+00 | 0.00000E+00 |
| Mirror 7 | -4.67133E-20 | 1.96718E-27 | 1.85277E-26 | 0.00000E+00 |
| Mirror 8 | -2.12451 E-26 | -3.54563E-29 | 3.35753E-34 | 0.00000E+00 |
| Mirror 9 | 2.24127E-22 | -4.81678E-27 | 8.20784E-32 | 0.00000E+00 |
| Mirror 10 | 6.10237E-25 | -8.56806E-30 | 5.42702E-35 | 0.00000E+00 |

In Figur 21 ist ein zweites Ausführungsbeispiel eines Objektives zur Abbildung von Strukturgrößen kleiner 50 nm gezeigt. Das Objektiv umfasst zehn Spiegel, einen ersten Spiegel MIR1, einen zweiten Spiegel MIR2, einen dritten Spiegel MIR3, einen vierten Spiegel MIR4, einen fünften Spiegel MIR5, einen sechsten Spiegel MIR6, einen siebten Spiegel MIR7, einen achten Spiegel MIRB, einen neunten Spiegel MIR9 sowie einen zehnten Spiegel MIR10. Das zweite Ausführungsbeispiel eines Objektives zur Abbildung von Strukturen kleiner 50 nm besteht aus einem ersten Subobjektiv 29000 mit den sechs Spiegeln MIR1, MIR2, MIR3, MIR4, MIR5, MIR6 und der Spiegelfolge konkav-konkav-konvex-konkav-konvex-konkav. Das erste Subobjektiv 29000 ist in ein erstes Teilobjektivsubsystem 30000 mit den Spiegeln MIR1, MIR2, MIR3, MIR4 und ein zweites Teilobjektivsubsystem 30002 MIR5, MIR6 unterteilt. Das zweite Subobjektiv 29010 umfasst die Spiegel MIR7, MIR8, MIR9 und MIR10, die alle als Konkavspiegel ausgebildet sind. Das zweite Subobjektiv 29010 umfasst ein erstes Teilobjektivteilsystem 30004 mit Spiegeln MIR7 und MIR8 und ein zweites Teilobjektivteilsystem 30006 mit Spiegeln MIR9 und MIR 10. Die bildseitige numerische Apertur ist NA=0.85 bei einer Betriebswellenlänge von 100nm und einer Verkleinerung von 8x. Die Bildfeldgröße beträgt 13 x 1 mm² in der Bildebene, d.h. die bildseitige Feldbreite $D_x$ beträgt 13 mm, die bildseitige Feldlänge $D_y$ beträgt 1 mm und der bildseitige Feldradius $D_r$ 14,5 mm. Die Auflösung beträgt 41 nm, die Baulänge des Objektives 1942 mm. Der bildseitige $W_{rms}$ beträgt 0,013 λ, die bildseitige Feldkrümmung 6 nm. Die Spiegel MIR7, MIR8, MIR9 und MIR10 umfassen Öffnungen. Die Spiegel MIR1, MIR2, MIR3, MIR4, MIR5 und MIR6 weisen keine Öffnungen auf. Der resultierende Obskurationsradius, der eine feldunabhängige Obskuration zur Verfügung stellt beträgt 28 % des Aperturradius. Der bildseitige freie Arbeitsabstand beträgt 15 mm und der objektseitige freie Arbeitsabstand 50 mm. Der maximale Einfallswinkel $\Theta_{CR(max)}$ auf einen der Spiegel MIR1 bis MIR10 des Hauptstrahls zu einem zentralen Feldpunktes beträgt 30°. Der maximale Winkel $\Theta_{max(max)}$ auf irgendeinen Spiegel MIR1 bis MIR10 beträgt 32,4°. Der maximale Winkelbereich $\Delta\Theta_{max}$ auf irgendeinen Spiegel MIR1 bis MIR10 beträgt 33,3°. Die Größe des größten Spiegels im Meridionalschnitt beträgt 650 mm. Die Größe des größten Spiegels in x-Richtung beträgt 704 mm. Das dargestellte Projektionsobjektiv umfasst wenigstens 4 Pupillenebenen. Wenigstens eine Pupillenebene ist zugänglich zur Positionierung einer Aperturblende und wenigstens eine weitere Pupillenebene ist zugänglich zur Positionierung einer Obskurations- bzw. Abschattungsblende. Bspw. kann eine Abschattungsblende auf dem Spiegle MIR2 angeordnet werden. Die optischen Daten des Systems sind in Tabelle 17 angegeben. Das System weist insgesamt drei Zwischenbilder ZWI1, ZWI2, ZWI3 auf. Dieses Ausführungsbeispiel zeich-net sich durch niedrige Einfallswinkel von weniger als 30° für den Hauptstrahl des zentralen Feldpunktes aus. Die , Aperturblende B ist auf oder nahe dem zweiten Spiegel MIR2 angeordnet. Sie kann alternativ aber auch in dem zweiten Subobjektiv z.B. auf dem Spiegel MIR 7 oder aber zwischen den Spiegeln MIR 9 und MIR 10 angeordnet werden. In Tabelle 17 bezeichnen:

|            |                   |
|------------|-------------------|
| Object:    | die Objektebene   |
| Mirror 1:  | den Spiegel MIR1  |
| Mirror 2:  | den Spiegel MIR2  |
| Mirror 3:  | den Spiegel MIR3  |
| Mirror 4:  | den Spiegel MIR4  |
| Mirror 5:  | den Spiegel MIR5  |
| Mirror 6:  | den Spiegel MIR6  |
| Mirror 7:  | den Spiegel MIR7  |
| Mirror 8:  | den Spiegel MIR8  |
| Mirror 9:  | den Spiegel MIR9  |
| Mirror 10: | den Spiegel MIR10 |
| STOP:      | die Aperturblende |
| Image:     | die Bildebene     |

Im unteren Teil von Tabelle 17 sind die asphärischen Konstanten der Spiegelflächen der einzelnen Spiegel angegeben:

Tabelle 17: Optische Daten des Systems gemäß Figur 21

| Surface  | Radius    | Thickness | Mode |
|----------|-----------|-----------|------|
| Object   | INFINITY  | 381.457   |      |
| Mirror 1 | -1379.982 | -331.458  | REFL |
| STOP     | INFINITY  | 0.000     |      |
| Mirror 2 | 862.420   | 409.088   | REFL |
| Mirror 3 | 294.135   | -393.417  | REFL |
| Mirror 4 | 674.870   | 1003.719  | REFL |

(fortgesetzt)

| Surface | Radius | Thickness | Mode |
|---------|--------|-----------|------|
| Mirror 5 | 159.301 | -486.152 | REFL |
| Mirror 6 | 519.366 | 977.030 | REFL |
| Mirror 7 | -1878.719 | -448.038 | REFL |
| Mirror 8 | 805.537 | 814.366 | REFL |
| Mirror 9 | -1449.005 | -316.328 | REFL |
| Mirror 10 | 452.987 | 331.329 | REFL |
| Image | INFINITY | 0.000 | |

| Surface | K | A | B | C |
|---------|---|---|---|---|
| Mirror 1 | 0.00000E+00 | 2.55145E-09 | -6.09305E-14 | 4.98564E-19 |
| Mirror 2 | 0.00000E+00 | -2.87984E-10 | 1.89704E-13 | -1.31315E-16 |
| Mirror 3 | 0.00000E+00 | -9.84186E-09 | 5.83377E-14 | 1.68182E-18 |
| Mirror 4 | 0.00000E+00 | -8.72959E-11 | 2.57957E-16 | -1.74722E-21 |
| Mirror 5 | 0.00000E+00 | 2.73117E-08 | 1.12013E-11 | 9.25229E-16 |
| Mirror 6 | 0.00000E+00 | -2.84379E-10 | -4.48476E-16 | -1.28457E-21 |
| Mirror 7 | 0.00000E+00 | -5.31063E-10 | 2.49955E-16 | 9.28030E-21 |
| Mirror 8 | 0.00000E+00 | 2.32104E-10 | 8.53499E-16 | 2.27404E-21 |
| Mirror 9 | 0.00000E+00 | 8.99663E-10 | 3.52918E-15 | -4.85346E-21 |
| Mirror 10 | 7.29438E-02 | -1.05224E-09 | -1.45361E-15 | 4.37512E-21 |

| Surface | D | E | F | G |
|---------|---|---|---|---|
| Mirror 1 | -2.04929E-23 | 5.33894E-28 | 0.00000E+00 | 0.00000E+00 |
| Mirror 2 | 3.83759E-20 | -4.05131E-24 | 0.00000E+00 | 0.00000E+00 |
| Mirror 3 | -3.47385E-23 | 1.19978E-28 | 0.00000E+00 | 0.00000E+00 |
| Mirror 4 | 3.35836E-27 | -2.85580E-33 | 0.00000E+00 | 0.00000E+00 |
| Mirror 5 | 3.49953E-19 | 0.00000E+00 | 0.00000E+00 | 0.00000E+00 |
| Mirror 6 | -2.99713E-27 | -4.01016E-32 | 0.00000E+00 | 0.00000E+00 |
| Mirror 7 | -5.91706E-25 | -4.04630E-31 | 0.00000E+00 | 0.00000E+00 |
| Mirror 8 | -3.97444E-27 | 1.59717E-32 | 0.00000E+00 | 0.00000E+10 |
| Mirror 9 | 4.87617E-25 | -4.02032E-30 | 2.37898E-35 | 0.00000E+00 |
| Mirror 10 | -1.37373E-25 | 1.02096E-30 | -4.77532E-36 | 7.03192E-42 |

Das System gemäß Figur 21 zeichnet sich durch eine Reihe vorteilhafter Maßnahmen für sich alleine genommen oder in Summe aus.

Gemäß einer ersten vorteilhaften Maßnahme umfasst das erste Subobjektiv mit einem ersten Teilobjektivsubsystem 30000 und einem zweiten Teilobjektivsubsystem 30002 wenigstens fünf Spiegel und ein Zwischenbild ZWI1 zwischen dem vierten Spiegel MIR4 und dem fünften Spiegel MIR5.

Vorteilhafterweise weist das Gesamtsystem wie in Figur 21 gezeigt höchstens zwei Konvexspiegel auf. Typischerweise ergeben sich auf Konvexspiegeln hohe Einfallswinkel, was zu Reflektivitätsverlusten führt. Daher ist die Verwendung einer möglichst geringen Anzahl von Konvexspiegeln für die Transmission des Gesamtsystems vorteilhaft.

Besonders vorteilhaft ist es wenn, wie beim System gemäß Figur 21 das zweite Subobjektiv 29010 bestehend aus den Teilobjektivteilsystemen 30004 und 30006 keinen Konvexspiegel aufweist. Ein Konvexspiegel im zweiten Subobjektiv besitzt typischerweise einen kleineren Durchmesser als ein dort angeordneter Konkavspiegel. Der notwendige Durchmesser der für die abschattungsfreie Strahlführung notwendigen Bohrung ist aber in beiden Fällen gleich. Daher ist der obskurierte Anteil der Pupille für einen Konvexspiegel größer als für einen Konkavspiegel, welches sich nachteilig auf den Kontrast der Abbildung auswirkt.

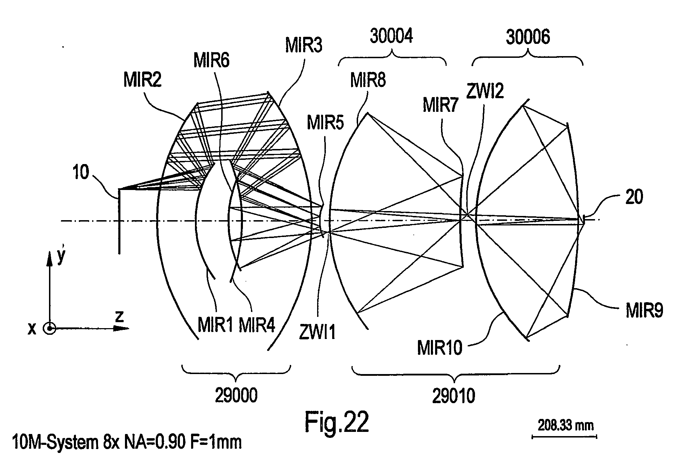

In Figur 22 ist ein drittes Ausführungsbeispiel eines Objektives zur Abbildung von Strukturgrößen kleiner 50 nm gezeigt. Das Objektiv umfasst zehn Spiegel, einen ersten Spiegel MIR1, einen zweiten Spiegel MIR2, einen dritten Spiegel MIR3, einen vierten Spiegel MIR4, einen fünften Spiegel MIR5, einen sechsten Spiegel MIR6, einen siebten Spiegel MIR7, einen achten Spiegel MIR8, einen neunten Spiegel MIR9 sowie einen zehnten Spiegel MIR10. Das dritte Ausführungsbeispiel besteht aus einem ersten Subobjektiv 29000 mit den Spiegeln MIR1, MIR2, MIR3, MIR4, MIR5, MIR6 und der Spiegelfolge konvex-konkav-konkav-konvex-konvex-konkav. Das zweite Subobjektiv 29010 umfasst die Spiegel MIR7, MIRB, MIR9 und MIR10 mit der Spiegelabfolge konvex-konkav-konkav-konkav. Im Gegensatz zum ersten Subobjektiv ist das zweite Subobjektiv auch in diesem Ausführungsbeispiel in ein erstes Teilobjektivteilsystem 30004 mit Spiegeln MIR7, MIR8 und ein zweites Teilobjektivteilsystem 10006 mit Spiegeln MIR9, MIR10 unterteilt. Die bildseitige numerische Apertur ist NA=0.90 bei einer Verkleinerung von 8x und einer Wellenlänge von 100 nm. Die Bildfeldgröße beträgt 13 x 1 mm$^2$ in der Bildebene, d. h. $D_x$=13mm, $D_y$=1 mm. Der bildseitige Feldradius $D_f$=2,5 mm. Die bildseitige $W_{RMS}$ beträgt 0,02 $\lambda$. Die bildseitige Feldkrümmung 5 nm, das Auflösungsvermögen 39 nm und die Gesamtlänge des Systems, d. h. die Baulänge 1510 mm. Die Spiegel MIR7, MIR8, MIR9 und MIR10 umfassen Öffnungen. Die Spiegel MIR1, MIR2, MIR3, MIR4, MIR5 und MIR6 umfassen keine Öffnungen. Der resultierende Obskurationsradius, der eine feldunabhängige Obskuration zur Verfügung stellt, beträgt 24 % des Aperturradius. Der bildseitige freie Arbeitsabstand beträgt 20 mm und der objektseitige freie Arbeitsabstand 120 mm. Der maximale Einfallswinkel auf die Spiegel MIR1 bis MIR10 eines Hauptstrahls zu einem zentralen Feldpunkt $\Theta_{CR(max)}$ beträgt 36,1°. Der maximale Einfallswinkel $\Theta_{max(max)}$ irgendeines Strahles, der auf die Spiegel MIR1 bis MIR10 einfällt, beträgt 44,4°. Der maximale Winkelbereich $\Delta\Theta_{max}$ der Einfallswinkel auf irgendeinen der Spiegel MIR1 bis MIR10 beträgt 24,2°. Die Größe des größten Spiegels in der Meridionalebene beträgt 767 mm und die Größe des größten Spiegels in x-Richtung beträgt 780 mm. Die optischen Daten des Systems sind in Tabelle 18 angegeben. Das System weist insgesamt zwei Zwischenbilder ZW11, ZW12 auf. In Tabelle 18 bezeichnen:

| | |
|---|---|
| Object: | die Objektebene |
| Mirror 1: | den Spiegel MIR1 |
| Mirror 2: | den Spiegel MIR2 |
| Mirror 3: | den Spiegel MIR3 |
| Mirror 4: | den Spiegel MIR4 |
| Mirror 5: | den Spiegel MIR5 |
| Mirror 6: | den Spiegel MIR6 |
| Mirror 7: | den Spiegel MIR7 |
| Mirror 8: | den Spiegel MIR8 |
| Mirror 9: | den Spiegel MIR9 |
| Mirror 10: | den Spiegel MIR10 |
| STOP: | die Aperturblende |
| Image: | die Bildebene |

Im unteren Teil von Tabelle 18 sind die asphärischen Konstanten der Spiegelflächen der einzelnen Spiegel angegeben:

Tabelle 18: Optische Daten des Systems gemäß Figur 22

| Surface | Radius | Thickness | Mode |
|---|---|---|---|
| Object | INFINITY | 245.168 | |
| Mirror 1 | 249.951 | -124.703 | REFL |
| Mirror 2 | 523.716 | 501.550 | REFL |
| Mirror 3 | -667.566 | -226.847 | REFL |
| Mirror 4 | -552.364 | 256.530 | REFL |
| Mirror 5 | 206.660 | -297.653 | REFL |
| Mirror 6 | 368.135 | 762.143 | REFL |
| STOP | INFINITY | 0.000 | |
| Mirror 7 | 4031.704 | -435.563 | REFL |
| Mirror 8 | 577.321 | 809.677 | REFL |
| Mirror 9 | -988.316 | -324.113 | REFL |
| Mirror 10 | 566.943 | 344.114 | REFL |
| Image | INFINITY | 0.000 | |

(fortgesetzt)

| Surface | K | A | B | C |
|---|---|---|---|---|
| Mirror 1 | 0.0000E+00 | -3.11456E-08 | 9.16528E-13 | -3.54546E-17 |
| Mirror 2 | -5.59339E-01 | -1.88162E-09 | 8.43476E-15 | -2.59617E-20 |
| Mirror 3 | 6.87474E-01 | 2.77052E-10 | 1.40958E-15 | 4.28911 E-21 |
| Mirror 4 | -1.59289E+01 | -1.06455E-08 | 2.59948E-13 | -4.36668E-18 |
| Mirror 5 | 5.12429E+00 | -8.25258E-08 | -9.24031 E-12 | -8.33161 E-16 |
| Mirror 6 | -1.39031E-01 | 3.43126E-10 | 4.60045E-15 | -6.53939E-20 |
| Mirror 7 | 5.78570E+02 | 2.57528E-09 | 3.83885E-14 | -2.02693E-19 |
| Mirror 8 | -6.96187E-02 | 2.19736E-10 | 3.72967E-16 | 1.51513E-21 |
| Mirror 9 | 2.14467E+00 | 1.04852E-09 | 2.81763E-15 | 1.99872E-20 |
| Mirror 10 | 5.40700E-01 | -5.74797E-10 | -3.19526E-16 | -3.95750E-21 |
| Surface | D | E | F | G |
| Mirror 1 | 8.93385E-22 | -1.43705E-26 | 1.00944E-31 | -1.28239E-37 |
| Mirror 2 | 5.48279E-26 | -1.28956E-31 | 6.35331 E-38 | 0.00000E+00 |
| Mirror 3 | 2.07859E-26 | -5.39237E-32 | 3.55065E-37 | 2.29678E-43 |
| Mirror 4 | 3.82440E-23 | 8.41820E-29 | -3.23510E-33 | 0.00000E+00 |
| Mirror 5 | 1.48317E-19 | -4.88263E-23 | 2.75394E-26 | -6.18092E-30 |
| Mirror 6 | 5.47733E-24 | -2.56664E-28 | 6.45932E-33 | -6.55148E-38 |
| Mirror 7 | -2.80256E-23 | 3.79804E-28 | -1.15483E-31 | -6.06768E-37 |
| Mirror 8 | 7.88332E-28 | 4.72725E-32 | -2.42047E-37 | 7.91050E-43 |
| Mirror 9 | 2.86297E-26 | 1.14192E-30 | -7.63438E-37 | 4.45766E-42 |
| Mirror 10 | 8.93037E-27 | -1.25840E-31 | 8.67177E-37 | -3.34533E-42 |

Das in Figur 22 gezeigte System zeichnet sich vorteilhaft dadurch aus, dass das erstes Subobjektiv 29000 nicht in Teilsysteme wie im Falle der Ausführungsform gemäß Figur 21 aufgeteilt ist, sondern wenigstens fünf Spiegel und kein Zwischenbild umfasst. Das zweite Subobjektiv 29010 umfasst zwei Teilobjektives 30004 und 30006.

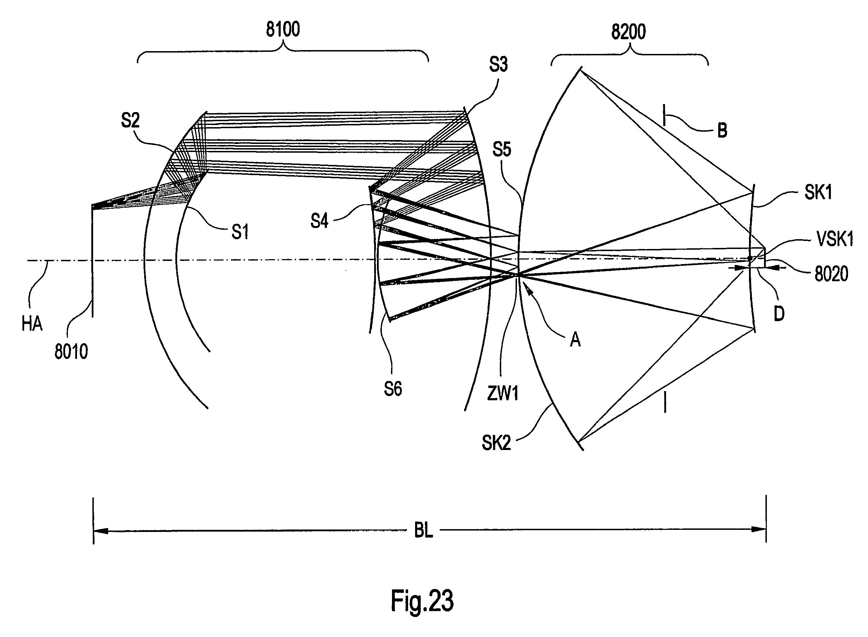

In Figur 23 ist ein Ausführungsbeispiel eines Objektives mit Zwischenbild und bildseitigen Apertur von NA=0,70 bei einer Betriebswellenlänge von 100nm und einer Verkleinerung von 8x gemäß einem weitem Aspekt der Erfindung gezeigt.

Das erfindungsgemäße Projektionsobjektiv umfasst zwei Teilobjektive, ein erstes Teilobjektiv 8100, sowie das zweite Teilobjektiv 8200. Das erste Teilobjektiv umfasst insgesamt sechs Spiegel, S1, S2, S3, S4, S5 sowie S6. Im Lichtweg von der Objektebene 8010 zur Bildebene 8020 gesehen ist der Spiegel S1 ein Konvexspiegel, der Spiegel S2 ein Konkavspiegel, der Spiegel S3 ein Konkavspiegel, der Spiegel S4 ein Konvexspiegel, der Spiegel S5 ein Konvexspiegel und der Spiegel S6 ein Konkavspiegel. Der Abbildungsfaktor des ersten Teilobjektives beträgt -0.33. Die Objektebene, in der bspw. das Retikel zu liegen kommt, ist mit 8010 bezeichnet. Die optische Achse, um die einzelne Spiegelsegmente rotationssymmetrisch sind, ist mit HA, bezeichnet und die Gesamtlänge des Systems von der Objektebene 8010 zur Bildebene 8020, die auch als Baulänge bezeichnet wird mit BL und beträgt 1300 mm. Das erste Teilobjektiv wird auch als Feldgruppe bezeichnet und umfasst die Spiegel S1, S2, S3, S4, S5 und S6. Bei diesen Spiegeln handelt es sich um außeraxiale Spiegelsegmente sog. off-axis Spiegelsegmente, die die Korrektur feldabhängiger Bildfehler zulassen.

An das erste Teilobjektiv 8100 schließt sich ein zweites Teilobjektiv 8200 an, das auch als Aperturgruppe bezeichnet wird und einen Abbildungsfaktor von -0.38 hat.

Das zweite Teilobjektiv 8200 umfasst vorliegend zwei Spiegel, wobei der erste Spiegel als Konvexspiegel und der zweite Spiegel der Aperturgruppe als Konkavspiegel ausgebildet ist. Der Konvexspiegel der Aperturgruppe wird mit SK1 und der Konkavspiegel mit SK2 bezeichnet. Der Konkavspiegel SK2 umfasst eine Aperturöffnung A für den Durchtritt eines Strahlbüschels, das das Projektionsobjektiv von der Objektebene 8010 zur Bildebene 8020 durchläuft.

Wie deutlich zu erkennen ist, ist der Abstand D, der sog. bildseitige Arbeitsabstand, zwischen der Vertex VSK1, d.h. des Scheitelpunktes des Konvexspiegels SK1 und der Bildebene 8020 größer als 12 mm, bevorzugt größer als 15 mm, ganz bevorzugt größer als 30 mm.

Bei dem dargestellten Projektionsobjektiv wird maximal ein Zwischenbild ZW1 ausgebildet, nämlich zwischen der Feldgruppe und der Aperturgruppe, d. h. zwischen dem ersten Teilobjektiv 8100 und dem zweiten Teilobjektiv 80200. Das Zwischenbild ZW1 liegt in der Nähe der Aperturöffnung A des Konkavspiegels SK2 der Aperturgruppe.

**EP 1 828 829 B1**

Die zugängliche Aperturblende B beim in Fig. 23 dargestellten Ausführungsbeispiel ist im Strahlengang in der Aperturgruppe zwischen dem Konvexspiegel SK1 und dem Konkavspiegel SK2 angeordnet

Das in Fig. 23 dargestellte Ausführungsbeispiel zeichnet sich dadurch aus, dass der im optischen Strahlengang letzte Spiegel S6 der Feldgruppe ein Konkavspiegel ist. Hierdurch wird eine besonders kleine Pupillenabschattung erreicht, die im vorliegenden Beispiel weniger als 12% beträgt. Des Weiteren weist die dargestellte Ausführungsform der Erfindung eine negative Schnittweite der Eintrittspupille auf. Das Bildfeld beträgt 13 x 1mm$^2$, d. h. die bildseitige Feldbreite $D_x$ beträgt 13 mm, die bildseitige Feldlänge $D_y$ beträgt 1 mm und der bildseitige Feldradius $D_r$ 12 mm. Die Auflösung beträgt 50 nm. Der bildseitige $W_{rms}$ beträgt 0,007 $\lambda$, die bildseitige Feldkrümmung 8 nm. Die Spiegel SK1 und SK2 umfassen Öffnungen. Die Spiegel S1 bis S6 weisen keine Öffnungen auf. Der resultierende Obskurationsradius, der eine feldunabhängige Obskuration zur Verfügung stellt beträgt 34 % des Aperturradius. Der bildseitige freie Arbeitsabstand beträgt 30 mm und der objektseitige freie Arbeitsabstand 103 mm. Der maximale Einfallswinkel $\Theta CR_{(max)}$ auf einen der Spiegel S1 bis S6, SK1 und SK2 des Hauptstrahles CR zu einem zentralen Feldpunktes beträgt 39,7°. Der maximale Winkel $\Theta_{max(max)}$ auf irgendeinen Spiegel S1 bis S6, SK1 und SK2 beträgt 52,2°. Der maximale Winkelbereich $\Delta\Theta_{max}$ auf irgendeinen Spiegel S1 bis S6, SK1 und SK2 beträgt 23,6°. Die Größe des größten Spiegels im Meridionalschnitt beträgt 693 mm. Die Größe des größten Spiegels in x-Richtung beträgt 706 mm.

Die optischen Daten des Systems gemäß Figur 23 können aus nachfolgender Tabelle 19 entnommen werden.

Dabei bezeichnet

| | |
|---|---|
| Mirror 1: | den Spiegel S1 |
| Mirror 2: | den Spiegel S2 |
| Mirror 3: | den Spiegel S3 |
| Mirror 4: | den Spiegel S4 |
| Mirror 5: | den Spiegel S5 |
| Mirror 6: | den Spiegel S6 |
| Mirror 7: | den Konvexspiegel SK1 |
| Mirror 8: | den Konkavspiegel SK2 |
| STOP: | die Aperturblende |

Der erste Teil von Tabelle 19 gibt die optischen Daten wieder und der zweite Teil von Tabelle 19 die asphärischen Konstanten der jeweiligen Spiegelflächen.

Tabelle 19

| Surface | Radius | Thickness | Mode |
|---|---|---|---|
| Object | INFINITY | 165.327 | |
| Mirror 1 | 249.504 | -62.783 | REFL |
| Mirror 2 | 343.765 | 670.215 | REFL |
| Mirror 3 | -828.212 | -218.641 | REFL |
| Mirror 4 | -1067.352 | 268.921 | REFL |
| Mirror 5 | 332.014 | -264.244 | REFL |
| Mirror 6 | 338.358 | 712.058 | REFL |
| Mirror 7 | 1159.033 | -164.051 | REFL |
| STOP | INFINITY | -283.661 | |
| Mirror 8 | 567.471 | 477.708 | REFL |
| Image | INFINITY | 0 | |

| Surface | K | A | B | C |
|---|---|---|---|---|
| Mirror 1 | 2.99269E-02 | 0.00000E+00 | -2.13755E-13 | 6.46731 E-18 |
| Mirror 2 | -3.44285E-01 | 0.00000E+00 | 2.07475E-15 | -1.50695E-19 |
| Mirror 3 | 2.56188E-01 | 0.00000E+00 | 4.13017E-15 | -8.73809E-20 |
| Mirror 4 | 3.72134E+01 | 0.00000E+00 | 1.17208E-13 | -1.00755E-17 |
| Mirror 5 | -2.17361E+00 | 0.00000E+00 | -2.13347E-12 | -1.63109E-17 |

57

(fortgesetzt)

| Surface | K | A | B | C |
|---|---|---|---|---|
| Mirror 6 | 5.10592E-01 | 0.00000E+00 | 4.64944E-15 | 9.47577E-20 |
| Mirror 7 | 2.30009E+01 | 1.60457E-09 | 7.62848E-15 | 7.32194E-20 |
| Mirror 8 | 1.38025E-01 | -4.77315E-11 | -7.94863E-17 | -1.46539E-22 |

| Surface | D | E | F | G |
|---|---|---|---|---|
| Mirror 1 | -2.49480E-22 | 5.90564E-27 | -7.53450E-32 | 0.00000E+00 |
| Mirror 2 | 1.63388E-24 | -8.61503E-30 | 0.00000E+00 | 0.00000E+00 |
| Mirror 3 | 9.49612E-25 | -4.79993E-30 | 6.26043E-36 | 0.00000E+00 |
| Mirror 4 | 6.10952E-22 | -1.76184E-26 | 2.51233E-31 | 0.00000E+00 |
| Mirror 5 | -6.87493E-20 | 2.30226E-23 | -4.50171E-27 | 0.00000E+00 |
| Mirror 6 | -1.14614E-24 | 9.25629E-29 | 8.23956E-34 | 0.0000E+00 |
| Mirror 7 | 1.10925E-24 | -2.18661E-30 | 9.19421E-34 | 0.00000E+00 |
| Mirror 8 | -3.96589E-28 | -6.93749E-35 | -5.09345E-39 | 0.00000E+00 |

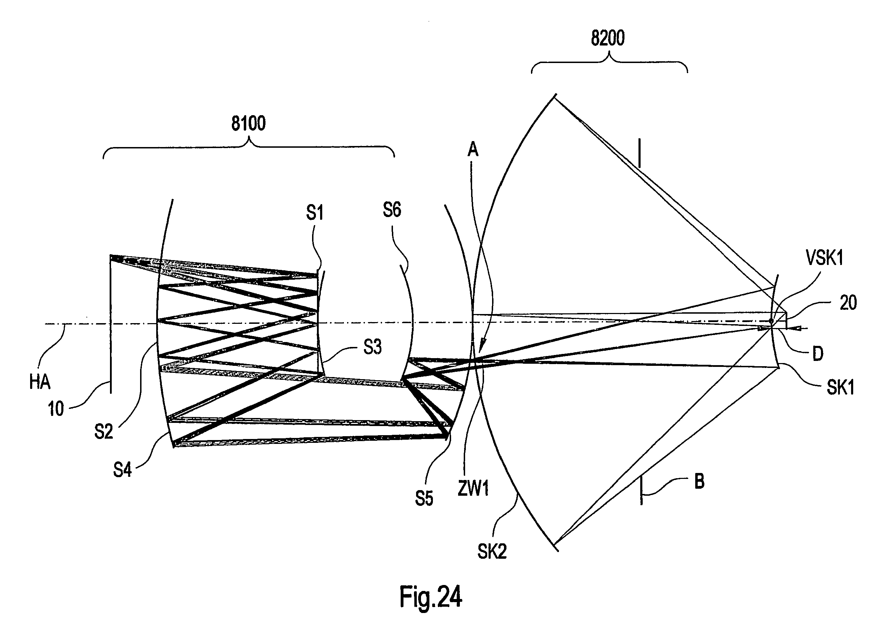

In Figur 24 ist ein zweites Ausführungsbeispiel eines 8-Spiegel-Objektives mit einer numerischen Apertur NA=0,7 und 8-facher Verkleinerung bei einer Wellenlänge von 100 nm mit einem Zwischenbild ZW1 gezeigt, gemäß einem weitern Aspekt der Erfindung. Gleiche Bauteile wie in Figur 23 sind mit denselben Bezugsziffern belegt.

Die optischen Daten des Systems gemäß Fig. 24 ergeben sich aus nachfolgender Tabelle 20.

Dabei bezeichnet

Mirror 1:   den Spiegel S1
Mirror 2:   den Spiegel S2
Mirror 3:   den Spiegel S3
Mirror 4:   den Spiegel S4
Mirror 5:   den Spiegel S5
Mirror 6:   den Spiegel S6
Mirror 7:   den Konvexspiegel SK1
Mirror 8:   den Konkavspiegel SK2
STOP:   die Aperturblende

Der erste Teil von Tabelle 20 gibt die optischen Daten wieder und der zweite Teil von Tabelle 20 die asphärischen Konstanten der jeweiligen Spiegelflächen.

Tabelle 20

| Surface | Radius | Thickness | Mode |
|---|---|---|---|
| Object | INFINITY | 450.606 | |
| Mirror 1 | -28568.210 | -350.616 | REFL |
| Mirror 2 | 851.174 | 350.616 | REFL |
| Mirror 3 | 442.020 | -350.606 | REFL |
| Mirror 4 | 987.208 | 696.277 | REFL |
| Mirror 5 | -512.086 | -134.752 | REFL |
| Mirror 6 | -273.167 | 779.239 | REFL |
| Mirror 7 | 348.346 | -282.337 | REFL |
| STOP | INFINITY | -362.208 | |
| Mirror 8 | 724.665 | 674.286 | REFL |
| Image | INFINITY | 0.000 | |

(fortgesetzt)

| Surface | K | A | B | C |
|---|---|---|---|---|
| Mirror 1 | 0.00000E+00 | 9.08199E-09 | -6.44794E-13 | 2.73864E-17 |
| Mirror 2 | 0.00000E+00 | -3.95755E-09 | -4.59326E-14 | -7.77764E-18 |
| Mirror 3 | 0.00000E+00 | -2.26321E-08 | 2.00888E-13 | 4.01582E-18 |
| Mirror 4 | 0.00000E+00 | -3.58006E-10 | -8.38532E-16 | -4.42394E-20 |
| Mirror 5 | 0.00000E+00 | 1.82876E-09 | 3.83573E-15 | -1.98419E-19 |
| Mirror 6 | 0.00000E+00 | 3.72775E-08 | -9.31689E-13 | 1.99541E-17 |
| Mirror 7 | 0.00000E+00 | 3.17967E-09 | 1.39624E-13 | 2.49821 E-18 |
| Mirror 8 | 0.00000E+00 | 9.10620E-12 | 2.42344E-17 | 2.73184E-23 |

| Surface | D | E | F | G |
|---|---|---|---|---|
| Mirror 1 | -9.33644E-22 | 1.62066E-26 | 0.00000E+00 | 0.00000E+00 |
| Mirror 2 | 1.19180E-21 | -6.96128E-26 | 0.00000E+00 | 0.00000E+00 |
| Mirror 3 | -3.30477E-22 | 7.17255E-27 | 0.00000E+00 | 0.00000E+00 |
| Mirror 4 | 4.09594E-25 | -2.20889E-30 | 0.00000E+00 | 0.00000E+00 |
| Mirror 5 | 1.79598E-24 | -5.45453E-30 | 0.00000E+00 | 0.00000E+00 |
| Mirror 6 | -2.45482E-22 | 1.70799E-27 | 0.00000E+00 | 0.00000E+00 |
| Mirror 7 | 1.11591 E-22 | 3.21132E-27 | 0.00000E+00 | 0.00000E+00 |
| Mirror 8 | 2.91015E-28 | -7.88285E-34 | 2.39162E-39 | 0.00000E+00 |

Die Größe des Feldes in der Bildebene beträgt für das Ausführungsbeispiel in Figur 24 13 x 1 mm$^2$, d. h. die bildseitige Feldbreite $D_x$ beträgt 13 mm, die bildseitige Feldlänge $D_y$ beträgt 1 mm und der bildseitige Feldradius $D_r$ 17,5 mm. Die Auflösung beträgt 50 nm. Die Baulänge des Objektives beträgt 1470 mm. Der bildseitige $W_{rms}$ beträgt 0, 14 $\lambda$, die bildseitige Feldkrümmung 125 nm. Die Spiegel SK1 und SK2 umfassen Öffnungen. Die Spiegel S1 bis S6 weisen keine Öffnungen auf. Der resultierende Obskurationsradius, der eine feldunabhängige Obskuration zur Verfügung stellt beträgt 57 % des Aperturradius. Der bildseitige freie Arbeitsabstand beträgt 30 mm und der objektseitige freie Arbeitsabstand 100 mm. Der maximale Einfallswinkel $\Theta_{CR(max)}$ auf einen der Spiegel S1 bis S6, SK1 und SK2 des Hauptstrahles CR zu einem zentralen Feldpunktes beträgt 25,4°. Der maximale Winkel $\Theta_{max(max)}$ auf irgendeinen Spiegel S1 bis S6, SK1 und SK2 beträgt 32,4°. Der maximale Winkelbereich $\Delta\Theta_{max}$ auf irgendeinen Spiegel S1 bis S6, SK1 und SK2 beträgt 20,5°. Die Größe des größten Spiegels im Meridionalschnitt beträgt 945 mm. Die Größe des größten Spiegels in x-Richtung beträgt 960 mm.

Im Gegensatz zum Ausführungsbeispiel in Figur 23, ist beim Ausführungsbeispiel gemäß Figur 24 der im Strahlengang letzte Spiegel S6 des ersten Teilobjektives 8100 ein Konvexspiegel. Außerdem ist die Schnittweite der Eintrittspupille positiv. Dies hat den Vorteil, dass insbesondere im ersten Teilobjektiv sehr kleine Einfallswinkel vorliegen und das System sehr kompakt ausgelegt werden kann. Desweiteren kann in diesem Beispiel die Aperturblende alternativ zu der gezeigten Lage in der Aperturgruppe zwischen dem siebten Spiegel und dem achten Spiegel auch in der Feldgruppe (nicht gezeigt) bevorzugt nahe oder direkt auf einem der Spiegel, beispielsweise dem zweiten Spiegel angeordnet werden. Dieses hat den Vorteil, dass die die Pupillenabschattung definierenden Obskurationsblende ebenfalls auf diesem Spiegel angeordnet und beispielsweise durch eine Antireflexbeschichtung realisiert werden kann.

**Patentansprüche**

1. Katoptrisches Projektionsobjektiv,
   wobei ein Strahlenbüschel das Projektionsobjektiv von einer Objektebene (10) zu einer Bildebene (20) durchläuft,
   bestehend aus einem ersten Teilobjektiv (100) und einem zweiten Teilobjektiv (200),
   wobei das erste Teilobjektiv (100) ein Objekt in der Objektebene (10) auf ein Zwischenbild (ZWISCH2) abbildet,
   wobei das zweite Teilobjektiv (200) das Zwischenbild (ZWISCH2) in die Bildebene (20) abbildet,
   wobei das erste Teilobjektiv (100) aus einer Mehrzahl von Spiegeln (Sp1, Sp2, Sp3, Sp4, Sp5, Sp6) besteht, die keine Öffnung für einen Durchtritt des Strahlenbüschels aufweisen,
   und wobei das zweite Teilobjektiv (200) aus einem primären Spiegel (SP7) und einem sekundären Konkavspiegel (SP8) besteht, die jeweils eine Öffnung für den Durchtritt des Strahlbüschels aufweisen,
   **dadurch gekennzeichnet, dass**
   der primäre Spiegel (SP7) ein Konkavspiegel ist.

**2.** Katoptrisches Projektionsobjektiv nach Anspruch 1, wobei im Lichtweg des Strahlbüschels der sekundäre Konkavspiegel (SP8) im Lichtweg nach dem primären Konkavspiegel (SP7) und vor der Bildebene (20) angeordnet ist und der primäre Konkavspiegel (SP7) einen Abstand (A) von der Bildebene aufweist, der größer als 12 mm ist.

**3.** Katoptrisches Projektionsobjektiv nach einem der Ansprüche 1 bis 2, wobei das Objektiv eine bildseitige numerische Apertur NA größer 0,4 aufweist.

**4.** Katoptrisches Projektionsobjektiv nach einem der Ansprüche 1 bis 3, wobei der Abbildungsfaktor des Objektivs 4x oder größer ist.

**5.** Katoptrisches Projektionsobjektiv nach einem der Ansprüche 1 bis 4, wobei in der Bildebene ein bildseitiges Feld mit einer maximalen Dimension (Dx,Dy) ausgebildet wird und die maximale Dimension (Dx,Dy) des bildseitigen Feldes mehr als 1 mm beträgt.

**6.** Katoptrisches Projektionsobjektiv nach einem der Ansprüche 1 bis 5, wobei das Projektionsobjektiv eine positive Schnittweite der Eintrittspupille aufweist.

**7.** Katoptrisches Projektionsobjektiv nach einem der Ansprüche 1 bis 6, wobei das erste Teilobjektiv nur Spiegel umfasst, die außeraxial zu einer Hauptachse des Projektionsobjektivs angeordnet sind.

**8.** Katoptrisches Projektionsobjektiv nach einem der Ansprüche 1 bis 7, wobei der im Lichtweg von Objektebene zur Bildebene zweite Spiegel aus der Mehrzahl der Spiegel des ersten Teilobjektivs ein Konkavspiegel ist.

**9.** Katoptrisches Projektionsobjektiv nach einem der Ansprüche 1 bis 8, wobei das erste Teilobjektiv (100) sechs Spiegel aufweist.

**10.** Katoptrisches Projektionsobjektiv nach Anspruch 9, wobei die Spiegelabfolge der sechs Spiegel (SP1, SP2, SP3, SP4, SP5, SP6) im Lichtweg von der Objektebene (10) zur Bildebene (20) im ersten Teilobjektives ist: konkav - konkav - konvex - konkav - konvex - konkav

**11.** Katoptrisches -Projektionsobjektiv nach Anspruch 9, wobei die Spiegelabfolge der sechs Spiegel (SP1, SP2, SP3, SP4, SP5, SP6) im Lichtweg von der Objektebene (10) zur Bildebene (20) im ersten Teilobjektives (100) ist: konkav - konvex - konkav - konvex - konvex - konkav

**12.** Katoptrisches Projektionsobjektiv, gemäß einem der Ansprüche 9 bis 11, wobei eine Aperturblende im ersten Teilobjektiv (100) auf einem zweiten Spiegel (S20) im Lichtweg von der Objektebene (10) zur Bildebene (20) oder nahe einem zweiten Spiegel (S20) im Lichtweg von der Objektebene (10) zur Bildebene (20) angeordnet ist.

**13.** Katoptrisches Projektionsobjektiv nach einem der Ansprüche 9 bis 12, **dadurch gekennzeichnet, dass** eine Aperturblende zwischen dem primären Konkavspiegel (SK1) und dem sekundärem Konkavspiegel (SK2) des zweiten Teilobjektives (200) angeordnet ist.

**14.** Katoptrisches Projektionsobjektiv nach einem der Ansprüche 9 bis 13, **dadurch gekennzeichnet, dass** das Projektionsobjektiv zwei Zwischenbilder (ZWISCH1, ZWISCH2) aufweist.

**15.** Katoptrisches Projektionsobjektiv nach einem der Ansprüche 9 bis 14, **dadurch gekennzeichnet, dass** der Einfallswinkel $\Theta_{CR}$ des Hauptstrahles zum mittleren Feldpunkt auf jedem der acht Spiegel (SP1, SP2, SP3, SP4, SP5, SP6, SK1, SK2) kleiner als 24° ist.

**16.** Mikrolithographie-Projektionsbelichtungsanlage mit einem Beleuchtungssystem und einem katoptrischen Projektionsobjektiv gemäß einem der Ansprüche 1 bis 15, wobei das katoptrische Projektionsobjektiv eine strukturtragende Maske auf ein lichtempfindliches Substrat abbildet.

**17.** Verfahren zum Belichten von lichtempfindlichen Substraten mit einer Mikrolithographie-Projektionsbelichtungsanlage nach Anspruch 16, wobei von dem Beleuchtungssystem eine strukturtragende Maske mit einem Strahlbüschel beleuchtet wird, wobei das von der Maske reflektierte Strahlbüschel von dem katoptischen Projektionsobjektiv auf das lichtempfindliche Substrat abgebildet wird und wobei dadurch das Substrat belichtet wird.

**Claims**

1. Catoptric projection lens,
   wherein a beam passes through the projection lens from an object plane (10) to an image plane (20), consisting of a first partial lens (100) and a second partial lens (200),
   wherein the first partial lens (100) images an object in the object plane (10) onto an intermediate image (INTER2),
   wherein the second partial lens (200) images the intermediate image (INTER2) into the image plane (20),
   wherein the first partial lens (100) consists of a plurality of mirrors (Sp1, Sp2, Sp3, Sp4, Sp5, Sp6) having no opening for passage of the beam, and wherein the second partial lens (200) consists of a primary mirror (SP7) and a secondary concave mirror (SP8), each having an opening for passage of the beam,
   **characterized in that**
   the primary mirror (SP7) is a concave mirror.

2. Catoptric projection lens according to Claim 1, wherein, in the light path of the beam, the secondary concave mirror (SP8) is arranged in the light path downstream of the primary concave mirror (SP7) and upstream of the image plane (20) and the primary concave mirror (SP7) is at a distance (A) from the image plane which is greater than 12 mm.

3. Catoptric projection lens according to either of Claims 1 and 2, wherein the lens has an image-side numerical aperture NA of greater than 0.4.

4. Catoptric projection lens according to any of Claims 1 to 3, wherein the imaging factor of the lens is 4x or higher.

5. Catoptric projection lens according to any of Claims 1 to 4, wherein, in the image plane, an image-side field having a maximum dimension (Dx, Dy) is formed and the maximum dimension (Dx, Dy) of the image-side field is more than 1 mm.

6. Catoptric projection lens according to any of Claims 1 to 5, wherein the projection lens has a positive vertex focal length of the entrance pupil.

7. Catoptric projection lens according to any of Claims 1 to 6, wherein the first partial lens only comprises mirrors arranged off-axis with respect to a principal axis of the projection lens.

8. Catoptric projection lens according to any of Claims 1 to 7, wherein that mirror from the plurality of mirrors of the first partial lens which is the second mirror in the light path from the object plane to the image plane is a concave mirror.

9. Catoptric projection lens according to any of Claims 1 to 8, wherein the first partial lens (100) has six mirrors.

10. Catoptric projection lens according to Claim 9, wherein the mirror sequence of the six mirrors (SP1, SP2, SP3, SP4, SP5, SP6) in the light path from the object plane (10) to the image plane (20) in the first partial lens is: concave-concave-convex-concave-convex-concave.

11. Catoptric projection lens according to Claim 9, wherein the mirror sequence of the six mirrors (SP1, SP2, SP3, SP4, SP5, SP6) in the light path from the object plane (10) to the image plane (20) in the first partial lens is: concave-convex-concave-convex-convex-concave.

12. Catoptric projection lens according to any of Claims 9 to 11, wherein an aperture stop is arranged in the first partial lens (100) on a second mirror (S20) in the light path from the object plane (10) to the image plane (20) or near a second mirror (S20) in the light path from the object plane (10) to the image plane (20).

13. Catoptric projection lens according to any of Claims 9 to 12, **characterized in that** an aperture stop is arranged between the primary concave mirror (SK1) and the secondary concave mirror (SK2) of the second partial lens (200).

14. Catoptric projection lens according to any of Claims 9 to 13, **characterized in that** the projection lens has two intermediate images (INTER1, INTER2).

15. Catoptric projection lens according to any of Claims 9 to 14, **characterized in that** the angle $\theta_{CR}$ of incidence of the chief ray with respect to the central field point on each of the eight mirrors (SP1, SP2, SP3, SP4, SP5, SP6, SK1, SK2) is less than 24°.

16. Microlithography projection exposure apparatus comprising an illumination system and a Catoptric projection lens according to any of Claims 1 to 15, wherein the Catoptric projection lens images a structure-bearing mask onto a light-sensitive substrate.

17. Method for exposing light-sensitive substrates using a microlithography projection exposure apparatus according to Claim 16, wherein a structure-bearing mask is illuminated with a beam by the illumination system, wherein the beam reflected from the mask is imaged onto the light-sensitive substrate by the catoptric projection lens, and wherein the substrate is thereby exposed.

**Revendications**

1. Objectif de projection catoptrique, dans lequel un faisceau de rayons passe à travers l'objectif de projection d'un plan objet (10) à un plan image (20), constitué d'un premier objectif partiel (100) et d'un second objectif partiel (200), dans lequel le premier objectif partiel (100) forme l'image d'un objet dans le plan objet (10) sur une image intermédiaire (ZWISCH2),
dans lequel le second objectif partiel (200) forme l'image de l'image intermédiaire (ZWISCH2) dans le plan image (20),
dans lequel le premier objectif partiel (100) est constitué d'une pluralité de miroirs (Sp1, Sp2, Sp3, Sp4, Sp5, Sp6) qui présentent une ouverture destinée au passage du faisceau de rayons, et
dans lequel le second objectif partiel (200) est constitué d'un miroir primaire (SP7) et d'un miroir secondaire concave (SP8) qui présentent chacun une ouverture destinée au passage du faisceau de rayons, **caractérisé en ce que** le miroir primaire (SP7) est un miroir concave.

2. Objectif de projection catoptrique selon la revendication 1, dans lequel le chemin optique du faisceau lumineux du miroir secondaire concave (SP8) est disposé sur le chemin optique en aval du miroir primaire concave (SP7) et en amont du plan image (20) et le miroir primaire concave (SP7) présente par rapport au plan image un espacement (A) supérieur à 12 mm.

3. Objectif de projection catoptrique selon l'une quelconque des revendications 1 à 2, dans lequel l'objectif présente une ouverture numérique du côté image NA supérieure à 0,4.

4. Objectif de projection catoptrique selon l'une quelconque des revendications 1 à 3, dans lequel le facteur de formation d'image de l'objectif est supérieur ou égal à 4x.

5. Objectif de projection catoptrique selon l'une quelconque des revendications 1 à 4, dans lequel un champ situé du côté image est formé dans le plan image avec une dimension maximale (Dx, Dy), la dimension maximale (Dx, Dy) du champ du côté image étant supérieure à 1 mm.

6. Objectif de projection catoptrique selon l'une quelconque des revendications 1 à 5, dans lequel l'objectif de projection présente une distance focale positive de la pupille d'entrée.

7. Objectif de projection catoptrique selon l'une quelconque des revendications 1 à 6, dans lequel le premier objectif partiel ne comprend que des miroirs qui sont disposés de manière désaxée par rapport à un axe principal de l'objectif de projection.

8. Objectif de projection catoptrique selon l'une quelconque des revendications 1 à 7, dans lequel le second miroir situé sur le chemin optique allant du plan objet au plan image, parmi la pluralité des miroirs du premier objectif partiel, est un miroir concave.

9. Objectif de projection catoptrique selon l'une quelconque des revendications 1 à 8, dans lequel le premier objectif partiel (100) comprend six miroirs.

10. Objectif de projection catoptrique selon la revendication 9, dans lequel la série de miroirs constituée des six miroirs (SP1, SP2, SP3, SP4, SP5, SP6) situés sur le chemin optique allant du plan objet (10) au plan image (20) dans le premier objectif partiel est la suivante : concave - concave - convexe - concave - convexe - concave.

11. Objectif de projection catoptrique selon la revendication 9, dans lequel la série de miroirs constituée des six miroirs (SP1, SP2, SP3, SP4, SP5, SP6) situés sur le chemin optique allant du plan objet (10) au plan image (20) dans le premier objectif partiel (100) est la suivante : concave - convexe - concave - convexe - convexe - concave.

**12.** Objectif de projection catoptrique selon l'une quelconque des revendications 9 à 11, dans lequel un diaphragme d'ouverture est disposé dans le premier objectif partiel (100) sur un second miroir (S20) sur le chemin optique allant du plan objet (10) au plan image (20) ou à proximité d'un second miroir (S20) situé sur le chemin optique allant du plan objet (10) au plan image (20).

**13.** Objectif de projection catoptrique selon l'une quelconque des revendications 9 à 12, dans lequel un diaphragme d'ouverture est disposé entre le miroir primaire concave (SK1) et le miroir secondaire concave (SK2) du second objectif partiel (200).

**14.** Objectif de projection catoptrique selon l'une quelconque des revendications 9 à 13, **caractérisé en ce que** l'objectif de projection comprend deux images intermédiaires (ZWISCH1, ZWISCH2).

**15.** Objectif de projection catoptrique selon l'une quelconque des revendications 9 à 14, **caractérisé en ce que** l'angle d'incidence $\Theta_{CR}$ du rayon principal par rapport au point de champ central sur chacun des huit miroirs (SP1, SP2, SP3, SP4, SP5, SP6, SK1, SK2) est inférieur à 24°.

**16.** Système d'éclairement de projection de microlithographie comprenant un système d'éclairement et un objectif de projection catoptrique selon l'une quelconque des revendications 1 à 15, dans lequel l'objectif de projection catoptrique forme l'image d'un masque portant une structure sur un substrat photosensible.

**17.** Procédé d'éclairement de substrats photosensibles au moyen d'un système d'éclairement par projection de microlithographie selon la revendication 16, dans lequel un masque portant une structure est éclairé par le système d'éclairement au moyen d'un faisceau de rayons, dans lequel l'image du faisceau de rayons réfléchi par le masque est formée par l'objectif de projection catoptrique sur le substrat photosensible et dans lequel le substrat est éclairé à travers celui-ci.

Fig.1a

Fig.1b

Fig.1c

Fig.1d

Fig.1e

Fig.1f

Fig.1g

Fig.1h

Fig.1i

2921

2922

2923

2912

2910

2920

y

x

z

Fig.1j

2921

2922

2923

2928

2924

2910

2926

2920

y

x

z

Fig.1k

Fig. 1l

Fig. 1m

Fig.1n

2810 — 2811     2811 — 2810

$d_W$

2102

2150

**Fig.1o**

z

y⊙    x

2941

2103    2947    2945

2942

2140    2946    2943

2105    2944

**Fig.1p**

y

x⊙    z

8M-System 6x NA=0.54

Fig.1q

EP 1 828 829 B1

250.00 mm

100    300    200

S2

S1 S5 S4

SK2

SK1

10

S3  B

20

HA

S6

Z1

Z2

8M-System 4x NA=0.50 F=13x1 mm²

Fig.2

y

x        z

250.00 mm

EP 1 828 829 B1

8M-System 5x NA=0.50 F=22x1 mm$^2$

Fig.3

208.33 mm

Fig.4

8M-System 6x NA=0.50 F=18x1 mm²

8M-System 8x NA=0.50

Fig.5

EP 1 828 829 B1

257.73 mm

Fig.6a

8M-System 8x NA=0.60

320.51 mm

← 100 → ← 200 →

SP1 SP6 ZWISCH2 SP8

10

20

SP2 B

SP4

SP3 ZWISCH1 HA SP5 SP7

8M-System 8x NA=0.60 F=1mm

**Fig.6b**

y
x ⊙ → z

253.73 mm

SP4 SP8

SP2 SP1 B

10' SP3 SP7

20

ZWISCH1 SP5

SP6

8M-System 8x NA=0.60 F=1mm

**Fig.6c**

y
x ⊙ → z

250.00 mm

8M-System 8x NA=0.60 F=1mm

Fig.6d

8M-System 8x NA=0.60 F=1mm

Fig.6e

10M-System 8x NA=0.75 F=1mm

Fig.7

324.68 mm

EP 1 828 829 B1

10M-System 8x NA=0.75 F=2mm

Fig.8

324.68 mm

10M-System 8x NA=0.70 F=1mm   Fig.9

SUBO1   SUBO2

320.51 mm

100    300    200

SK2

S40    SK1

S10  S50 S80    S30

10    S20    S70 Z1    20

B    Z3    Z2

S60

10M-System 8x NA=0.72 F=1mm

Fig.10

y

x    z

320.51 mm

EP 1 828 829 B1

10M-System 8x NA=0.70 F=1mm

Fig.11

EP 1 828 829 B1

290.70 mm

Fig.12

10M-System 8x NA=0.72 F=2mm

Fig. 13

Fig. 14

Fig.15

Fig.16

10M-System katadioptrisch NA=0.70

Fig.17

6M-System 8x NA=0.50 F=13x1mm$^2$

Fig.18

6M-System 8x NA=0.50 F=13x1mm²

Fig.19

10M-System 8x NA=0.72 F=1mm  Fig.20

192.31 mm

10M-System 8x NA=0.85 F=1mm  Fig.21

250.00 mm

Fig.22

10M-System 8x NA=0.90 F=1mm

208.33 mm

EP 1 828 829 B1

Fig.23

Fig.24

EP 1 828 829 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5686728 A
- EP 1434093 A
- US 6750948 B2
- US 6750948 B
- US 20040114217 A
- US 20040114217 A1
- US 6750648 B
- US 5212588 A

- US 5003567 A
- US 6452661 B
- US 6195201 B
- US 6512641 B
- EP 1069448 A
- WO 2004010224 A
- EP 1225481 A
- US 6198793 B

**In der Beschreibung aufgeführte Nicht-Patentliteratur**

- Handbook of optics. McGraw Hill, 1995, vol. 1, 35-3